# EUROPEAN PATENT APPLICATION

(11) **EP 4 369 887 A1**
(43) Date of publication of application: **15.05.2024**
(21) Application number: 23200427.5
(22) Date of filing: 28.09.2023
(51) Int. Cl.: H10K 50/12, H10K 50/19

(54) **ORGANIC LIGHT EMITTING DIODE AND ORGANIC LIGHT EMITTING DEVICE INCLUDING THEREOF**

(30) Priority: 14.11.2022 KR 20220151500
(71) Applicant: LG Display Co., Ltd., Seoul 07336 (KR)
(72) Inventor: SHIN, In-Ae, 10845 Paju-si, Gyeonggi-do (KR); YOON, Kyung-Jin, 10845 Paju-si, Gyeonggi-do (KR); MIN, Hye-Li, 10845 Paju-si, Gyeonggi-do (KR); LIM, Gi-Hwan, 10845 Paju-si, Gyeonggi-do (KR); KIM, Jong-Uk, 10845 Paju-si, Gyeonggi-do (KR); KIM, Jun-Yun, 10845 Paju-si, Gyeonggi-do (KR); IM, Joon-Beom, 10845 Paju-si, Gyeonggi-do (KR)
(74) Representative: Viering, Jentschura & Partner mbB Patent- und Rechtsanwälte

(57) **Abstract**

The present disclosure relates to an organic light emitting device (100), including: a substrate (110) defining a first pixel region (SP1) and a second pixel region (SP2); and an organic light emitting diode (D) disposed over the substrate (110), wherein the organic light emitting diode (D) includes a transmissive electrode (230), a reflective electrode (210) facing the transmissive electrode and an emissive layer (220) disposed between the transmissive electrode (230) and the reflective electrode (210), wherein the organic light emitting diode (D) respectively corresponds to each of the first pixel region (SP1) and the second pixel region (SP2), wherein the emissive layer comprises a first emissive layer (220-B1, 220-B2) and a second emissive layer (220-G1, 220-G2), wherein the first emissive layer (220-B1, 220-B2) of the organic light emitting diode (D1-B, D2-B) is disposed in the first pixel region (SP1) and includes a first blue emitting material layer (350) including a first blue fluorescent compound (352), and a second blue emitting material layer (360, 460) disposed between the first blue emitting material layer (350) and the transmissive electrode (230) and including a second blue fluorescent compound (362, 462) and a blue phosphorescent compound (364, 464), and wherein the second emissive layer (220-G1, 220-G2) of the organic light emitting diode (D1-G, D2-G) is disposed in the second pixel region (SP2) and includes a first green emitting material layer (550) including a first green delayed fluorescent compound (552), and a second green emitting material layer (560, 660) disposed between the first green emitting material layer (550) and the transmissive layer (230) and including a second green delayed fluorescent compound (562, 662).

## Description

### BACKGROUND

### Technical Field

The present disclosure relates to an organic light emitting diode, and more particularly to, an organic light emitting diode with beneficial luminous properties and an organic light emitting device including the diode.

### Discussion of the Related Art

A flat display device including an organic light emitting diode (OLED) has attracted attention as a display device that can replace a liquid crystal display device (LCD). The OLED can be formed of a thin organic thin film equal to or less than 2000 Å, and the electrode configurations in the OLED can implement unidirectional or bidirectional images. Also, the OLED can be formed even on a flexible transparent substrate such as a plastic substrate so that a flexible or a foldable display device can be realized with ease using the OLED. In addition, the OLED can be driven at a lower voltage and the OLED has advantageous high color purity compared to the LCD.

In the OLED, holes injected from an anode and electrons injected from a cathode are recombined in an emitting material layer to form excitons with unstable energy state, and then the excitons relax into a ground state thereby emitting light. Since fluorescent material uses only singlet excitons in the luminous process, the related art fluorescent material shows low luminous efficiency. On the contrary, phosphorescent material can show high luminous efficiency since it uses triplet exciton as well as singlet excitons in the luminous process. However, examples of phosphorescent material include metal complexes, which have a short luminous lifespan and are thus not suitable for commercial use.

### SUMMARY

Accordingly, embodiments of the present disclosure are directed to an organometallic compound, an organic light emitting diode and an organic light emitting device that substantially obviate one or more of the problems due to the limitations and disadvantages of the related art.

An aspect of the present disclosure is to provide an organic light emitting diode of which luminous efficiency and color purity can be improved and an organic light emitting device including the organic light emitting diode.

Additional features and aspects will be set forth in the description that follows, and in part will be apparent from the description, or may be learned by practice of the disclosed concepts provided herein. Other features and aspects of the disclosed concept may be realized and attained by the structure particularly pointed out in the written description, or derivable therefrom, and the claims hereof as well as the appended drawings.

To achieve these and other aspects of the inventive concepts, as embodied and broadly described, in one aspect, the present disclosure provides an organic light emitting device including: a substrate defining a first pixel region and a second pixel region; and an organic light emitting diode disposed over the substrate, wherein the organic light emitting diode includes a transmissive electrode, a reflective electrode facing the transmissive electrode and an emissive layer disposed between the transmissive electrode and the reflective electrode, wherein the organic light emitting diode respectively corresponds to each of the first pixel region and the second pixel region, wherein the emissive layer comprises a first emissive layer and a second emissive layer, wherein the first emissive layer of the organic light emitting diode is disposed in the first pixel region and includes a first blue emitting material layer including a first fluorescent compound, and a second blue emitting material layer disposed between the first blue emitting material layer and the transmissive electrode and including a second fluorescent compound and a blue phosphorescent compound, and wherein the second emissive layer of the organic light emitting diode is disposed in the second pixel region and includes a first green emitting material layer including a first green delayed fluorescent compound, and a second green emitting material layer disposed between the first green emitting material layer and the transmissive layer and including a second green delayed fluorescent compound.

The first blue fluorescent compound can include an organic compound having the following structure of Chemical Formula 1: 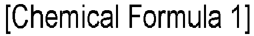 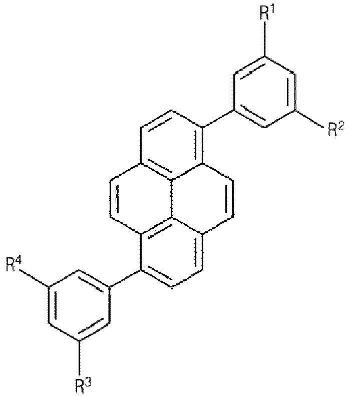 wherein, in the Chemical Formula 1, each of R¹, R², R³ and R⁴ is independently hydrogen, an unsubstituted or substituted C₁-C₂₀ alkyl group, an unsubstituted or substituted C₆-C₃₀ aryl group or an unsubstituted or substituted C₆-C₃₀ aryl amino group.

The first blue emitting material layer can further include a first blue host having the following structure of Chemical Formula 3: 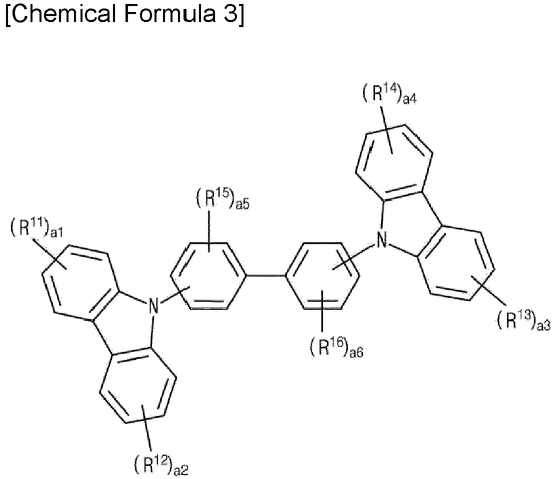 wherein, in the Chemical Formula 3,
each of R¹¹, R¹², R¹³, R¹⁴, R¹⁵ and R¹⁶ is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹ is identical to or different from each other when a1 is 2, 3 or 4, where each R¹² is identical to or different from each other when a2 is 2, 3 or 4, where each R¹³ is identical to or different from each other when a3 is 2, 3 or 4, where each R¹⁴ is identical to or different from each other when a4 is 2, 3 or 4, where each R¹⁵ is identical to or different from each other when a5 is 2, 3 or 4, and where each R¹⁶ is identical to or different from each other when a6 is 2, 3 or 4; and
each of a1, a2, a3, a4, a5 and a6 is independently 0, 1, 2, 3 or 4.

As an example, the first blue host can have the following structure of Chemical Formula 3A or Chemical Formula 3B: 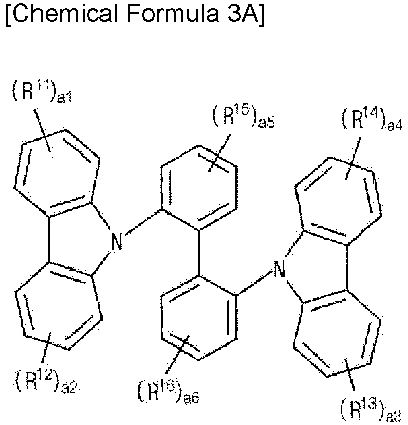 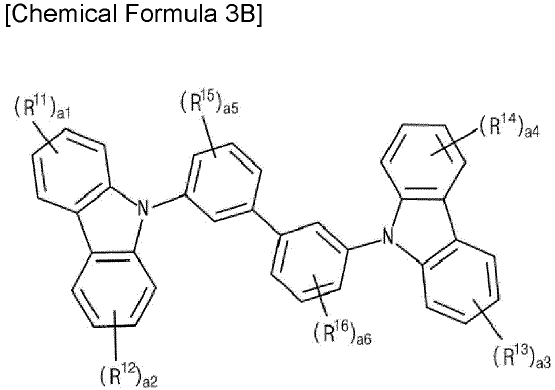 wherein, in the Chemical Formulae 3A and 3B,
each of R¹¹, R¹², R¹³, R¹⁴, R¹⁵ and R¹⁶, and a1, a2, a3, a4, a5 and a6 is a same as defined in Chemical Formula 3.

The second blue fluorescent compound can include an organic compound having the following structure of Chemical Formula 5: 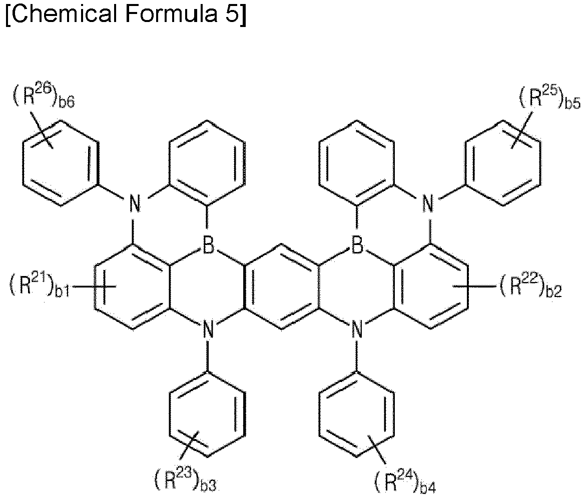 wherein, in the Chemical Formula 5,
each of R²¹ and R²² is independently an unsubstituted or substituted C₆-C₃₀ aryl group, an unsubstituted or substituted C₃-C₃₀ hetero aryl group or an unsubstituted or substituted C₆-C₃₀ aryl amino group, where each R²¹ is identical to or different from each other when b1 is 2 or 3, and where each R²² is identical to or different from each other when b2 is 2 or 3;
each of R²³, R²⁴, R²⁵ and R²⁶ is independently an unsubstituted or substituted C₁-C₂₀ alkyl group or an unsubstituted or substituted C₆-C₃₀ aryl group, where each R²³ is identical to or different from each other when b3 is 2, 3, 4 or 5, where each R²⁴ is identical to or different from each other when b4 is 2, 3, 4 or 5, where each R²⁵ is identical to or different from each other when b5 is 2, 3, 4 or 5, and where each R²⁶ is identical to or different from each other when b6 is 2, 3, 4 or 5;
each of b1 and b2 is independently 0, 1, 2 or 3; and
each of b3, b4, b5 and b6 is independently 0, 1, 2, 3, 4 or 5.

For example, the second blue fluorescent compound can include an organic compound having the following structure of Chemical Formula 5A: 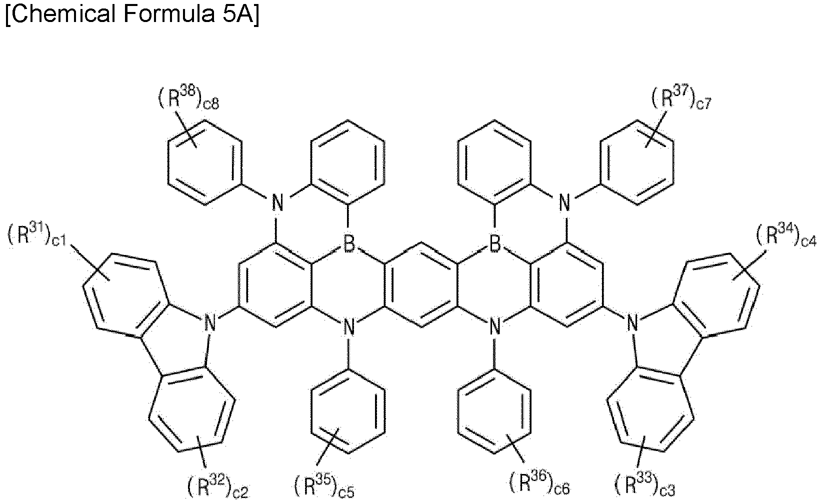 wherein, in the Chemical Formula 5A,
each of R³¹, R³², R³³, R³⁴, R³⁵, R³⁶, R³⁷ and R³⁸ is independently an unsubstituted or substituted C₁-C₂₀ alkyl group or an unsubstituted or substituted C₆-C₃₀ aryl group, where each R³¹ is identical to or different from each other when c1 is 2, 3 or 4, where each R³² is identical to or different from each other when c2 is 2, 3 or 4, where each R³³ is identical to or different from each other when c3 is 2, 3 or 4, where each R³⁴ is identical to or different from each other when c4 is 2, 3 or 4, where each R³⁵ is identical to or different from each other when c5 is 2, 3, 4 or 5, where each R³⁶ is identical to or different from each other when c6 is 2, 3, 4 or 5, where each R³⁷ is identical to or different from each other when c7 is 2, 3, 4 or 5, and where each R³⁸ is identical to or different from each other when c8 is 2, 3, 4 or 5;
each of c1, c2, c3 and c4 is independently 0, 1, 2, 3 or 4; and
each of c5, c6, c7 and c8 is independently 0, 1, 2, 3, 4 or 5.

The blue phosphorescent compound can include an organometallic compound having the following structure of Chemical Formula 7: 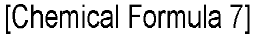 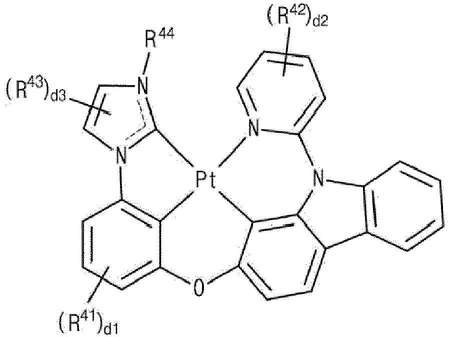 wherein, in the Chemical Formula 7,
each of R⁴¹, R⁴² and R⁴³ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁴¹ is identical to or different from each other when d1 is 2 or 3, where each R⁴² is identical to or different from each other when d2 is 2, 3 or 4, and where each R⁴³ is identical to or different from each other when d3 is 2;
R⁴⁴ is hydrogen, an unsubstituted or substituted C₁-C₂₀ alkyl group, an unsubstituted or substituted C₆-C₃₀ aryl group or an unsubstituted or substituted C₃-C₃₀ hetero aryl group;
d1 is 0, 1, 2 or 3;
d2 is 0, 1, 2, 3 or 4; and
d3 is 0, 1 or 2.

The second blue emitting material layer can further include at least one of a second blue host having the structure of Chemical Formula 3 and a third blue host having the following structure of Chemical Formula 9: 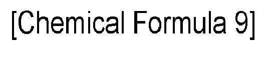 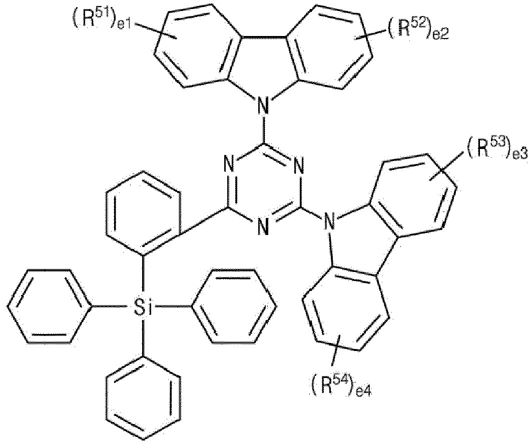 wherein, in the Chemical Formula 9,
each of R⁵¹, R⁵², R⁵³ and R⁵⁴ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁵¹ is identical to or different from each other when e1 is 2, 3 or 4, where each R⁵² is identical to or different from each other when e2 is 2, 3 or 4, where each R⁵³ is identical to or different from each other when e3 is 2, 3 or 4, and where each R⁵⁴ is identical to or different from each other when e4 is 2, 3 or 4; and
each of e1, e2, e3 and e4 is independently 0, 1, 2, 3 or 4.

Each of the first green delayed fluorescent compound and the second green delayed fluorescent compound can independently include an organic compound having the following structure of Chemical Formula 11: 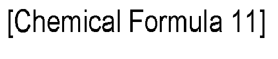 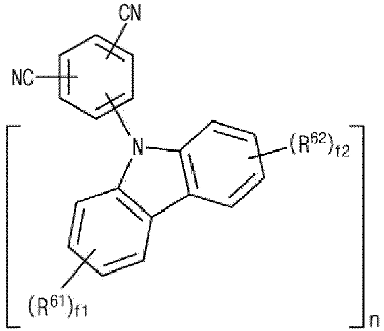 wherein, in the Chemical Formula 11,
each of R⁶¹ and R⁶² is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁶¹ is identical to or different from each other when f1 is 2, 3 or 4, and where each R⁶² is identical to or different from each other when f2 is 2, 3 or 4;
each of f1 and f2 is independently 0, 1, 2, or 4; and
n is 1, 2, 3 or 4.

The first green emitting material layer can further include a first green fluorescent compound and the second green emitting material layer further includes a second green fluorescent compound.

As an example, each of the first green fluorescent compound and the second green fluorescent compound can independently include an organic compound having the following structure of Chemical Formula 13A or Chemical Formula 13B: 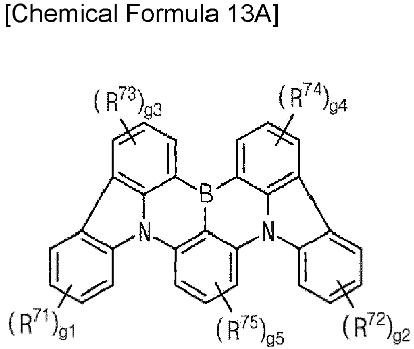 wherein, in the Chemical Formula 13A,
each of R⁷¹, R⁷², R⁷³ and R⁷⁴ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁷¹ is identical to or different from each other when g1 is 2, 3 or 4, where each R⁷² is identical to or different from each other when g2 is 2, 3 or 4, where each R⁷³ is identical to or different from each other when g3 is 2 or 3, where each R⁷⁴ is identical to or different from each other when g4 is 2 or 3;
R⁷⁵ is an unsubstituted or substituted C₃-C₃₀ hetero aryl group, or
optionally, two adjacent R⁷⁵ when g5 is 2 or 3 can be further linked to form an unsubstituted or substituted C₆-C₃₀ aryl ring or an unsubstituted or substituted C₃-C₂₀ hetero aryl ring;
each of g1 and g2 is independently 0, 1, 2, 3 or 4; and
each of g3, g4 and g5 is independently 0, 1, 2 or 3, 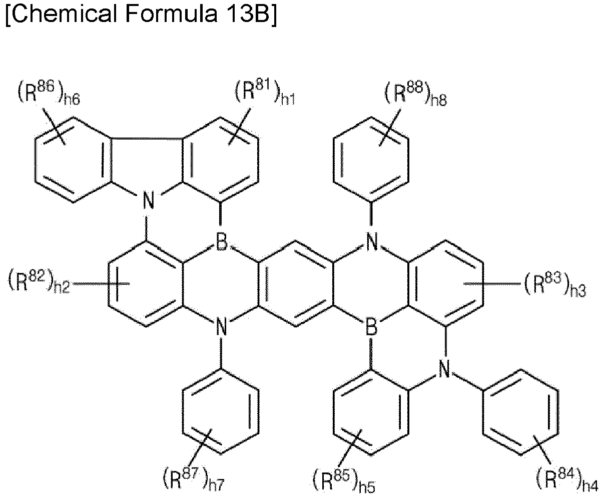 wherein, in the Chemical Formula 13B,
   each of R⁸¹, R⁸², R⁸³, R⁸⁴, R⁸⁵, R⁸⁶, R⁸⁷ and R⁸⁸ is independently an unsubstituted or substituted C₁-C₂₀ alkyl group, an unsubstituted or substituted C₆-C₃₀ aryl group or an unsubstituted or substituted C₃-C₃₀ hetero aryl group, or optionally, R⁸⁴ is fused to a ring including R⁸³ or a ring including R⁸⁵ to form a 5-membering ring or a 6-membering ring including a nitrogen atom, where each R⁸¹ is identical to or different from each other when h1 is 2 or 3, where each R⁸² is identical to or different from each other when h2 is 2 or 3, where each R⁸³ is identical to or different from each other when h3 is 2 or 3, where each R⁸⁴ is identical to or different from each other when h4 is 2, 3, 4 or 5, where each R⁸⁵ is identical to or different from each other when h5 is 2, 3 or 4, where each R⁸⁶ is identical to or different from each other when h6 is 2, 3 or 4, where each R⁸⁷ is identical to or different from each other when h7 is 2, 3, 4 or 5, and where each R⁸⁸ is identical to or different from each other when h8 is 2, 3, 4 or 5;
   each of h1, h2 and h3 is independently 0, 1, 2 or 3;
   each of h5 and h6 is independently 0, 1, 2, 3 or 4; and
   each of h4, h7 and h8 is independently 0, 1, 2, 3, 4 or 5.

The first green emitting material layer can further include a first green host and the second green emitting material layer can further include a second green host.

For example, each of the first green host and the second green host can independently include an organic compound having the following structure of Chemical Formula 15: 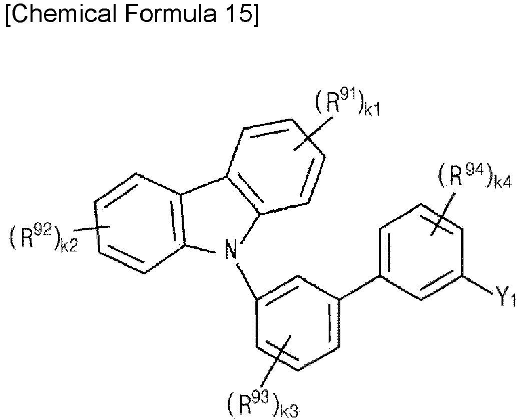 wherein, in the Chemical Formula 15,
each of R⁹¹ and R⁹² is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁹¹ is identical to or different from each other when k1 is 2, 3 or 4, and where each R⁹² is identical to or different from each other when k2 is 2, 3 or 4;
each of R⁹³ and R⁹⁴ is independently an unsubstituted or substituted C₁-C₂₀ alkyl group, an unsubstituted or substituted C₆-C₃₀ aryl group or an unsubstituted or substituted C₃-C₃₀ hetero aryl group, or optionally, R⁹³ and R⁹⁴ can be further linked to form an unsubstituted or substituted hetero ring, where each R⁹³ is identical to or different from each other when k3 is 2, 3 or 4, and where each R⁹⁴ is identical to or different from each other when k4 is 2, 3 or 4;
Y' has the following structure of Chemical Formula 15A or Chemical Formula 15B;
each of k1, k2, k3 and k4 is independently 0, 1, 2, 3 or 4, 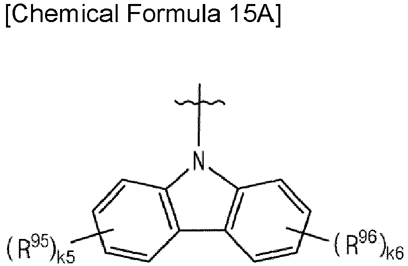 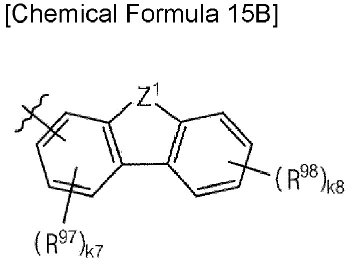 wherein, in Chemical Formulae 15A and 15B,
   each of R⁹⁵, R⁹⁶, R⁹⁷ and R⁹⁸ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁹⁵ is identical to or different from each other when k5 is 2, 3 or 4, where each R⁹⁶ is identical to or different from each other when k6 is 2, 3 or 4, where each R⁹⁷ is identical to or different from each other when k7 is 2 or 3, and where each R⁹⁸ is identical to or different from each other when k8 is 2, 3 or 4;
   each of k5, k6 and k8 is independently 0, 1, 2, 3 or 4;
   k7 is 0, 1, 2 or 3;
   Z¹ is NR⁹⁹, O or S, where R⁹⁹ is hydrogen, an unsubstituted or substituted C₁-C₂₀ alkyl group, an unsubstituted or substituted C₆-C₃₀ aryl group or an unsubstituted or substituted C₃-C₃₀ hetero aryl group.

Optionally, the emissive layer of the organic light emitting diode disposed in the third pixel region can include a first red emitting material layer including a red delayed fluorescent compound and a red fluorescent compound, and a second red emitting material layer disposed between the first red emitting material layer and the transmissive electrode and including a red phosphorescent compound.

The red delayed fluorescent compound can have the structure of Chemical Formula 11.

The red fluorescent compound can have the following structure of Chemical Formula 17: 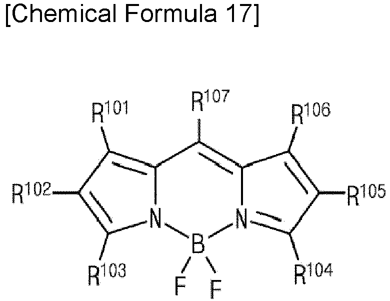 wherein, in the Chemical Formula 17,
each of R¹⁰¹, R¹⁰², R¹⁰³, R¹⁰⁴, R¹⁰⁵ and R¹⁰⁶ is independently hydrogen, an unsubstituted or substituted C₁-C₂₀ alkyl group, an unsubstituted or substituted C₆-C₃₀ aryl group or an unsubstituted or substituted C₃-C₃₀ hetero aryl group; and
R¹⁰⁷ is an unsubstituted or substituted C₆-C₃₀ aryl group or an unsubstituted or substituted C₃-C₃₀ hetero aryl group.

The first red emitting material layer can further include a first red host and the second red emitting material layer can further include a second red host.

For example, each of the first red host and the second red host can independently include an organic compound having the following structured of Chemical Formula 19: 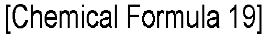 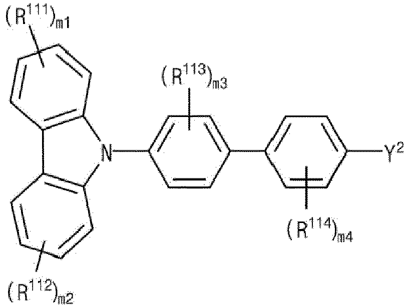 wherein, in the Chemical Formula 19,
each of R¹¹¹ and R¹¹² is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹¹ is identical to or different from each other when m1 is 2, 3 or 4, and where each R¹¹² is identical to or different from each other when m2 is 2, 3 or 4;
each of R¹¹³ and R¹¹⁴ is independently an unsubstituted or substituted C₁-C₂₀ alkyl group, an unsubstituted or substituted C₆-C₃₀ aryl group or an unsubstituted or substituted C₃-C₃₀ hetero aryl group, or optionally, R¹¹³ and R¹¹⁴ can be further linked to form an unsubstituted or substituted hetero ring, where each R¹¹³ is identical to or different from each other when m3 is 2, 3 or 4, and where each R¹¹⁴ is identical to or different from each other when m4 is 2, 3 or 4;
Y² has the following structure of Chemical Formula 19A or Chemical Formula 19B;
each of m1, m2, m3 and m4 is independently 0, 1, 2, 3 or 4, 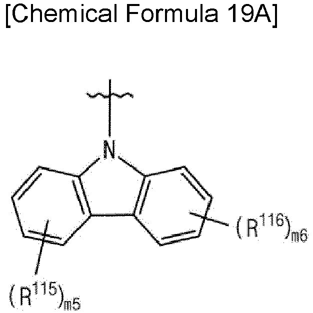 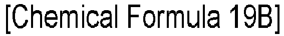 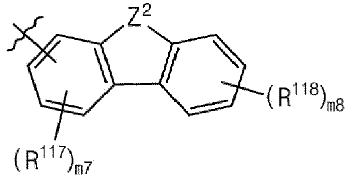 wherein, in Chemical Formulae 19A and 19B,
   each of R¹¹⁵, R¹¹⁶, R¹¹⁷ and R¹¹⁸ is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹⁵ is identical to or different from each other when m5 is 2, 3 or 4, where each R¹¹⁶ is identical to or different from each other when m6 is 2, 3 or 4, where each R¹¹⁷ is identical to or different from each other when m7 is 2 or 3, and where each R¹¹⁸ is identical to or different from each other when m8 is 2, 3 or 4;
   each of m5, m6 and m8 is independently 0, 1, 2, 3 or 4;
   m7 is 0, 1, 2 or 3;
   Z² is NR¹¹⁹, O or S, where R¹¹⁹ is hydrogen, an unsubstituted or substituted C₁-C₂₀ alkyl group, an unsubstituted or substituted C₆-C₃₀ aryl group or an unsubstituted or substituted C₃-C₃₀ hetero aryl group.

Each of first blue emitting material layer and the second blue emitting material layer, each of the first green emitting material layer and the second green emitting material layer, and optionally, each of the first red emitting material layer and the second red emitting material layer can be located within a single emitting part, respectively.

Alternatively, the emissive layer of the organic light emitting diode disposed in the first pixel region can include a first blue emitting part including the first blue emitting material layer, a second blue emitting part including the second blue emitting material layer and a charge generation layer disposed between the first blue emitting part and the second blue emitting part, and/or the emissive layer of the organic light emitting diode disposed in the second pixel region can include a first green emitting part including the first green emitting material layer, a second green emitting part including the second green emitting material layer and a charge generation layer disposed between the first green emitting part and the second green emitting part.

In another aspect, the present disclosure provides an organic light emitting diode that includes: a reflective electrode; a transmissive electrode facing the reflective electrode; and an emissive layer disposed between the reflective electrode and the transmissive electrode, wherein the emissive layer includes: a first emitting part including a first blue emitting material layer; a second emitting part disposed between the first emitting part and the transmissive electrode, the second emitting part including a green emitting material layer; a third emitting part disposed between the second emitting part and the transmissive electrode, the third emitting part including a second blue emitting material layer; a first charge generation layer disposed between the first emitting part and the second emitting part; and a second charge generation layer disposed between the second emitting part and the third emitting part, wherein the first blue emitting material layer includes a first blue fluorescent compound, wherein the second blue emitting material layer includes a second blue fluorescent compound and a blue phosphorescent compound, and wherein the green emitting material layer includes a first green emitting material layer including a first green delayed fluorescent compound, and a second green emitting material layer disposed between the first green emitting material layer and the second charge generation layer and including a second green delayed fluorescent compound.

The first blue emitting material layer can further include a first blue host having the structure of Chemical Formula 3 such as Chemical Formula 3A or Chemical Formula 3B.

The second blue emitting material layer further includes a second blue host having the structure of Chemical Formula 3 and/or a third blue host having the structure of Chemical Formula 9.

The first green emitting material layer can further include a first green fluorescent compound and the second green emitting material layer can further include a second green fluorescent compound.

Alternatively, the first green emitting material layer can further include a first green host and the second green emitting material layer can further include a second green host.

Optionally, the second emitting part can further include a red emitting material layer, wherein the red emitting material layer is disposed between the green emitting material layer and the first charge generation layer or disposed between the green emitting material layer and the second charge generation layer, and the red emitting material layer can include a first red emitting material layer including a red delayed fluorescent compound and a red fluorescent compound, and a second red emitting material layer disposed between the first red emitting material layer and the second charge generation layer and including a red phosphorescent compound.

The first red emitting material layer can further include a first red host and the second red emitting material layer can further include a second red host.

The second emitting part can further include a yellow green emitting material layer disposed between the green emitting material layer and the red emitting material layer.

In yet another aspect, the present disclosure provides an organic light emitting device, for example, an organic light emitting display device or an organic light emitting illumination device, includes a substrate and the organic light emitting diode over the substrate.

In the organic light emitting device of the present disclosure, the organic light emitting diode disposed in a first pixel region includes a first blue emitting material layer of a fluorescence emitting layer and a second blue emitting material layer of a Phosphor-Sensitized Fluorescence (PSF) emitting material layer disposed adjacently to a transmissive electrode. The organic light emitting diode disposed in a second pixel region includes multiple green emitting material layers each of which includes a delayed fluorescent compound. The organic light emitting device with beneficial luminous efficiency and the luminous lifetime can be fabricated.

Optionally, the organic light emitting diode disposed in a third pixel region can include a first red emitting material layer including a delayed fluorescent compound and a second red emitting material layer with a phosphorescent compound disposed adjacently to the transmissive electrode. In this case, the luminous property of the organic light device can be further improved.

The organic light emitting diode can include multiple emitting parts where the first blue emitting material layer, the second blue emitting material layer, the multiple green emitting material layers, and optionally, the first and second red emitting material are included, and therefore, white (W) emission with improved luminous property and color purity can be implemented.

It is to be understood that both the foregoing general description and the following detailed description are exemplary and explanatory, and are intended to provide further explanation of the inventive concepts as claimed.

### BRIEF DESCRIPTION OF THE DRAWINGS

The accompanying drawings, which are included to provide a further understanding of the disclosure, are incorporated in and constitute a part of this application, illustrate embodiments of the disclosure and together with the description serve to explain principles of the disclosure.
FIG. 1 illustrates a schematic circuit diagram of an organic light emitting display device in accordance with the present disclosure.
FIG. 2 illustrates a schematic cross-sectional view of an organic light emitting display device as an example of an organic light emitting device in accordance with an example embodiment of the present disclosure.
Each of FIGS. 3 to 5 illustrates a schematic cross-sectional view of an organic light emitting diode in accordance with an example embodiment of the present disclosure.
Each of FIGS. 6 to 8 illustrates a schematic cross-sectional view of an organic light emitting diode in accordance with another example embodiment of the present disclosure.

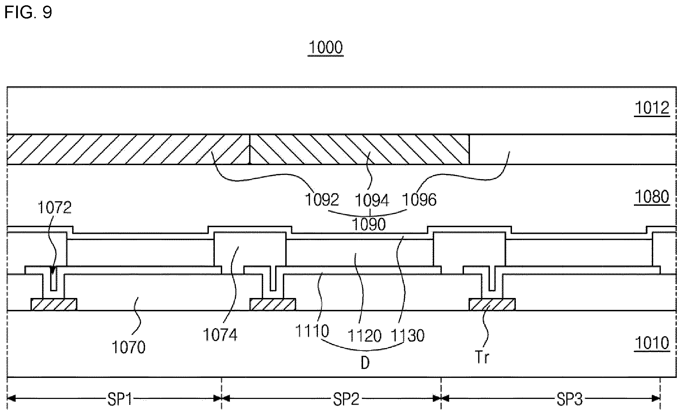

FIG. 9 illustrates a schematic cross-sectional view of an organic light emitting display device as an example of an organic light emitting device in accordance with another example embodiment of the present disclosure.

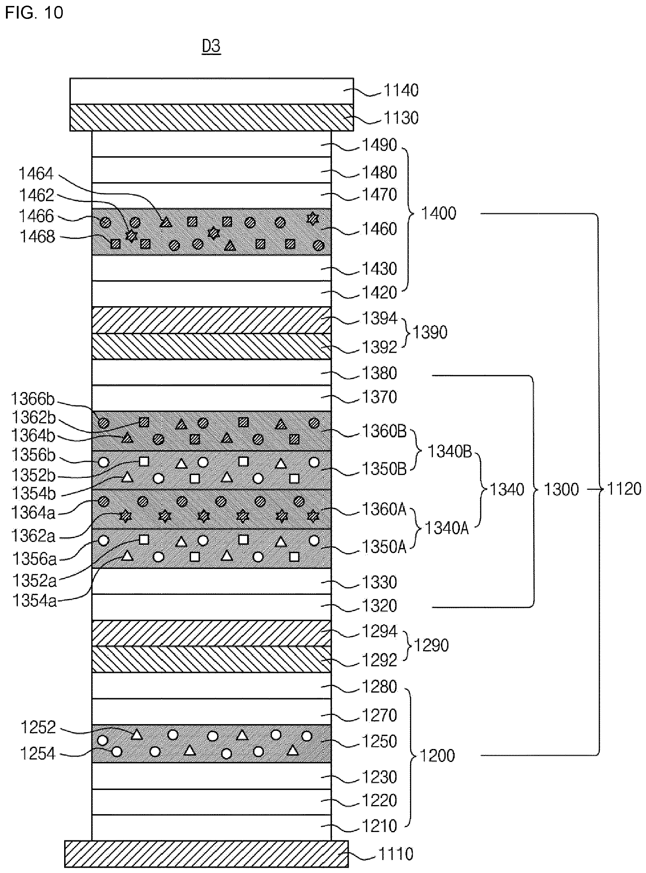

FIG. 10 illustrates a schematic cross-sectional view of an organic light emitting diode in accordance with another example embodiment of the present disclosure.

### DETAILED DESCRIPTION

Reference will now be made in detail to aspects of the disclosure, examples of which are illustrated in the accompanying drawings. Wherever possible, the same reference numbers will be used throughout the drawings to refer to the same or like parts.

The present disclosure relates to an organic light emitting display device including an organic light emitting diode with multiple emitting material layers in each pixel region, or an organic light emitting diode including an emissive layer with multiple emitting parts and an organic light emitting device including the organic light emitting diode. The organic light emitting diode can be applied to an organic light emitting device such as an organic light emitting display device or an organic light emitting illumination device. As an example, an organic light emitting display device will be described.

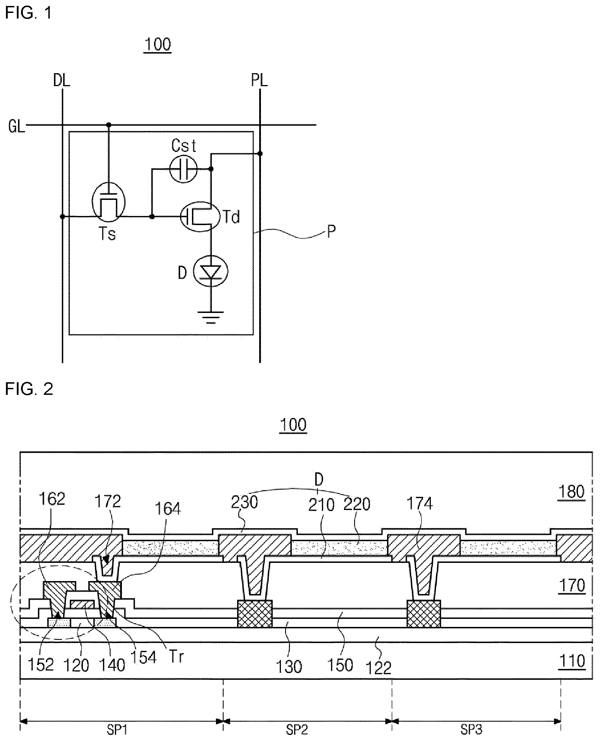

FIG. 1 illustrates a schematic circuit diagram of an organic light emitting display device in accordance with the present disclosure. As illustrated in FIG. 1, a gate line GL, a data line DL and power line PL, each of which crosses each other to define a pixel region P, in an organic light emitting display device 100. A switching thin film transistor Ts, a driving thin film transistor Td, a storage capacitor Cst and an organic light emitting diode D are disposed within the pixel region P. The pixel region P can include a first pixel region SP1 (FIG. 2), a second pixel region SP2 (FIG. 2) and a third pixel region SP3 (FIG. 2). However, embodiments of the present disclosure are not limited to such examples.

The switching thin film transistor Ts is connected to the gate line GL and the data line DL. The driving thin film transistor Td and the storage capacitor Cst are connected between the switching thin film transistor Ts and the power line PL. The organic light emitting diode D is connected to the driving thin film transistor Td. When the switching thin film transistor Ts is turned on by a gate signal applied to the gate line GL, a data signal applied to the data line DL is applied to a gate electrode of the driving thin film transistor Td and one electrode of the storage capacitor Cst through the switching thin film transistor Ts.

The driving thin film transistor Td is turned on by the data signal applied to the gate electrode 140 (FIG. 2) so that a current proportional to the data signal is supplied from the power line PL to the organic light emitting diode D through the driving thin film transistor Td. And then, the organic light emitting diode D emits light having a luminance proportional to the current flowing through the driving thin film transistor Td. In this case, the storage capacitor Cst is charged with a voltage proportional to the data signal so that the voltage of the gate electrode 140 in the driving thin film transistor Td is kept constant during one frame. Therefore, the organic light emitting display device can display a desired image.

FIG. 2 illustrates a schematic cross-sectional view of an organic light emitting display device in accordance with an example embodiment of the present disclosure. As illustrated in FIG. 2, the organic light emitting display device 100 includes a substrate 110 having a first pixel region SP1, a second pixel region SP2 and a third pixel region SP3 and an encapsulation film 180 oppositely facing the substrate 110. The first to third pixel regions SP1, SP2 and SP3 are defined in the substrate 110, and each of the first to third pixel regions SP1, SP2 and SP3 can be defined to an emitting area where an organic light emitting diode D is disposed and a driving area where a thin film transistor Tr is disposed. The thin film transistor Tr and the organic light emitting diode D are disposed on the substrate 110 in each of the first to third pixel regions SP1, SP2 and SP3, respectively, to form an array panel.

As an example, the first pixel region SP1 can be a blue pixel region, the second pixel region SP2 can be a green pixel region and the third pixel region SP3 can be a red pixel region. Each of the organic light emitting diodes D emitting red, green and blue light, respectively, is located correspondingly in the first pixel region SP1, the second pixel region SP2 and the third pixel region SP3. The first to third pixel regions SP1, SP2 and SP3 can constitute a pixel unit. Alternatively, the pixel unit can further include a fourth pixel region of a white pixel region.

The substrate can include transparent material. In one example embodiment, the substrate 110 can include, but is not limited to, glass, thin flexible material and/or polymer plastics. For example, the flexible material can be selected from the group, but is not limited to, polyimide (PI), polyethersulfone (PES), polyethylenenaphthalate (PEN), polyethylene terephthalate (PET), polycarbonate (PC) and/or combinations thereof.

A buffer layer 122 can be disposed on the substrate 110 in each of the first to third pixel regions SP1, SP2 and SP3. The thin film transistor Tr can be disposed on the buffer layer 122. The buffer layer 122 can be omitted.

A semiconductor layer 120 is disposed on the buffer layer 122. In one example embodiment, the semiconductor layer 120 can include, but is not limited to, oxide semiconductor materials. In this case, a light-shield pattern may be disposed under the semiconductor layer 120, and the light-shield pattern can prevent light from being incident toward the semiconductor layer 120, and thereby, preventing or reducing the semiconductor layer 120 from being degraded by the light. Alternatively, the semiconductor layer 120 can include polycrystalline silicon. In this case, opposite edges of the semiconductor layer 120 can be doped with impurities.

A gate insulating layer 130 including an insulating material is disposed on the semiconductor layer 120. The gate insulating layer 130 can include, but is not limited to, an inorganic insulating material such as silicon oxide (SiOₓ, wherein 0 < x ≤ 2) or silicon nitride (SiNₓ, wherein 0 < x ≤ 2).

A gate electrode 140 made of a conductive material such as a metal is disposed on the gate insulating layer 130 so as to correspond to a center of the semiconductor layer 120. While the gate insulating layer 130 may be disposed on a whole area of the substrate 110 as shown in FIG. 2, the gate insulating layer 130 can alternatively be patterned in correspondence to, for example, identically as, the gate electrode 140.

An interlayer insulating layer 150 including an insulating material is disposed on the gate electrode 140 and covers an entire surface of the substrate 110. The interlayer insulating layer 150 can include, but is not limited to, an inorganic insulating material such as silicon oxide (SiOₓ, wherein 0 < x ≤ 2) or silicon nitride (SiNₓ, wherein 0 < x ≤ 2), or an organic insulating material such as benzocyclobutene or photo-acryl.

The interlayer insulating layer 150 has first and second semiconductor layer contact holes 152 and 154 that expose or do not cover a portion of the surface nearer to the opposing ends than to a center of the semiconductor layer 120. The first and second semiconductor layer contact holes 152 and 154 are disposed on opposite sides of the gate electrode 140 and spaced apart from the gate electrode 140. The first and second semiconductor layer contact holes 152 and 154 are formed within the gate insulating layer 130 in FIG. 2. Alternatively, the first and second semiconductor layer contact holes 152 and 154 can be formed only within the interlayer insulating layer 150 when the gate insulating layer 130 is patterned in correspondence to, for example, identically as, the gate electrode 140.

A source electrode 162 and a drain electrode 164, which are made of conductive material such as a metal, are disposed on the interlayer insulating layer 150. The source electrode 162 and the drain electrode 164 are spaced apart from each other on opposing sides of the gate electrode 140, and contact both sides of the semiconductor layer 120 through the first and second semiconductor layer contact holes 152 and 154, respectively.

The semiconductor layer 120, the gate electrode 140, the source electrode 162 and the drain electrode 164 constitute the thin film transistor Tr, which acts as a driving element. The thin film transistor Tr in FIG. 2 has a coplanar structure in which the gate electrode 140, the source electrode 162 and the drain electrode 164 are disposed on the semiconductor layer 120. Alternatively, the thin film transistor Tr can have an inverted staggered structure in which a gate electrode is disposed under a semiconductor layer and a source and drain electrodes are disposed on the semiconductor layer. In this case, the semiconductor layer can include amorphous silicon.

The organic light emitting diode D is electrically connected to the thin film transistor Tr in each of the first to third pixel regions SP1, SP2 and SP3, respectively. The gate line GL and the data line DL, which cross each other to define a pixel region P, and a switching element Ts, which is connected to the gate line GL and the data line DL, can be further formed in each of the pixel regions SP1, SP2 and SP3. The switching element Ts is connected to the thin film transistor Tr, which is a driving element. In addition, the power line PL is spaced apart in parallel from the gate line GL or the data line DL. The thin film transistor Tr can further include a storage capacitor Cst configured to constantly keep a voltage of the gate electrode 140 for one frame.

A passivation layer 170 is disposed on the source and drain electrodes 162 and 164. The passivation layer 170 covers the thin film transistor Tr on the whole substrate 110. The passivation layer 170 has a flat top surface and a drain contact hole 172 that exposes or does not cover the drain electrode 164 of the thin film transistor Tr. While the drain contact hole 172 is disposed on the second semiconductor layer contact hole 154, it may be spaced apart from the second semiconductor layer contact hole 154.

The organic light emitting diode (OLED) D includes a first electrode 210 that is disposed on the passivation layer 170 and connected to the drain electrode 164 of the thin film transistor Tr. The OLED D further includes an emissive layer 220 and a second electrode 230 each of which is disposed sequentially in this order on the first electrode 210. The OLED D is located correspondingly to each of the first to third pixel regions SP1, SP2 and SP3 and emits different color light. For example, the OLED D disposed in the first pixel region SP1 can emit blue color light, the OLED D disposed in the second pixel region SP2 can emit green color light and the OLED D disposed in the third pixel region SP3 can emit red color light.

The first electrode 210 is formed separately for each pixel region SP1, SP2 or SP3, and the second electrode 230 can be formed over a whole display area. One of the first electrode 210 and the second electrode 220 can be an anode and the other of the first electrode 210 and the second electrode 230 can be a cathode. In one example embodiment, the first electrode 210 can be a transmissive (or semi-transmissive) electrode and the second electrode 230 can be a reflective electrode. In this case, the light emitted from the OLED D passes through the first electrode 210 to display an image on the substrate 110 side, and the organic light display device 100 can be a bottom-emission type.

In another example embodiment, the first electrode 210 can be a reflective electrode and the second electrode 230 can be a transmissive (or semi-transmissive) electrode. In this case, the light emitted from the OLED D passes through the second electrode 230 to display an image on the opposite side of the substrate 110, and the organic light display device 100 can be a top-emission type.

In one example embodiment, the first electrode 210 can be an anode and include conductive material having relatively high work function value, for example, a transparent conductive oxide (TCO).

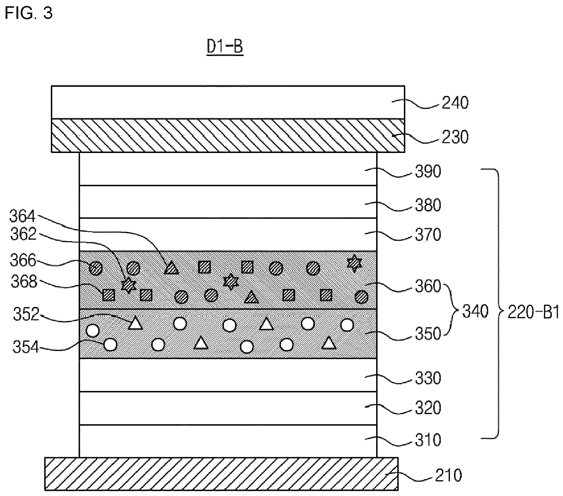

In one example embodiment, when the organic light emitting display device 100 is a bottom-emission type, the first electrode 210 can have a single-layered structure of the TCO. In this case, a capping layer 240 (FIGS. 3 to 5) can be omitted, and the first electrode 210 can have a thin thickness to have a light transmissive (or semi-transmissive) property. Alternatively, when the organic light emitting display device 100 is a top-emission type, a reflective electrode or a reflective layer may be disposed under the first electrode 210.

As an example, the first electrode 210 can be a reflective electrode including a transparent conducive layer having the TCO and a reflective layer. For example, the transparent conductive layer of the first electrode 210 can include, but is not limited to, indium tin oxide (ITO), indium zinc oxide (IZO), indium tin zinc oxide (ITZO), tin oxide (SnO), zinc oxide (ZnO), indium cerium oxide (ICO), aluminum doped zinc oxide (AZO), and/or the like. The reflective layer can include, but is not limited to, silver (Ag) or aluminum-palladium-copper (APC) alloy. For example, the first electrode 210 can have a triple-layered structure of ITO/Ag/ITO or ITO/APC/ITO.

In addition, a bank layer 174 is disposed on the passivation layer 170 in order to cover edges of the first electrode 210. The bank layer 174 exposes or does not cover a center of the first electrode 210 corresponding to each pixel region SP1, SP2 or SP3. The bank layer 174 can be omitted.

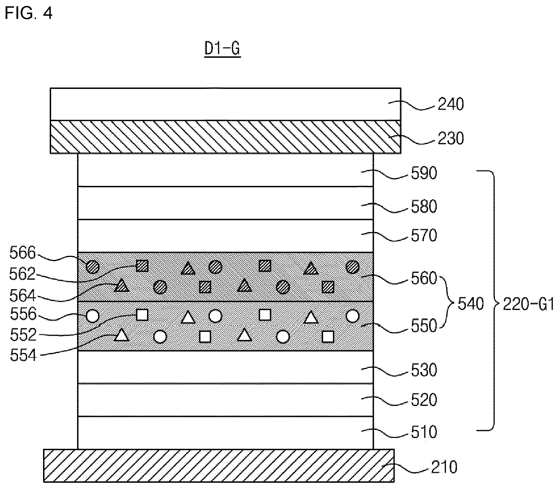

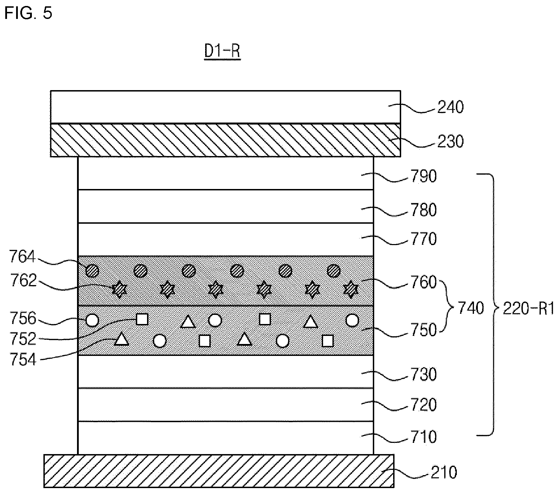

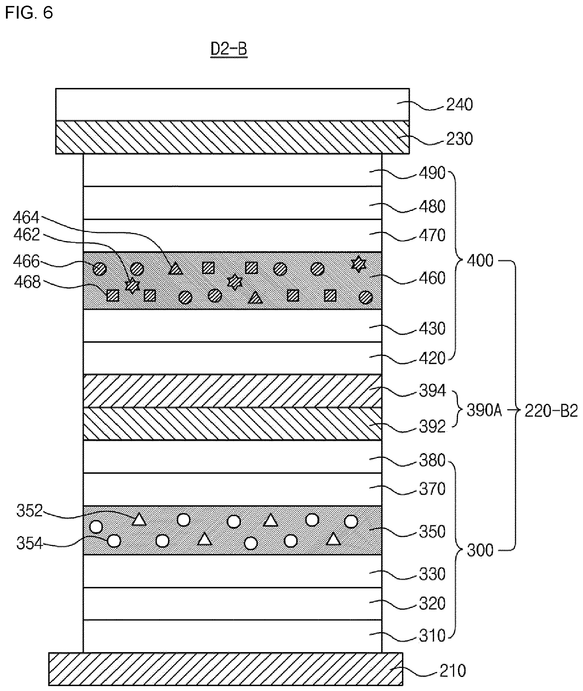

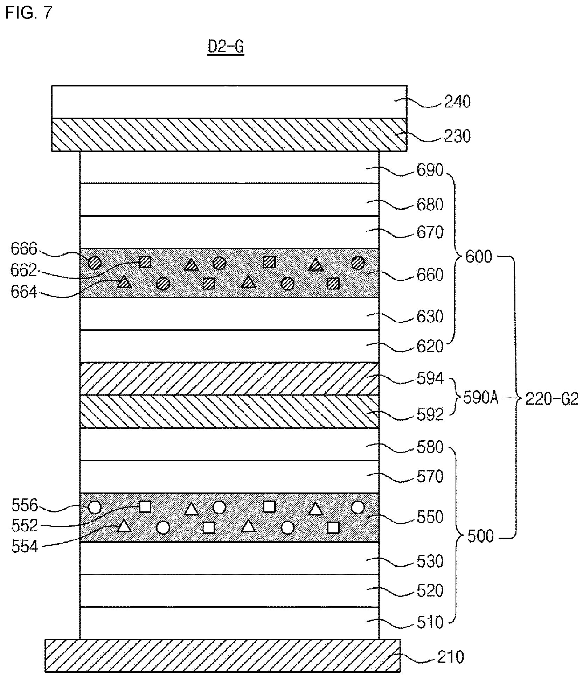

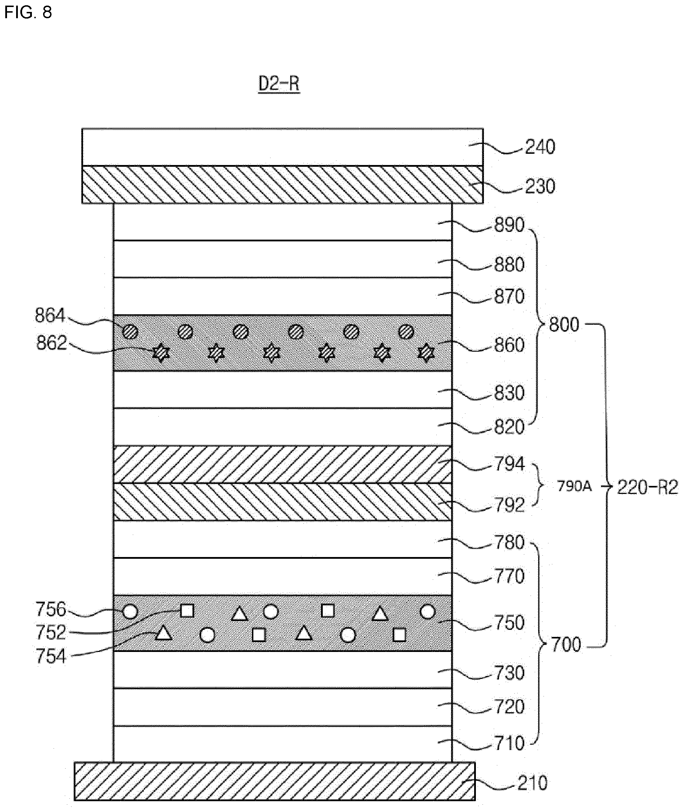

An emissive layer 220 is disposed on the first electrode 210. In one example embodiment, the emissive layer (first emissive layer) 220-B1 or 220-B2 disposed in the first pixel region SP1 can include a first blue emitting material layer 350 (FIGS. 3 and 6) of a blue fluorescence emitting layer and a second blue emitting material layer 360 or 460 (FIG. 3 or 6) of a blue PSF (Phosphor-Sensitized Fluorescence) emitting material layer. The emissive layer (second emissive layer) 220-G1 or 220-G2 disposed in the second pixel region SP2 can include a first green emitting material layer 550 (FIGS. 4 and 7) and a second green emitting material layer 560 or 660 (FIGS. 4 and 7) each of which includes at least a delayed fluorescent compound. Optionally, the emissive layer (third emissive layer) 220-R1 or 220-R2 disposed in the third pixel region SP3 can include a first red emitting material layer 750 (FIGS. 5 and 8) including at least delayed fluorescent compound and a second red emitting material layer 760 or 860 (FIGS. 5 and 8) including a phosphorescent compound.

In one example embodiment, the emissive layer 220 can have a single emitting part 220-B1, 220-G1 or 220-R1 (FIGS. 3 to 5). Alternatively, the emissive layer 220 can have multiple emitting parts 300, 400, 500, 600, 700 and 800 and at least one charge generation layer 390A, 590A, 690 A and/or 792+794 to have a tandem structure (FIGS. 6 to 8).

In another example embodiment, each of the emissive layer 220 and/or the emitting parts 300, 400, 500, 600, 700 and 800 in each of the first pixel region SP1, the second pixel region SP2 and the third pixel region SP3 can have single-layered structure of an emitting material layer (EML). Alternatively, the emissive layer 220 and/or the emitting parts 300, 400, 500, 600, 700 and 800 in each of the pixel regions SP1, SP2 and SP3 can have a multiple-layered structure of a hole injection layer (HIL), a hole transport layer (HTL), an electron blocking layer (EBL), an EML, a hole blocking layer (HBL), an electron transport layer (ETL) and/or an electron injection layer (EIL) (FIGS. 3 to 8). In addition, the emissive layer 220 in each of the first pixel region SP1, the second pixel region SP2 and the third pixel region SP3 can further include a charge generation layer (CGL) disposed between the emitting parts.

As described below, the blue emissive layer (first emissive layer) 220-B1 or 220-B2 disposed in the first pixel region SP1 can include a first blue emitting material layer 350 and a second blue emitting material layer 360 or 460 (FIGS. 3 and 6). The green emissive layer (second emissive layer) 220-G1 or 220-G2 disposed in the second pixel region SP2 can include a first green emitting material layer 550 and a second green emitting material layer 560 or 660 (FIGS. 4 and 7). The red emissive layer (third emissive layer) 220-R1 or 220-R2 disposed in the third pixel region SP3 can include a first red emitting material layer 750 and a second red emitting material layer 760 or 860 (FIGS. 5 and 8).

The first blue emitting material layer 350 can be a fluorescence emitting layer including a blue fluorescent emitter (dopant), and optionally, a first blue host, and the second blue emitting material layer 360 or 460 can be a PSF emitting layer including a phosphorescent compound, a blue fluorescent emitter (dopant), and optionally, a second host and/or a third blue host. The blue emitting material layer 360 or 460 of the PSF emitting layer can be disposed closer to the second electrode 230 of the transmissive electrode than the first blue emitting material layer 350 of the fluorescence emitting layer. In this case, strong cavity effect in the OLED D disposed in the first pixel region SP1 is realized so that the OLED D can have lower driving voltages and significantly improved luminous efficiency.

Each of the first green emitting material layer 550 and the second green emitting material layer 560 or 660 can be a fluorescence emitting layer that includes a delayed fluorescent compound, a fluorescent compound, and optionally, a green host. Since each of the first and second green emitting material layers 550, 560 and 660 includes a delayed fluorescent compound 552, 562, or 662 with beneficial luminous properties so that the OLED D disposed in the second pixel region SP2 can have beneficial luminous efficiency. In addition, since each of the first and second green emitting material layers 550, 560 and 660 includes a fluorescent compound 554, 564, or 664 with excellent color purity so that the OLED D disposed in the second pixel region SP3 can have excellent color purity. In this case, strong cavity effect in the OLED D disposed in the second pixel region SP2 is realized so that the OLED D can have lower driving voltages and significantly improved luminous efficiency.

The first red emitting material layer 750 is a fluorescence emitting layer including a delayed fluorescent compound, a fluorescent compound, and optionally, a red host, and the second red emitting material layer 760 or 860 is a phosphorescence emitting layer including a phosphorescent compound, and optionally, a red host. The second red emitting material layer 760 or 860 of the phosphorescence emitting layer can be disposed closer to the second electrode 230 of the reflective electrode than the first red emitting material layer 750. The second red emitting material layer 760 or 860 of the phosphorescence emitting layer has luminous efficiency higher than that of the first red emitting material layer 750 of the fluorescence emitting layer. For example, a phosphorescent emitter in the second red emitting material layer 760 or 860 of the phosphorescence emitting layer can have quantum efficiency larger than that of a fluorescent emitter in the first red emitting material layer 750 of the fluorescence emitting layer. In this case, strong cavity effect in the OLED D disposed in the third pixel region SP3 is realized so that the OLED D can have lower driving voltages and significantly improved luminous efficiency.

The second electrode 230 is disposed on the substrate 110 above which the emissive layer 220 is disposed. The second electrode 230 can be disposed on a whole display area. The second electrode 230 can include a conductive material with a relatively low work function value compared to the first electrode 210. The second electrode 230 can be a cathode providing electrons. In one example embodiment, the second electrode 230 can include a highly reflective material, for example, at least one of, but is not limited to, aluminum (Al), magnesium (Mg), calcium (Ca), silver (Ag), alloy thereof and/or combinations thereof such as aluminum-magnesium alloy (Al-Mg). When the organic light emitting display device 100 is a top-emission type, the second electrode 230 is thin (e.g., 10 nm to 30 nm) so as to have light-transmissive (semi-transmissive) property. Alternatively, the first electrode 210 can be the transmissive electrode and the second electrode 230 can be the reflective electrode in the organic light emitting display device 110 of the bottom-emission type.

The OLED D can further include a capping layer 240 (FIGS. 3 to 8) disposed on the second electrode 230. In this case, the luminous efficiency of the organic light emitting display device can be further improved.

In addition, an adhesive layer can be disposed on the OLED D. The adhesive layer can prevent primarily moisture and/or the likes from being penetrated into the OLED D. The adhesive layer can be made of, but is not limited to, optically clear resin (OCR).

In addition, an encapsulation film 180 can be disposed on the adhesive layer or the second electrode 230 in order to further prevent or reduce outer moisture from penetrating into the OLED D. The encapsulation film 180 can be made of transparent or semitransparent material. For example, the encapsulation film 180 can include, but is not limited to, plastics such as poly-imides, metal foils and/or the like. Alternatively, the encapsulation film 180 can have, but is not limited to, a laminated structure of a first inorganic insulating film, an organic insulating film and a second inorganic insulating film. The encapsulation film 180 can be omitted.

The organic light emitting display device 100 can further include a color filter layer disposed correspondingly to each of the first to third pixel regions SP1, SP2 and SP3. For example, the color filter layer can be disposed between the OLED D1 and the substrate 110, or over the OLED D1 or the encapsulation film 180.

The organic light emitting display device 100 can further include a polarizing plate in order to reduce reflection of external light. For example, the polarizing plate can be a circular polarizing plate. When the organic light emitting display device 100 is the bottom-emission type, the polarizing plate can be disposed under the substrate 110. Alternatively, when the organic light emitting display device 100 is the top-emission type, the polarizing plate can be disposed on the encapsulation film 180. In addition, a cover window can be attached to the encapsulation film 180 or the polarizing plate in the organic light emitting display device 100 of the top-emission type. In this case, the substrate 110 and the cover window may have a flexible property, thus the organic light emitting display device 100 may be a flexible display device.

In another example embodiment, the first electrode 210 can act as the transmissive electrode and the second electrode 230 can act as the reflective electrode in the organic light emitting display device 100 of the bottom-emission type. In this case, the second blue emitting material layer of the PSF emitting layer can be disposed closer to the first electrode 210 of the transmissive electrode than the first blue emitting material layer of the fluorescence emitting layer in the first pixel region SP1. In addition, the second red emitting material layer of the phosphorescence emitting layer can be disposed closer to the first electrode of the transmissive electrode than the first red emitting material layer of the fluorescence emitting layer.

The OLED D is described in more detail. FIG. 3 illustrates a schematic cross-sectional view of a blue organic light emitting diode D1-B disposed in the first pixel region SP1, FIG. 4 illustrates a schematic cross-sectional view of a green organic light emitting diode D1-G disposed in the second pixel region SP2, and FIG. 5 illustrates a schematic cross-sectional view of a red organic light emitting diode D1-R disposed in the third pixel region SP3.

As illustrated in FIG. 3, the blue OLED D1-B includes a first electrode 210 of a reflective electrode, a second electrode 230 of a transmissive (or semi-transmissive) electrode facing the first electrode 210, and a first emissive layer (blue emissive layer) 220-B1 disposed between the first and second electrodes 210 and 230. The first emissive layer 220-B1 includes a blue emitting material layer (blue EML) 340 that includes a first blue emitting material layer (blue EML1) 350 and a second blue emitting material layer (blue EML2) 360.

As illustrated in FIG. 4, the green OLED D1-G includes a first electrode 210 of a reflective electrode, a second electrode 230 of a transmissive (or semi-transmissive) electrode facing the first electrode 210, and a second emissive layer (green emissive layer) 220-G1 disposed between the first and second electrodes 210 and 230. The second emissive layer 220-G1 includes a green emitting material layer (green EML) 540 that includes a first green emitting material layer (green EML1) 550 and a second green emitting material layer (green EML2) 560.

As illustrated in FIG. 5, the red OLED D1-R includes a first electrode 210 of a reflective electrode, a second electrode 230 of a transmissive (or semi-transmissive) electrode facing the first electrode 210, and a third emissive layer (red emissive layer) 220-R1 disposed between the first and second electrodes 210 and 230. The third emissive layer 220-R1 includes a red emitting material layer (red EML) 740 that includes a first red emitting material layer (red EML1) 750 and a second red emitting material layer (red EML2) 760.

In addition, each of the blue OLED D1-B, the green OLED D1-G and the red OLED D1-R can further include a capping layer 240 in order to improve light extraction. The capping layer 240 disposed in the blue OLED D1-B, the green OLED D1-G and the red OLED D1-R can be integrally formed by being connected to each other. Each of the blue OLED D1-B, the green OLED D1-G and the red OLED D1-R can be disposed in the first pixel region SP1, the second pixel region SP2 and the third pixel region SP3, respectively, in the organic light emitting display device 100.

The first electrode 210 can be an anode and the second electrode 230 can be a cathode in each of the blue OLED D1-B, the green OLED D1-G and the red OLED D1-R, respectively. The first electrode 210 can be the reflective electrode and the second electrode 230 can be the transmissive (or semi-transmissive) electrode. As an example, the first electrode 210 can include ITO or ITO/Ag/ITO and the second electrode 230 can include MgAg, but is not limited thereto. When the second electrode 230 includes MgAg, the contents of the Mg can be about 10 wt%. The first electrode 210 has a first light transmittance and the second electrode 230 has a second light transmittance larger than the first light transmittance.

The first emissive layer 220-B1 can further include at least one of a hole transport layer (HTL) 320 disposed between the first electrode 210 and the blue EML 340 and an electron transport layer (ETL) 380 disposed between the blue EML 340 and the second electrode 230. In addition, the first emissive layer 220-B1 can further include at least one of a hole injection layer (HIL) 310 disposed between the first electrode 210 and the HTL 320 and an electron injection layer (EIL) 390 disposed between the ETL 380 and the second electrode 230. Alternatively, the first emissive layer 220-B1 can further include at least one of an electron blocking layer (EBL) 330 disposed between the blue EML 340 and the HTL 320 and a hole blocking layer (HBL) 370 disposed between the blue EML 340 and the ETL 380.

The second emissive layer 220-G1 can further include at least one of an HTL 520 disposed between the first electrode 210 and the green EML 540 and an ETL 580 disposed between the green EML 540 and the second electrode 230. In addition, the second emissive layer 220-G1 can further include at least one of an HIL 510 disposed between the first electrode 210 and the HTL 520 and an EIL 590 disposed between the ETL 580 and the second electrode 230. Alternatively, the second emissive layer 220-G1 can further include at least one of an EBL 530 disposed between the green EML 540 and the HTL 520 and an HBL 570 disposed between the green EML 540 and the ETL 580.

The third emissive layer 220-R1 can further include at least one of an HTL 720 disposed between the first electrode 210 and the red EML 740 and an ETL 780 disposed between the red EML 740 and the second electrode 230. In addition, the third emissive layer 220-R1 can further include at least one of an HIL 710 disposed between the first electrode 210 and the HTL 720 and an EIL 790 disposed between the ETL 780 and the second electrode 230. Alternatively, the third emissive layer 220-R1 can further include at least one of an EBL 730 disposed between the red EML 740 and the HTL 720 and an HBL 770 disposed between the red EML 740 and the ETL 780.

Each of the HILs 310, 510 and 710, the HTLs 320, 520 and 720, the EBLs 330, 530 and 730, the HBLs 370, 570 and 770, the ETLs 380, 580 and 780 and the EILs 390, 590 and 790 can be a common layer in each of the blue OLED D1-B, the green OLED D1-G and the red OLED D1-R, respectively. The HILs 310, 510 and 710, the HTLs 320, 520 and 720, the EBLs 330, 530 and 730, the HBLs 370, 570 and 770, the ETLs 380, 580 and 780 and the EILs 390, 590 and 790 in the blue OLED D1-B, the green OLED D1-G and the red OLED D1-R can be integrally formed by being connected to each other.

The blue EML1 340 of the fluorescence emitting layer can include a first compound 352, and optionally, a second compound 354. The first compound 352 can be a first blue fluorescent compound (fluorescent emitter or fluorescent dopant) and the second compound 354 can be a first blue host.

In one example embodiment, the first compound 352 of the first blue fluorescent compound can be a pyrene-based organic compound. For example, the first compound can have, but is not limited to, the following structure of Chemical Formula 1: 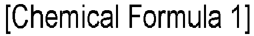 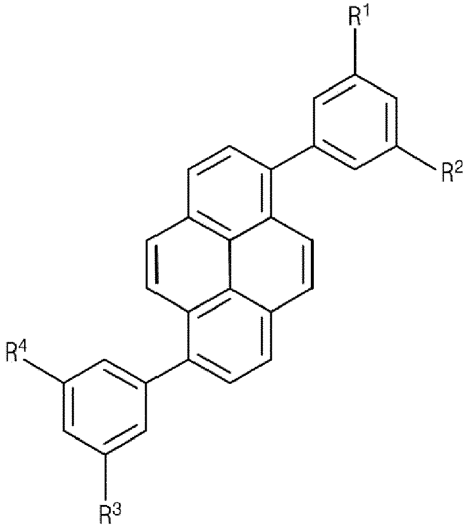 wherein, in the Chemical Formula 1,
each of R¹, R², R³ and R⁴ is independently hydrogen, an unsubstituted or substituted C₁-C₂₀ alkyl group, an unsubstituted or substituted C₆-C₃₀ aryl group or an unsubstituted or substituted C₆-C₃₀ aryl amino group.

As used herein, the term "unsubstituted" means that a hydrogen is directly linked to a carbon atom. "Hydrogen", as used herein, can refer to protium, deuterium and tritium.

As used herein, "substituted" means that the hydrogen is replaced with a substituent. The substituent can comprise, but is not limited to, an unsubstituted or halogen-substituted C₁-C₂₀ alkyl group, an unsubstituted or halogen-substituted C₁-C₂₀ alkoxy group, halogen, a cyano group, a hydroxyl group, a carboxylic group, a carbonyl group, an amino group, a C₁-C₁₀ alkyl amino group, a C₆-C₃₀ aryl amino group, a C₃-C₃₀ hetero aryl amino group, a nitro group, a hydrazyl group, a sulfonate group, an unsubstituted or halogen-substituted C₁-C₁₀ alkyl silyl group, an unsubstituted or halogen-substituted C₁-C₁₀ alkoxy silyl group, an unsubstituted or halogen-substituted C₃-C₂₀ cyclo alkyl silyl group, an unsubstituted or halogen-substituted C₆-C₃₀ aryl silyl group, a C₃-C₃₀ hetero aryl silyl group, an unsubstituted or substituted C₆-C₃₀ aryl group, and/or an unsubstituted or substituted C₃-C₃₀ hetero aryl group.

In an example embodiment, the substituent among an alkyl group, an aryl group, a hetero aryl group, an arylene group, a hetero arylene group, an aryl amino group and/or a hetero aryl group can be at least one of a C₁-C₁₀ alkyl group, a C₆-C₃₀ aryl group and a C₃-C₃₀ hetero aryl group unless otherwise indicated.

As used herein, the term "hetero" in terms such as "a hetero aromatic group", "a hetero aryl group", "a hetero arylene group" and the likes means that at least one carbon atom, for example 1 to 5 carbons atoms, constituting an aliphatic chain, an alicyclic group or ring or an aromatic group or ring is substituted with at least one hetero atom selected from the group consisting of N, O, S and P.

As used herein, the C₆-C₃₀ aryl group can include, but is not limited to, an unfused or fused aryl group such as phenyl, biphenyl, terphenyl, naphthyl, anthracenyl, pentalenyl, indenyl, indeno-indenyl, heptalenyl, biphenylenyl, indacenyl, phenalenyl, phenanthrenyl, benzo-phenanthrenyl, dibenzo-phenanthrenyl, azulenyl, pyrenyl, fluoranthenyl, triphenylenyl, chrysenyl, tetraphenylenyl, tetracenyl, pleiadenyl, picenyl, pentaphenylenyl, pentacenyl, fluorenyl, indeno-fluorenyl or spiro-fluorenyl unless otherwise indicated. The C₆-C₃₀ arylene group can be a bivalent substituent corresponding to the aryl group unless otherwise indicated.

As used herein, the C₃-C₃₀ hetero aryl group can comprise, but is not limited to, an unfused or fused hetero aryl group such as pyrrolyl, pyridinyl, pyrimidinyl, pyrazinyl, pyridazinyl, triazinyl, tetrazinyl, imidazolyl, pyrazolyl, indolyl, iso-indolyl, indazolyl, indolizinyl, pyrrolizinyl, carbazolyl, benzo-carbazolyl, dibenzo-carbazolyl, indolo-carbazolyl, indeno-carbazolyl, benzo-furo-carbazolyl, benzo-thieno-carbazolyl, carbolinyl, quinolinyl, iso-quinolinyl, phthlazinyl, quinoxalinyl, cinnolinyl, quinazolinyl, quinolizinyl, purinyl, benzo-quinolinyl, benzo-iso-quinolinyl, benzo-quinazolinyl, benzo-quinoxalinyl, acridinyl, phenazinyl, phenoxazinyl, phenothiazinyl, phenanthrolinyl, perimidinyl, phenanthridinyl, pteridinyl, naphthyridinyl, furanyl, pyranyl, oxazinyl, oxazolyl, oxadiazolyl, triazolyl, dioxinyl, benzo-furanyl, dibenzo-furanyl, thiopyranyl, xanthenyl, chromenyl, iso-chromenyl, thioazinyl, thiophenyl, benzo-thiophenyl, dibenzo-thiophenyl, difuro-pyrazinyl, benzofuro-dibenzo-furanyl, benzothieno-benzo-thiophenyl, benzothieno-dibenzo-thiophenyl, benzothieno-benzo-furanyl, benzothieno-dibenzo-furanyl, xanthene-linked spiro acridinyl, dihydroacridinyl substituted with at least one C₁-C₁₀ alkyl and N-substituted spiro fluorenyl unless otherwise indicated. The C₃-C₃₀ hetero arylene group can be a bivalent substituent corresponding to the hetero aryl group unless otherwise indicated.

As an exmaple, each of R¹, R², R³ and R⁴ in Chemical Formula 1 can be independently a C₁-C₁₀ alkyl group (*e.g*., *tert*-butyl) or a C₆-C₃₀ aryl group (*e.g.*, phenyl or naphthyl). In one example embodiment, the first compound 352 can be at least one of or selected from, but is not limited to, the following compounds of Chemical Formula 2:

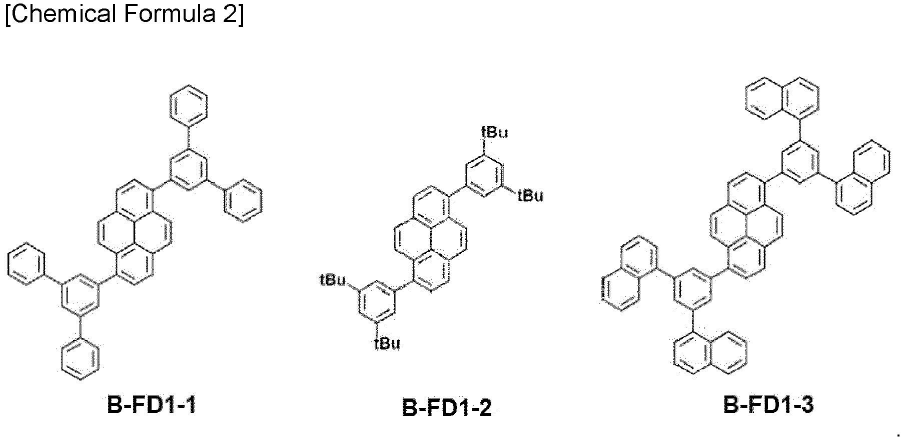

In one example embodiment, the second compound 354 of the first blue host can be a biscarbazole-based organic compound. For example, the second compound 354 can have, but is not limited to, the following structure of Chemical Formula 3: 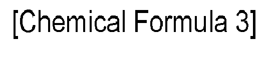 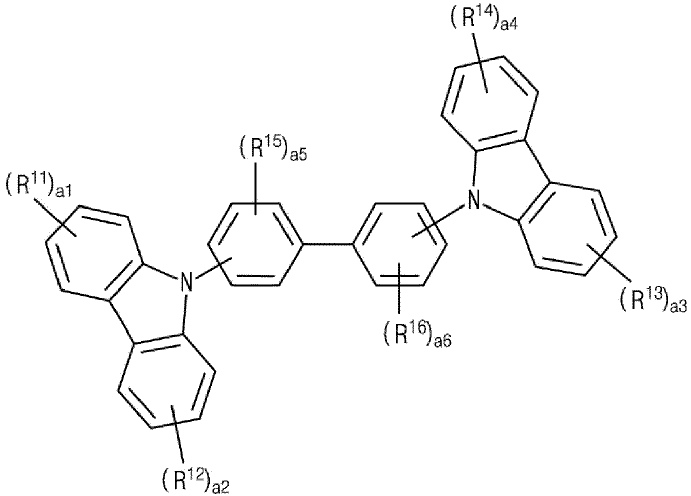 wherein, in the Chemical Formula 3,
each of R¹¹, R¹², R¹³, R¹⁴, R¹⁵ and R¹⁶ is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹ is identical to or different from each other when a1 is 2, 3 or 4, where each R¹² is identical to or different from each other when a2 is 2, 3 or 4, where each R¹³ is identical to or different from each other when a3 is 2, 3 or 4, where each R¹⁴ is identical to or different from each other when a4 is 2, 3 or 4, where each R¹⁵ is identical to or different from each other when a5 is 2, 3 or 4, and where each R¹⁶ is identical to or different from each other when a6 is 2, 3 or 4; and
each of a1, a2, a3, a4, a5 and a6 is independently 0, 1, 2, 3 or 4.

For example, each of R¹¹, R¹², R¹³, R¹⁴, R¹⁵ and R¹⁶ in Chemical Formula 3 can be independently an unsubstituted or substituted C₁-C₁₀ alkyl group (e.g., methyl or tert-butyl) or an unsubstituted or substituted C₆-C₃₀ aryl group (e.g., phenyl unsubstituted or substituted with a C₁-C₁₀ alkyl group such as methyl and/or tert-butyl). In addition, each of a1, a2, a3 and a4 in Chemical Formula 3 can be independently 0 or 1 and each of a5 and a6 in Chemical Formula 3 can be independently 0.

In one example embodiment, the carbazole moieties in Chemical Formula 3 can be linked to a specific position of the central benzene rings. For example, each of the carbazole moieties in Chemical Formula 3 can be linked to an ortho- or a meta- position of the benzene ring. As an example, the second compound 354 can have the following structure of Chemical Formula 3A or Chemical Formula 3B: 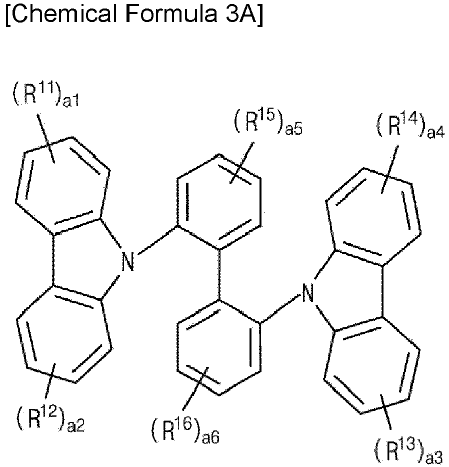 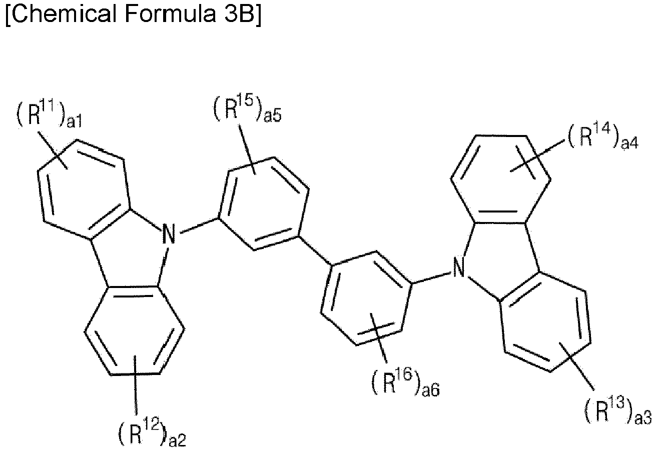 wherein, in the Chemical Formulae 3A and 3B,
each of R¹¹, R¹², R¹³, R¹⁴, R¹⁵ and R¹⁶, and a1, a2, a3, a4, a5 and a6 is a same as defined in Chemical Formula 3.

In one example embodiment, the second compound 354 can be at least one of or selected from, but is not limited to, the following compounds of Chemical Formula 4:

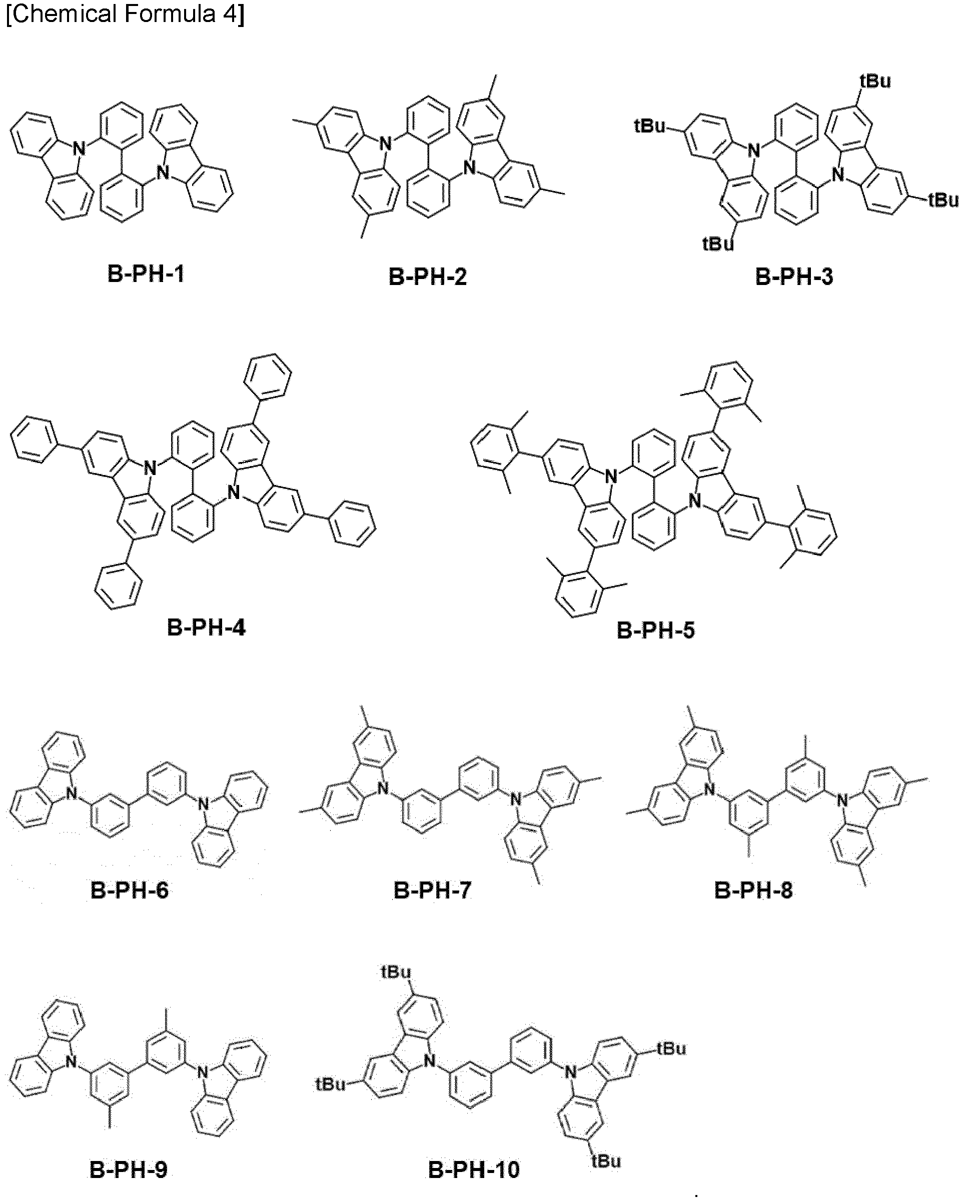

The contents of the first compound 352 can be less than the contents of the second compound 354 in the blue EML1 350. As an example, the contents of the first compound 352 in the blue EML1 350 can be, but is not limited to, about 0.1 wt% to about 10 wt%.

The blue EML2 360 can include a third compound 362, a fourth compound 364, and optionally, a fifth compound 366 and/or a sixth compound 368. The third compound 362 can be a second blue fluorescent compound (fluorescent emitter or fluorescent dopant), the fourth compound 364 can be a blue phosphorescent compound (phosphorescent emitter or auxiliary dopant), the fifth compound 366 can be a second blue host and the sixth compound 368 can be a third blue host. The fifth compound 366 can be a P-type blue host and the sixth compound 368 can be an N-type blue host.

In one example embodiment, the third compound 362 of the second blue fluorescent compound can be a boron-based organic compound. For example, the third compound 362 can have, but is not limited to, the following structure of Chemical Formula 5: 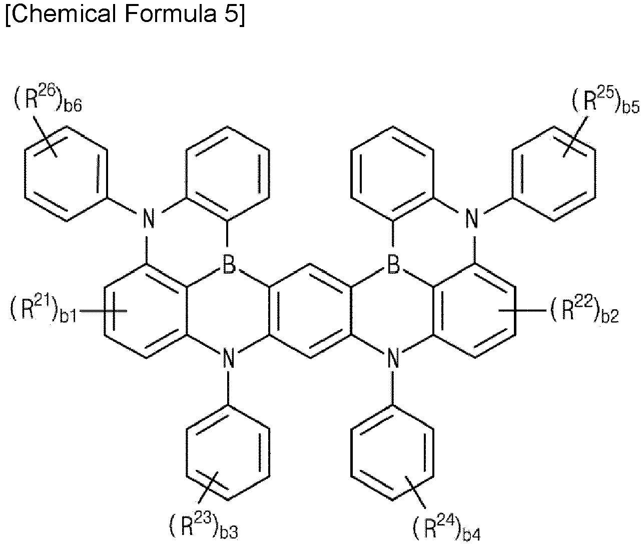 wherein, in the Chemical Formula 5,
each of R²¹ and R²² is independently an unsubstituted or substituted C₆-C₃₀ aryl group, an unsubstituted or substituted C₃-C₃₀ hetero aryl group or an unsubstituted or substituted C₆-C₃₀ aryl amino group, where each R²¹ is identical to or different from each other when b1 is 2 or 3, and where each R²² is identical to or different from each other when b2 is 2 or 3;
each of R²³, R²⁴, R²⁵ and R²⁶ is independently an unsubstituted or substituted C₁-C₂₀ alkyl group or an unsubstituted or substituted C₆-C₃₀ aryl group, where each R²³ is identical to or different from each other when b3 is 2, 3, 4 or 5, where each R²⁴ is identical to or different from each other when b4 is 2, 3, 4 or 5, where each R²⁵ is identical to or different from each other when b5 is 2, 3, 4 or 5, and where each R²⁶ is identical to or different from each other when b6 is 2, 3, 4 or 5;
each of b1 and b2 is independently 0, 1, 2 or 3; and
each of b3, b4, b5 and b6 is independently 0, 1, 2, 3, 4 or 5.

In one example embodiment, each of R²¹ and R²² in Chemical Formula 5 can be independently an unsubstituted or substituted C₃-C₃₀ hetero aryl group or an unsubstituted or substituted C₆-C₃₀ aryl amino group, and each of R²³, R²⁴, R²⁵ and R²⁶ in Chemical Formula 5 can be independently an unsubstituted or substituted C₆-C₃₀ aryl group.

Alternatively, each of R²¹ and R²² in Chemical Formula 5 can be independently an unsubstituted or C₁-C₁₀ alkyl (e.g., methyl)-substituted C₃-C₃₀ hetero aryl group (e.g., carbazolyl). Each of R²³, R²⁴, R²⁵ and R²⁶ in Chemical Formula 5 can be independently an unsubstituted or C₁-C₁₀ alkyl (e.g., tert-butyl)-substituted C₆-C₃₀ aryl group (e.g., phenyl). For example, the third compound 362 can have the following structure of Chemical Formula 5A: 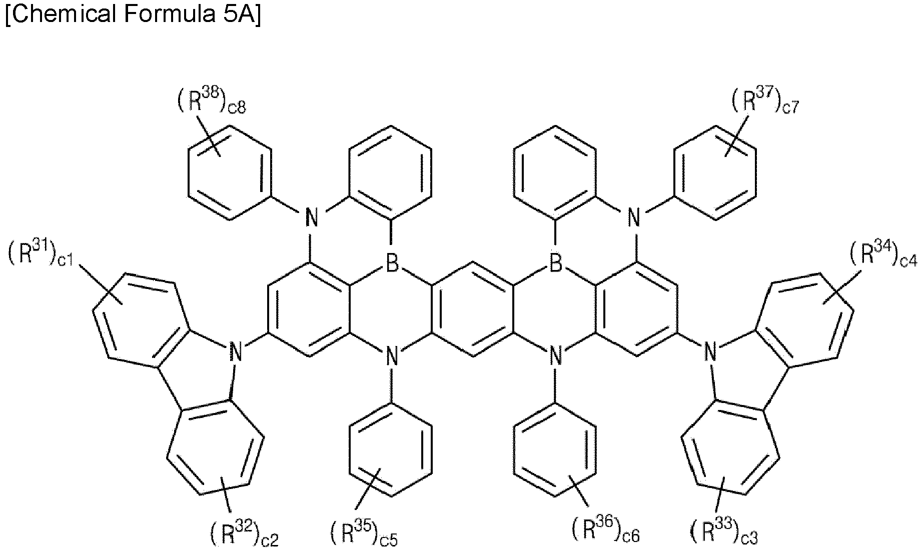 wherein, in the Chemical Formula 5A,
each of R³¹, R³², R³³, R³⁴, R³⁵, R³⁶, R³⁷ and R³⁸ is independently an unsubstituted or substituted C₁-C₂₀ alkyl group or an unsubstituted or substituted C₆-C₃₀ aryl group, where R³¹ is identical to or different from each other when c1 is 2, 3 or 4, where each R³² is identical to or different from each other when c2 is 2, 3 or 4, where each R³³ is identical to or different from each other when c3 is 2, 3 or 4, where each R³⁴ is identical to or different from each other when c4 is 2, 3 or 4, where each R³⁵ is identical to or different from each other when c5 is 2, 3, 4 or 5, where each R³⁶ is identical to or different from each other when c6 is 2, 3, 4 or 5, where each R³⁷ is identical to or different from each other when c7 is 2, 3, 4 or 5, and where each R³⁸ is identical to or different from each other when c8 is 2, 3, 4 or 5;
each of c1, c2, c3 and c4 is independently 0, 1, 2, 3 or 4; and
each of c5, c6, c7 and c8 is independently 0, 1, 2, 3, 4 or 5.

For example, each of R³¹, R³², R³³, R³⁴, R³⁵, R³⁶, R³⁷ and R³⁸ in Chemical Formula 5A can be independently a C₁-C₁₀ alkyl group (e.g., methyl or tert-butyl), each of c1, c2, c3, c4, c5 and c6 in chemical Formula 5A can be independently 0 or 1, and each of c7 and c8 in Chemical Formula 5A can be independently 0. For example, the third compound 362 can be at least one of or selected from, but is not limited to, the following compounds of Chemical Formula 6:

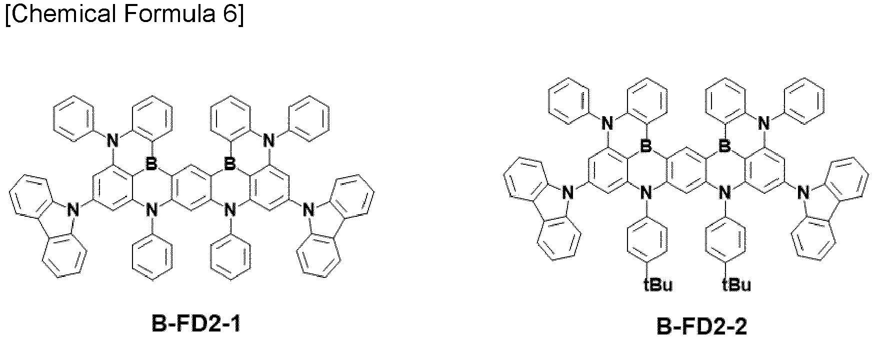

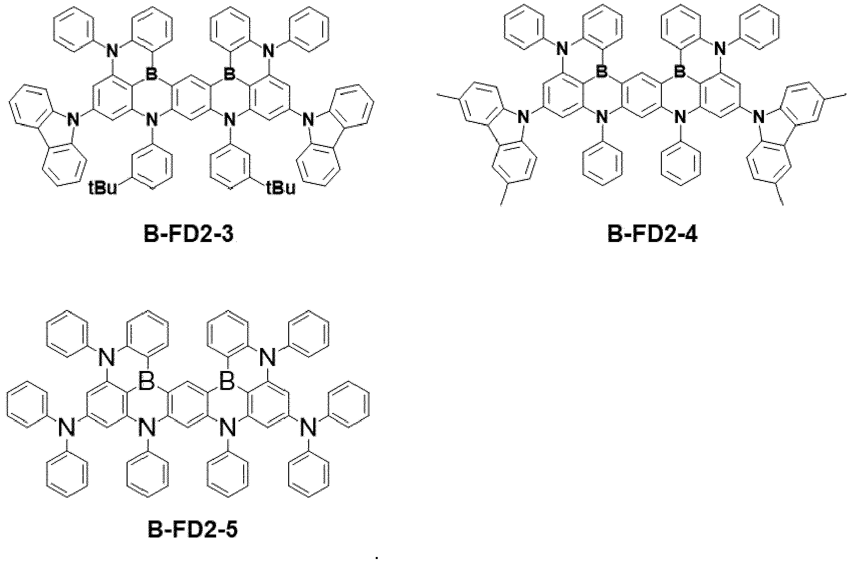

In one example embodiment, the fourth compound 364 of the blue phosphorescent compound can be an organometallic compound where a central metal atom is platinum. For example, the fourth compound 364 can have, but is not limited to, the following organometallic compound of Chemical Formula 7: 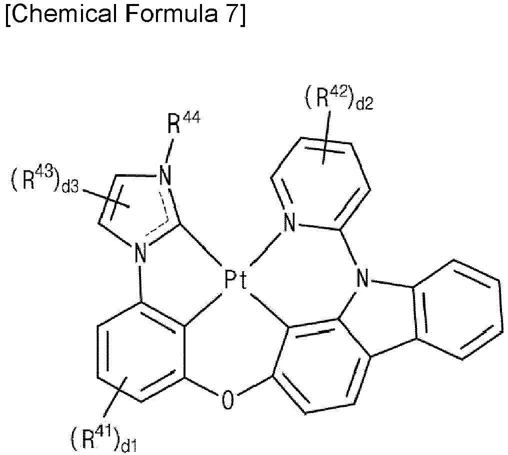 wherein, in the Chemical Formula 7,
each of R⁴¹, R⁴² and R⁴³ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁴¹ is identical to or different from each other when d1 is 2 or 3, where each R⁴² is identical to or different from each other when d2 is 2, 3 or 4, and where each R⁴³ is identical to or different from each other when d3 is 2;
R⁴⁴ is hydrogen, an unsubstituted or substituted C₁-C₂₀ alkyl group, an unsubstituted or substituted C₆-C₃₀ aryl group or an unsubstituted or substituted C₃-C₃₀ hetero aryl group;
d1 is 0, 1, 2 or 3;
d2 is 0, 1, 2, 3 or 4; and
d3 is 0, 1 or 2.

In one example embodiment, each of R⁴¹, R⁴² and R⁴⁴ in Chemical Formula 7 can be independently an unsubstituted or substituted C₁-C₁₀ alkyl group (*e.g*., methyl or tert-butyl), each of d1 and d2 can be independently 1, and d3 can be 0. For example, the fourth compound 364 can be at least one of or selected from, but is not limited to, the following organometallic compounds of Chemical Formula 8:

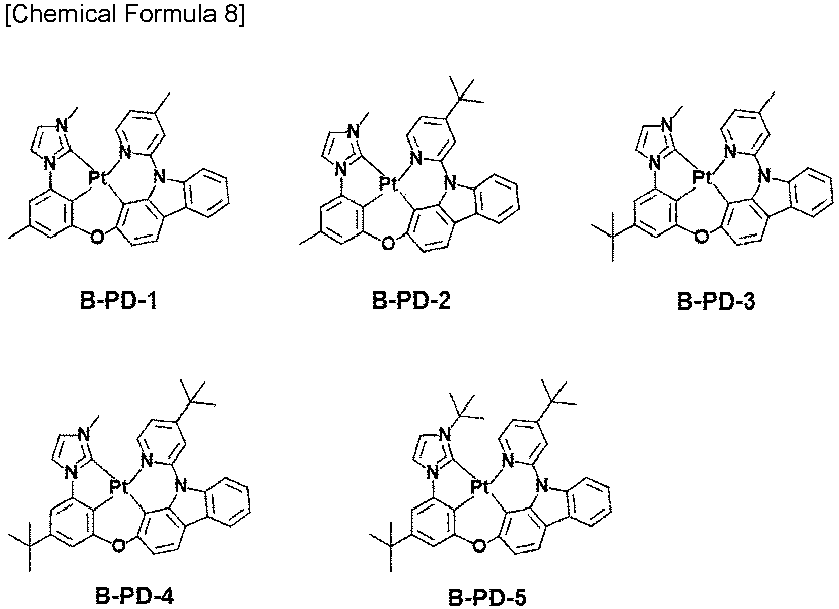

In one example embodiment, the fifth compound 366 of the second blue host can be a biscarbazole-based organic compound. For example, the fifth compound 366 can have the structure of Chemical Formulae 3, 3A, 3B and/or 4. As an example, the fifth compound 366 can have, but is not limited to, the structure of Chemical Formula 3A or Chemical Formula 3B.

In another example embodiment, each of the second compound 354 and the fifth compound 366 can independently have the structure of Chemical Formula 3A or Chemical Formula 3B. The second compound 354 in the blue EML1 350 can be identical to or different from the fifth compound 366 in the blue EML2 360. Alternatively, each of the second compound 354 and the fifth compound 366 can independently have the structure of Chemical Formula 3A.

In one example embodiment, the sixth compound 368 of the third blue host can have a carbazole moiety and an azine moiety such as a triazine moiety. For example, the sixth compound 368 can have, but is not limited to, the following structure of Chemical Formula 9: 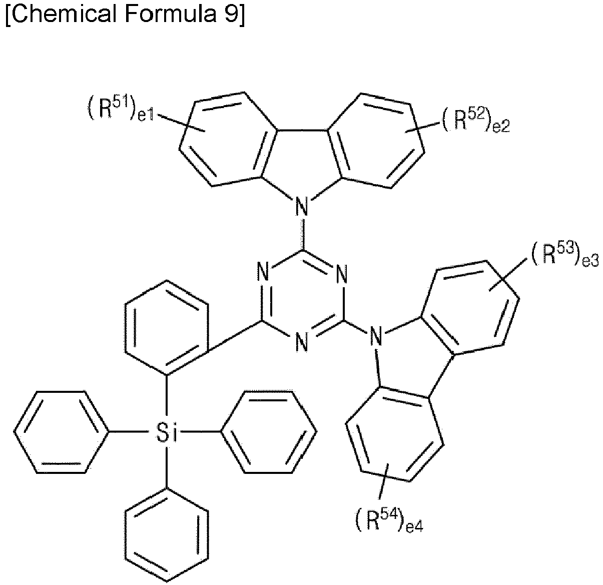 wherein, in the Chemical Formula 9,
each of R⁵¹, R⁵², R⁵³ and R⁵⁴ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁵¹ is identical to or different from each other when e1 is 2, 3 or 4, where each R⁵² is identical to or different from each other when e2 is 2, 3 or 4, where each R⁵³ is identical to or different from each other when e3 is 2, 3 or 4, and where each R⁵⁴ is identical to or different from each other when e4 is 2, 3 or 4; and
each of e1, e2, e3 and e4 is independently 0, 1, 2, 3 or 4.

In one example embodiment, each of R⁵¹, R⁵², R⁵³ and R⁵⁴ in Chemical Formula 9 can be independently an unsubstituted or substituted C₁-C₂₀ alkyl group (e.g., methyl or tert-butyl) or an unsubstituted or C₁-C₂₀ alkyl (e.g., tert-butyl)-substituted C₆-C₃₀ aryl group (e.g., phenyl), and each of e1, e2, e3 and e4 can be independently 0 or 1. As an example, the fourth compound 368 can be at least one of or selected from, but is not limited to, the following compounds of Chemical Formula 10:

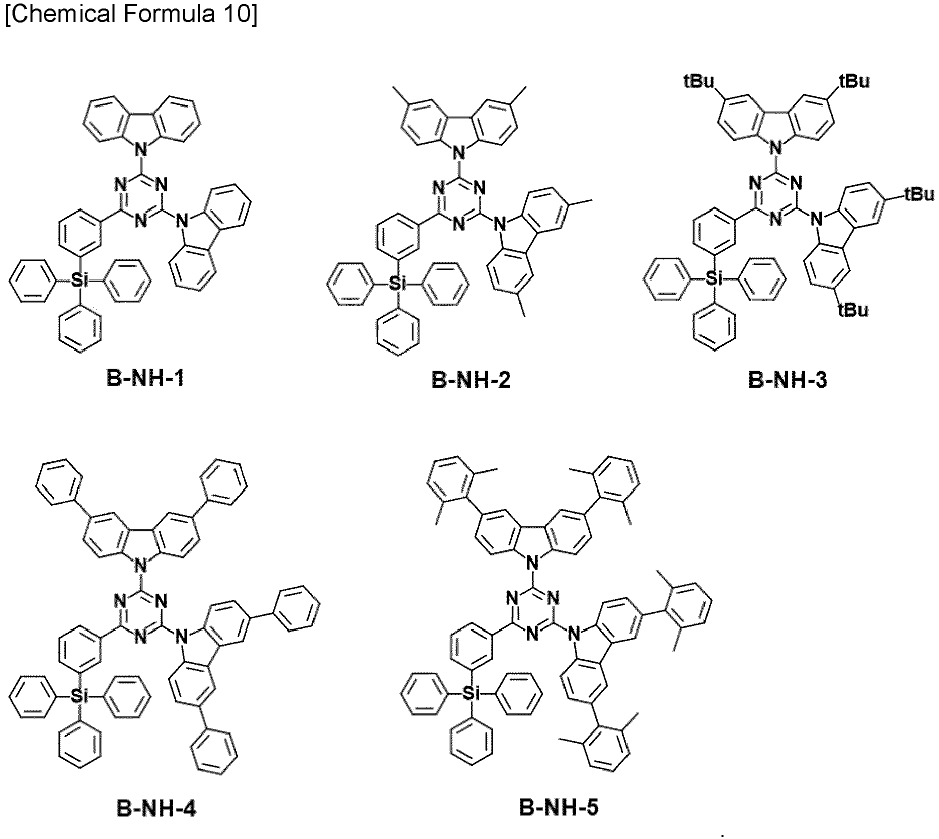

The contents of the fourth compound 364 can be larger than the contents of the third compound 362, but can be less than the contents of the fifth compound 366 and the sixth compound 368 in the blue EML2 360. The contents of the fifth compound 366 can be identical to or different from the contents of the sixth compound 368 in the blue EML2 360. For example, the contents of the fourth compound 364 can be about 500 to about 2000 parts by weight and the contents of each of the fifth and sixth compounds 366 and 368 can be about 3000 to about 6000 parts by weight based on the contents of the third compound 362.

In the blue EML2 360, a difference between the maximum absorption wavelength of the third compound 362 and the maximum photoluminescence wavelength of the fourth compound 364 can be about 15 nm or less. Accordingly, luminous properties of the blue OLED D1-B can be further improved.

In the blue OLED D1-B, the blue EML2 360 of the PSF emitting layer is disposed closer to the second electrode 230 of the transmissive electrode than the blue EML1 350. In other words, the blue EML2 360 of the PSF emitting layer is disposed between the second electrode 230 of the transmissive electrode and the blue EML1 350 of the fluorescence emitting layer.

In another example embodiment, a difference between a first luminescence peak intensity in the blue EML1 350 and a second luminescence peak intensity in the blue EML2 360 of the PSF emitting layer can be about 0.1 or less. In this case, a strong cavity effect can be realized in the blue OLED D1-B so that the blue OLED D1-B can have lower driving voltages and greatly improved blue luminous efficiency. As used herein, the second luminescence peak means a luminescence peak having the second highest luminescence intensity or a luminescence peak at a wavelength obtained by adding about 30 nm to the maximum luminescence wavelength.

In another example embodiment, a difference between the maximum luminescence wavelength of the first compound 352 in the blue EML1 350 and the maximum luminescence wavelength of the third compound 362 in the blue EML2 360 of the PSF emitting layer can be about 15 nm or less. In this case, the luminous efficiency of the blue OLED D1-B can be further improved.

Alternatively, the first electrode 210 can be the transmissive (semi-transmissive) electrode and the second electrode 230 can be the reflective electrode. In this case, the blue EML2 of the PSF emitting layer is disposed closer to the first electrode 210 of the transmissive electrode than the blue EML1 of the fluorescence emitting layer. In other words, the blue EML2 360 of the PSF emitting layer is disposed between the first electrode 210 and the blue EML1 350 of the fluorescence emitting layer.

With referring to FIG. 4, the green EML 540 includes the green EML1 550 and the green EML2 560 each of which is fluorescence emitting layer. The green EML2 560 is disposed between the green EML1 550 and the HBL 570. The green EML1 550 includes a seventh compound 552, an eighth compound 554, and optionally a ninth compound 556. The green EML2 560 includes a tenth compound 562, an eleventh compound 564, and optionally a twelfth compound 566.

Each of the seventh compound 552 and the tenth compound 562 is a first green delayed fluorescent compound (auxiliary dopant) and a second green delayed fluorescent compound (auxiliary dopant), respectively. Each of the eighth compound 554 and the eleventh compound 564 is a first green fluorescent compound (fluorescent emitter, fluorescent dopant) and a second green fluorescent compound (fluorescent emitter, fluorescent dopant), respectively. Each of the ninth compound 556 and the twelfth compound 566 is a first green host and a second green host, respectively.

The seventh compound 552 can be identical to or different form the tenth compound 562. The eighth compound 554 can be identical to or different form the eleventh compound 564. The ninth compound 556 can be identical to or different from the twelfth compound 566.

In one example embodiment, each of the seventh compound 552, which can be the first green delayed fluorescent compound in the green EML1 550, and the tenth compound 562, which can be the second green delayed fluorescent compound in the green EML2 560, can independently have, but is not limited to, the following structure of Chemical Formula 11: 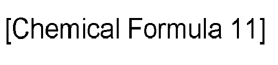 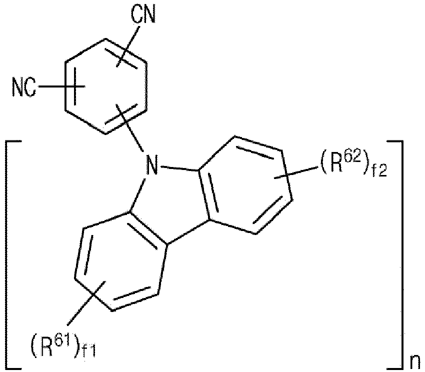 wherein, in the Chemical Formula 11,
each of R⁶¹ and R⁶² is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁶¹ is identical to or different from each other when f1 is 2, 3 or 4, and where each R⁶² is identical to or different from each other when f2 is 2, 3 or 4;
each of f1 and f2 is independently 0, 1, 2, or 4; and
n is 1, 2, 3 or 4.

In one example embodiment, each of R⁶¹ and R⁶² can be independently a C₁-C₂₀ alkyl group (*e.g.*, methyl) or a C₃-C₃₀ hetero aryl group (*e.g.*, carbazolyl), each of f1 and f2 can be independently 0 or 1, and n can b 3 or 4 in Chemical Formula 11.

As an example, each of the seventh compound 552 and the tenth compound 562 can be independently at least one of or selected from, but is not limited to, the following compounds of Chemical Formula 12:

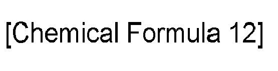

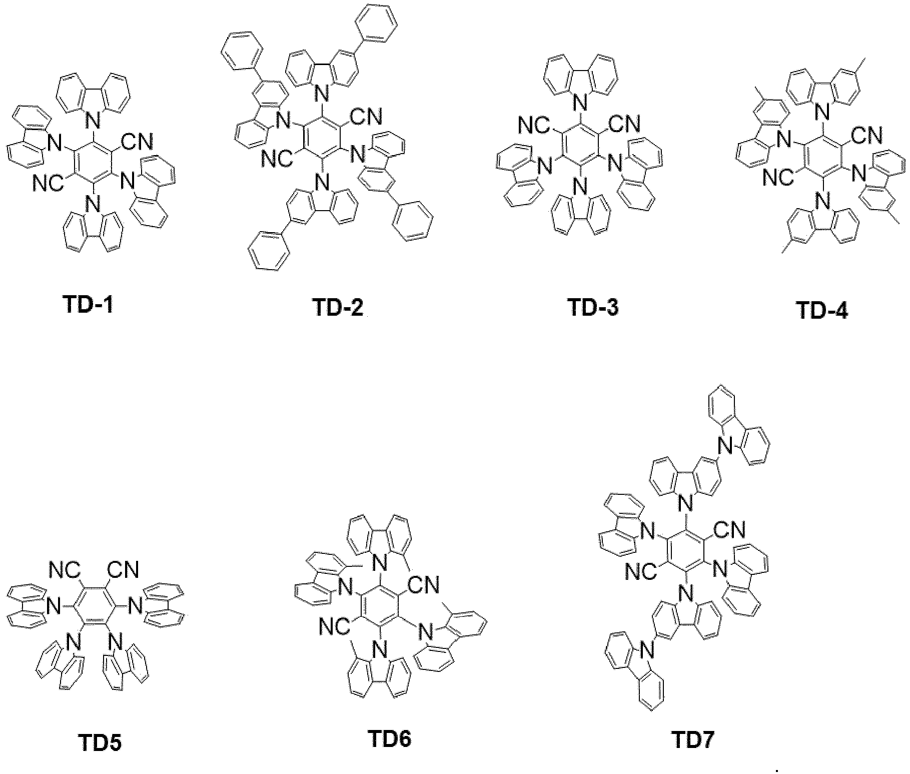

Alternatively, each of the seventh compound 552 and the tenth compound 562 can be independently an organic compound where two cyano groups substituted to the benzene ring in Chemical Formula 11 are linked to each other at an ortho- or meta-position. As an example, each of the seventh compound 552 and the tenth compound 562 can be independently, but is not limited to, at least one of Compound TD-3 and Compound TD-5 in Chemical Formula 12.

In one example embodiment, each of the eighth compound 554, which can be the first green fluorescent compound in the green EML1 550, and the eleventh compound 564, which can be the second green florescent compound in the green EML2 560, can be independently a boron-based organic compound. For example, each of the eighth compound 554 and the eleventh compound 564 can independently have, but is not limited to, the following structure of Chemical Formula 13A or Chemical Formula 13B: 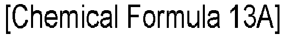 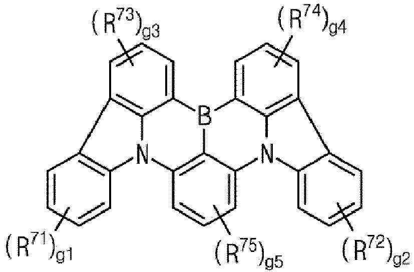 wherein, in the Chemical Formula 13A,
each of R⁷¹, R⁷², R⁷³ and R⁷⁴ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁷¹ is identical to or different from each other when g1 is 2, 3 or 4, where each R⁷² is identical to or different from each other when g2 is 2, 3 or 4, where each R⁷³ is identical to or different from each other when g3 is 2 or 3, where each R⁷⁴ is identical to or different from each other when g4 is 2 or 3;
R⁷⁵ is an unsubstituted or substituted C₃-C₃₀ hetero aryl group, or
optionally, two adjacent R⁷⁵ when g5 is 2 or 3 can be further linked to form an unsubstituted or substituted C₆-C₃₀ aryl ring or an unsubstituted or substituted C₃-C₂₀ hetero aryl ring;
each of g1 and g2 is independently 0, 1, 2, 3 or 4; and
each of g3, g4 and g5 is independently 0, 1, 2 or 3, 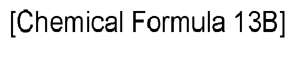 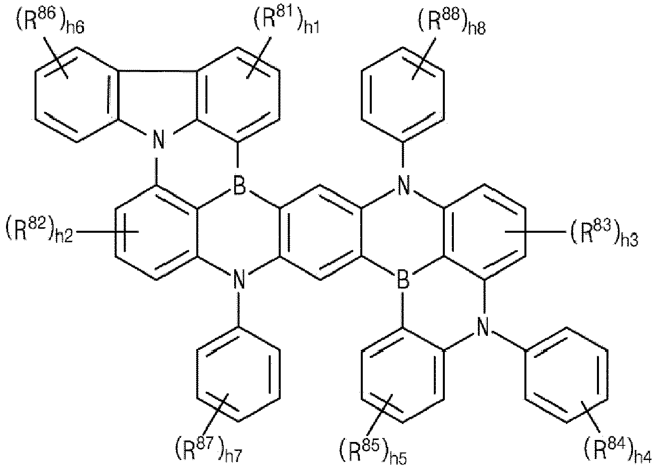 wherein, in the Chemical Formula 13B,
   each of R⁸¹, R⁸², R⁸³, R⁸⁴, R⁸⁵, R⁸⁶, R⁸⁷ and R⁸⁸ is independently an unsubstituted or substituted C₁-C₂₀ alkyl group, an unsubstituted or substituted C₆-C₃₀ aryl group or an unsubstituted or substituted C₃-C₃₀ hetero aryl group, or optionally, R⁸⁴ is fused to a ring including R⁸³ or a ring including R⁸⁵ to form a 5-membering ring or a 6-membering ring including a nitrogen atom, where R⁸¹ is identical to or different from each other when h1 is 2 or 3, where each R⁸² is identical to or different from each other when h2 is 2 or 3, where each R⁸³ is identical to or different from each other when h3 is 2 or 3, where each R⁸⁴ is identical to or different from each other when h4 is 2, 3, 4 or 5, where each R⁸⁵ is identical to or different from each other when h5 is 2, 3 or 4, where each R⁸⁶ is identical to or different from each other when h6 is 2, 3 or 4, where each R⁸⁷ is identical to or different from each other when h7 is 2, 3, 4 or 5, and where each R⁸⁸ is identical to or different from each other when h8 is 2, 3, 4 or 5;
   each of h1, h2 and h3 is independently 0, 1, 2 or 3;
   each of h5 and h6 is independently 0, 1, 2, 3 or 4; and
   each of h4, h7 and h8 is independently 0, 1, 2, 3, 4 or 5.

In one example embodiment, each of R⁷¹, R⁷², R⁷³ and R⁷⁴ can be independently a C₁-C₂₀ alkyl group (*e.g.*, tert-butyl), R⁷⁵ can be an unsubstituted or at least one, for example, two to four, C₁-C₁₀ alkyl-substituted C₃-C₃₀ hetero aryl group (*e.g*., carbazolyl), or two adjacent R⁷⁵ can be further linked to form an unsubstituted or C₁-C₁₀ alkyl (e.g. tert-butyl)-substituted C₃-C₃₀ hetero aryl ring (e.g., quinoline ring or iso-quinoline ring), each of g1, g2, g3 and g4 can be independently 1 and g5 can be 1 or 2 in Chemical Formula 13A.

In one example embodiment, each of R⁸¹, R⁸², R⁸³, R⁸⁴, R⁸⁵, R⁸⁶, R⁸⁷ and R⁸⁸ is independently a C₁-C₂₀ alkyl group (*e.g.*, methyl, iso-propyl or tert-butyl), or R⁸⁴ can be fused to the ring including R⁸³ or the ring including R⁸⁵ to form a 5-membered ring including the nitrogen atom in Chemical Formula 13B. In addition, each of h1, h2, h3, h4, h5 and h6 can be independently 0 or 1 and each of h7 and h8 can be independently 0, 1, 2 or 3 in Chemical Formula 13B. For example, each of the eighth compound 554 and the eleventh compound 564 can be independently at least one of or selected from, but is not limited to, the following compounds of Chemical Formula 14:

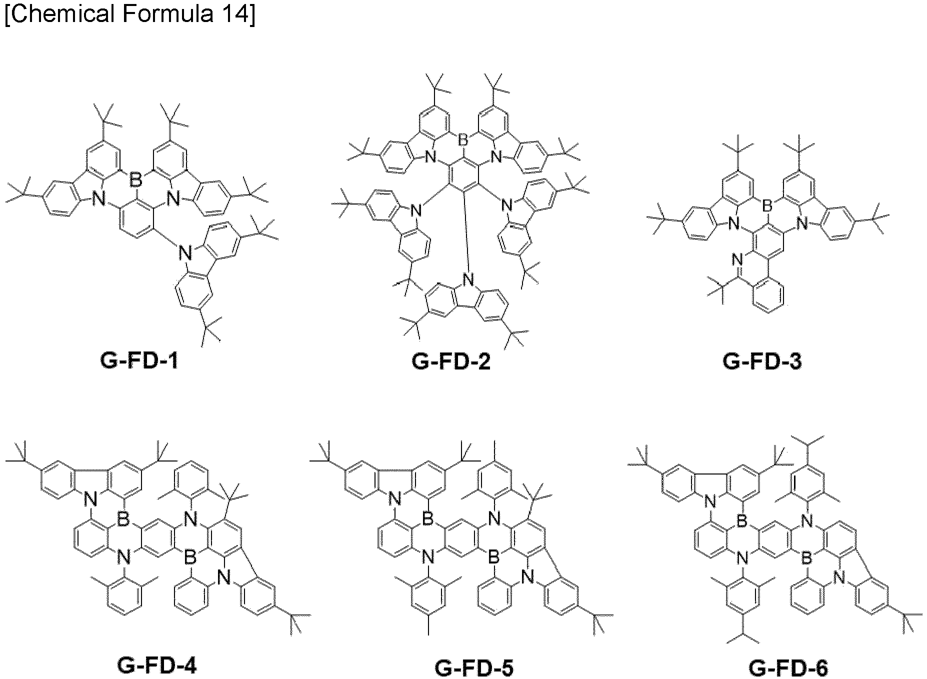

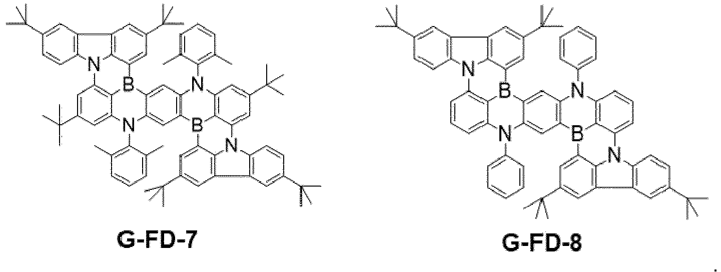

In one example embodiment, each of the ninth compound 556, which can be the first green host in the green EML1 550, and the twelfth compound 566, which can be the second host in the green EML2 560, can be independently a carbazole-based organic compound. For example, each of the ninth compound 556 and the twelfth compound 566 can independently have, but is not limited to, the following structure of Chemical Formula 15: 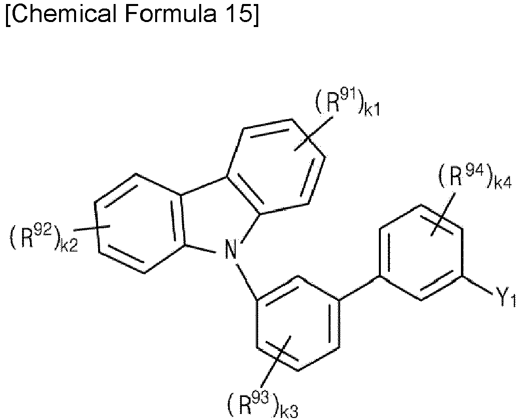 wherein, in the Chemical Formula 15,
each of R⁹¹ and R⁹² is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁹¹ is identical to or different from each other when k1 is 2, 3 or 4, and where each R⁹² is identical to or different from each other when k2 is 2, 3 or 4;
each of R⁹³ and R⁹⁴ is independently an unsubstituted or substituted C₁-C₂₀ alkyl group, an unsubstituted or substituted C₆-C₃₀ aryl group or an unsubstituted or substituted C₃-C₃₀ hetero aryl group, or optionally, R⁹³ and R⁹⁴ can be further linked to form an unsubstituted or substituted hetero ring, where each R⁹³ is identical to or different from each other when k3 is 2, 3 or 4, and where each R⁹⁴ is identical to or different from each other when k4 is 2, 3 or 4;
Y' has the following structure of Chemical Formula 15A or Chemical Formula 15B;
each of k1, k2, k3 and k4 is independently 0, 1, 2, 3 or 4, 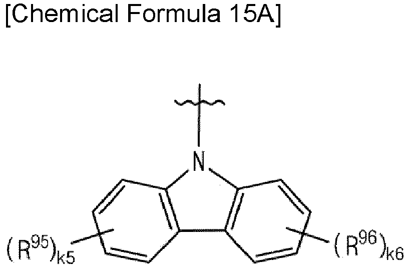 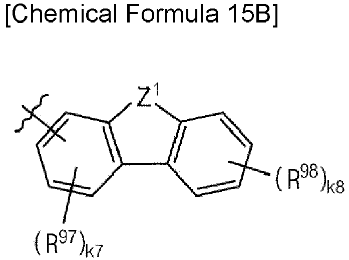 wherein, in Chemical Formulae 15A and 15B,
   each of R⁹⁵, R⁹⁶, R⁹⁷ and R⁹⁸ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁹⁵ is identical to or different from each other when k5 is 2, 3 or 4, where each R⁹⁶ is identical to or different from each other when k6 is 2, 3 or 4, where each R⁹⁷ is identical to or different from each other when k7 is 2 or 3, and where each R⁹⁸ is identical to or different from each other when k8 is 2, 3 or 4;
   each of k5, k6 and k8 is independently 0, 1, 2, 3 or 4;
   k7 is 0, 1, 2 or 3;
   Z¹ is NR⁹⁹, O or S, where R⁹⁹ is hydrogen, an unsubstituted or substituted C₁-C₂₀ alkyl group, an unsubstituted or substituted C₆-C₃₀ aryl group or an unsubstituted or substituted C₃-C₃₀ hetero aryl group.

The ninth compound 556 in the green EML1 550 can be identical to or different from the twelfth compound 566 in the green EML2 560. In addition, each of the ninth compound 556 in the green EML1 550 and the twelfth compound 566 in the green EML2 560 can be independently identical to or different from the second compound 354 in the blue EML1 350, respectively. As an example, each of the ninth compound 556 and the twelfth compound 566 can be at least one of or selected from, but is not limited to, the following compound of Chemical Formula 16:

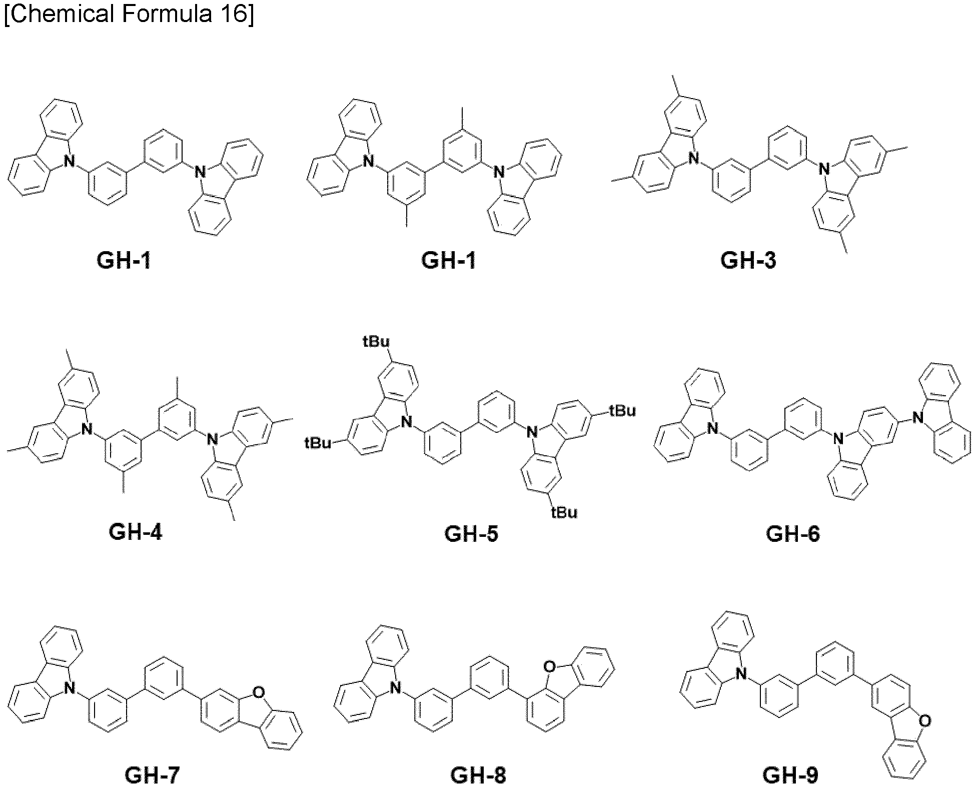

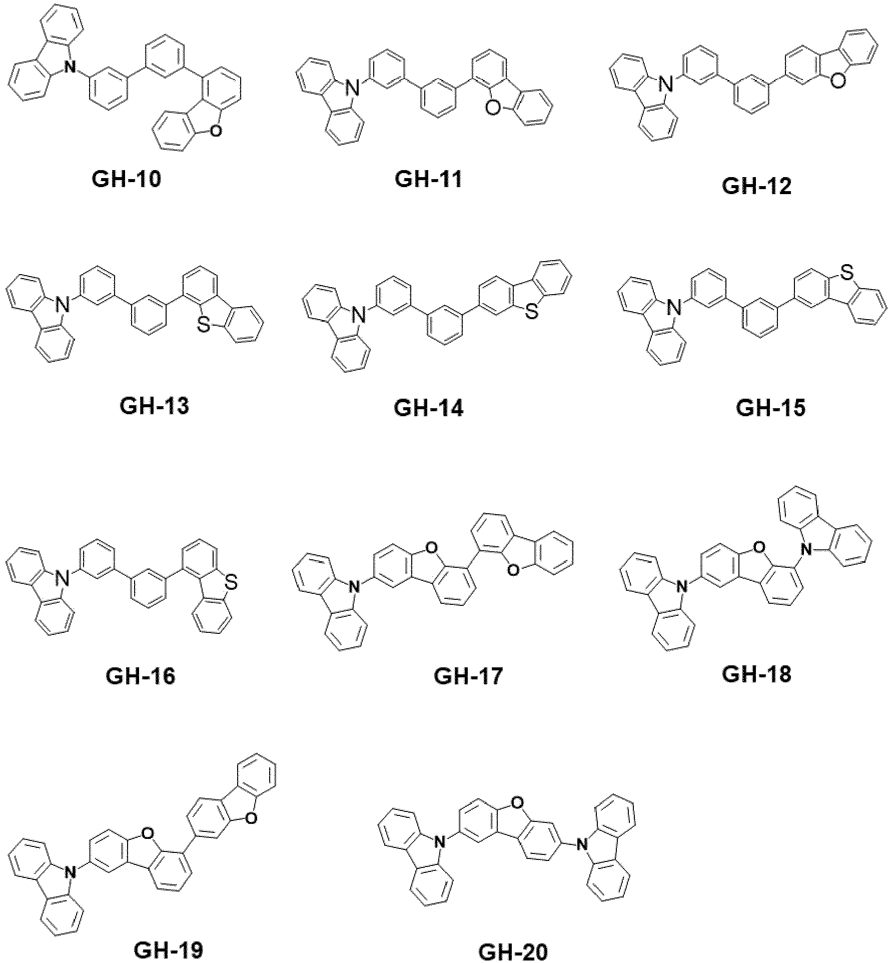

In one example embodiment, the seventh compound 552 of the first green delayed fluorescent compound in the green EML1 550 can have a lowest unoccupied molecular orbital (LUMO) energy level about -3.0 eV or less. A difference between a highest occupied molecular orbital (HOMO) energy level of the seventh compound 552 and a HOMO energy level of the ninth compound 556 of the first green host in the green EML1 550 can be about 0.4 eV or less. In addition, a difference between the LUMO energy level of the seventh compound 552 and a LUMO energy level of the eighth compound 554 of the first green fluorescent compound in the green EML1 550 can be about 0.3 eV or less.

In another example embodiment, the tenth compound 562 of the second green delayed fluorescent compound in the green EML2 560 can have a LUMO energy level about -3.0 eV or less. A difference between a HOMO energy level of the tenth compound 562 and a HOMO energy level of the twelfth compound 566 of the second green host in the green EML2 560 can be about 0.4 eV or less. In addition, a difference between the LUMO energy level of the tenth compound 562 and a LUMO energy level of the eleventh compound 564 of the second green fluorescent compound in the green EML2 560 can be about 0.3 eV or less.

Each of the green EML1 550 and the green EML2 560 of the fluorescence emitting layers includes independently each of the delayed fluorescent compounds 552 and 562, respectively, so that the green OLED D1-G can realize beneficial luminous efficiency. In addition, each of the green EML1 550 and the green EML2 560 includes independently each of the fluorescent compounds 554 and 564, respectively, so that the color purity of the green OLED D1-G can be greatly improved. A strong cavity effect is implemented in the green OLED D1-G so that the green OLED D1-G can have lower driving voltages and greatly improved green luminous efficiency.

The contents of the seventh compound 552 can be more than the contents of the eighth compound 554, but can be less than the contents of the ninth compound 556 in the green EML1 550 of the green OLED D1-G. For example, the contents of each of the seventh compound 552 and the ninth compound 556 can be about 4000 to about 6000 parts by weight based upon the contents of the eighth compound 554 in the green EML1 550.

The contents of the tenth compound 562 can be more than the contents of the eleventh compound 564, but can be less than the contents of the twelfth compound 566 in the green EML2 560 of the green OLED D1-G. For example, the contents of each of the tenth compound 562 and the twelfth compound 566 can be about 4000 to about 6000 parts by weight based upon the contents of the eleventh compound 564 in the green EML2 560.

With referring to FIG. 5, the red EML 740 includes a red EML1 750 of the red fluorescence emitting layer and a red EML2 760 of the phosphorescence emitting layer disposed between the red EML1 750 and the HBL 770. The red EML1 750 includes a thirteenth compound 752, a fourteenth compound 754, and optionally a fifteenth compound 756. The red EML2 760 includes a sixteenth compound 762, and optionally a seventeenth compound 764.

In one example embodiment, the thirteenth compound 752 of a red delayed fluorescent compound in the red EML1 750 can have the structure of Chemical Formulae 11 to 12, and can be at least one of the compounds in Chemical Formula 12. As an example, the thirteenth compound 752 can be an organic compound where two cyano groups substituted to the benzene ring in Chemical Formula 11 are linked to each other at a para-position. As an example, the thirteenth compound 752 can be at least one of, but is not limited to, the Compounds TD-1, TD-2, TD-4, TD-6 and TD-7 in Chemical Formula 12.

In one example embodiment, the fourteenth compound 754 of the red fluorescent compound can have a BODIPY (boron dipyromethene) core. For example, the fourteenth compound 754 can have, but is not limited to, the following structure of Chemical Formula 17: 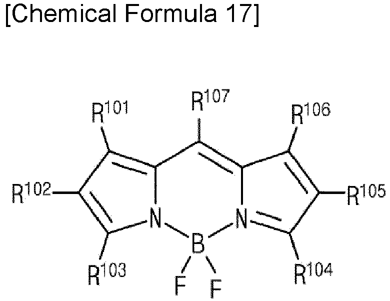 wherein, in the Chemical Formula 17,
each of R¹⁰¹, R¹⁰², R¹⁰³, R¹⁰⁴, R¹⁰⁵ and R¹⁰⁶ is independently hydrogen, an unsubstituted or substituted C₁-C₂₀ alkyl group, an unsubstituted or substituted C₆-C₃₀ aryl group or an unsubstituted or substituted C₃-C₃₀ hetero aryl group; and
R¹⁰⁷ is an unsubstituted or substituted C₆-C₃₀ aryl group or an unsubstituted or substituted C₃-C₃₀ hetero aryl group.

In one example embodiment, each of R¹⁰¹ R¹⁰³, R¹⁰⁴ and R¹⁰⁶ in Chemical Formula 17 can be independently a C₁-C₁₀ alkyl group or an unsubstituted or C₁-C₁₀ alkyl (e.g., methyl or tert-butyl)-substituted phenyl group. Each of R¹⁰² and R¹⁰⁵ in Chemical Formula 17 can be independently hydrogen or an unsubstituted or C₁-C₁₀ alkyl-substituted phenyl group. R¹⁰⁷ in Chemical Formula 17 can be an C₆-C₃₀ aryl group (e.g., phenyl) substituted with at least one of C₁-C₁₀ alkoxy group (e.g. methoxy) or at least one C₆-C₃₀ aryl group (e.g., one or two phenyls) unsubstituted or substituted with a C₁-C₁₀ alkyl group (e.g., tert-butyl), or an unsubstituted or substituted C₃-C₃₀ hetero aryl group (e.g., dibenzofuranyl, dibenzothiophenyl or carbazolyl). For example, the fourteenth compound 754 can be at least one of or selected from, but is not limited to, the following compounds of Chemical Formula 18:

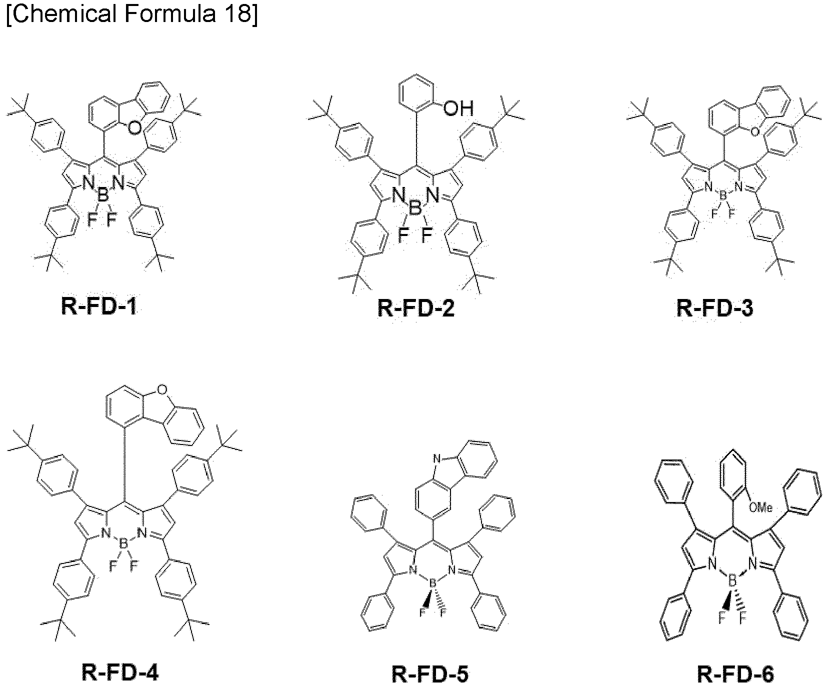

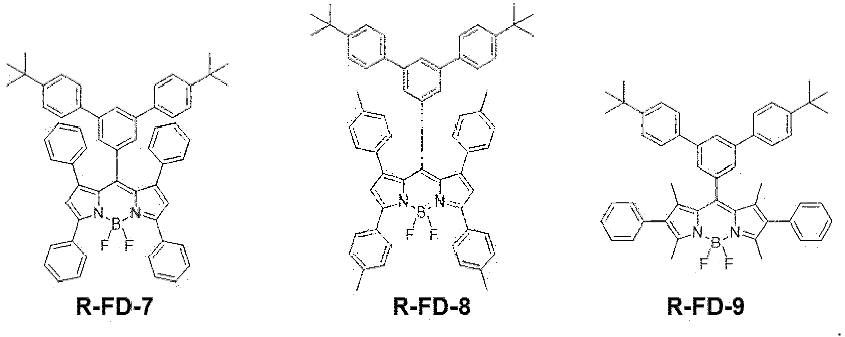

In one example embodiment, the fifteenth compound 756 of the first red host can have at least one carbazolyl moiety. For example, the fifteenth compound 756 can have, but is not limited to, the following structure of Chemical Formula 19: 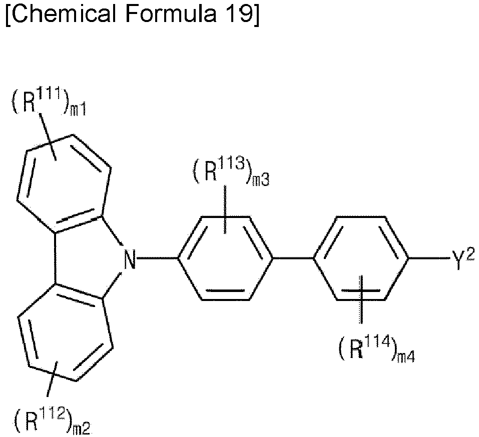 wherein, in the Chemical Formula 19,
each of R¹¹¹ and R¹¹² is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹¹ is identical to or different from each other when m1 is 2, 3 or 4, and where each R¹¹² is identical to or different from each other when m2 is 2, 3 or 4;
each of R¹¹³ and R¹¹⁴ is independently an unsubstituted or substituted C₁-C₂₀ alkyl group, an unsubstituted or substituted C₆-C₃₀ aryl group or an unsubstituted or substituted C₃-C₃₀ hetero aryl group, or optionally, R¹¹³ and R¹¹⁴ can be further linked to form an unsubstituted or substituted hetero ring, where each R¹¹³ is identical to or different from each other when m3 is 2, 3 or 4, and where each R¹¹⁴ is identical to or different from each other when m4 is 2, 3 or 4;
Y² has the following structure of Chemical Formula 19A or Chemical Formula 19B;
each of m1, m2, m3 and m4 is independently 0, 1, 2, 3 or 4, 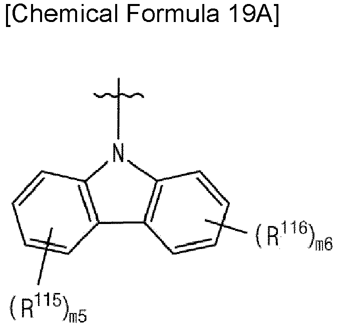 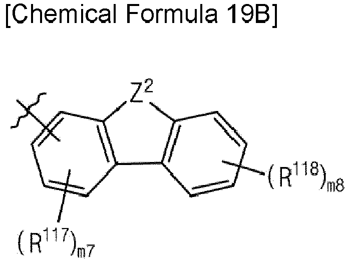 wherein, in Chemical Formulae 19A and 19B,
   each of R¹¹⁵, R¹¹⁶, R¹¹⁷ and R¹¹⁸ is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹⁵ is identical to or different from each other when m5 is 2, 3 or 4, where each R¹¹⁶ is identical to or different from each other when m6 is 2, 3 or 4, where each R¹¹⁷ is identical to or different from each other when m7 is 2 or 3, and where each R¹¹⁸ is identical to or different from each other when m8 is 2, 3 or 4;
   each of m5, m6 and m8 is independently 0, 1, 2, 3 or 4;
   m7 is 0, 1, 2 or 3;
   Z² is NR¹¹⁹, O or S, where R¹¹⁹ is hydrogen, an unsubstituted or substituted C₁-C₂₀ alkyl group, an unsubstituted or substituted C₆-C₃₀ aryl group or an unsubstituted or substituted C₃-C₃₀ hetero aryl group.

As an example, the fifteenth compound 756 can be at least one of or selected from, but is not limited to, the following compounds of Chemical Formula 20:

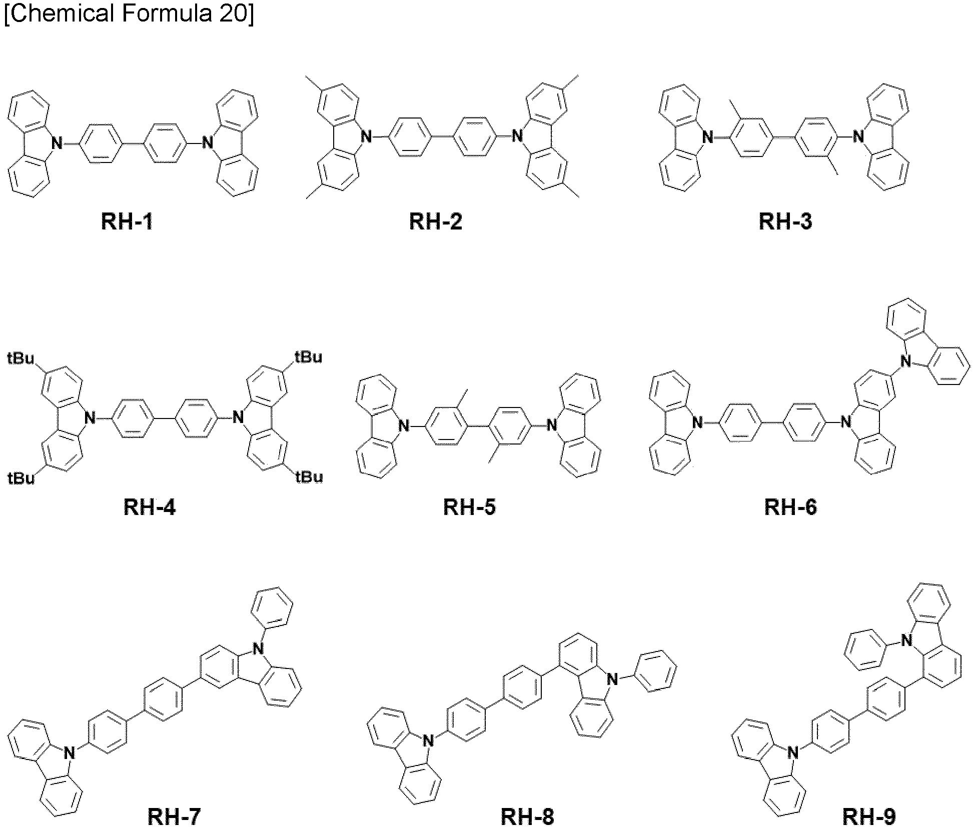

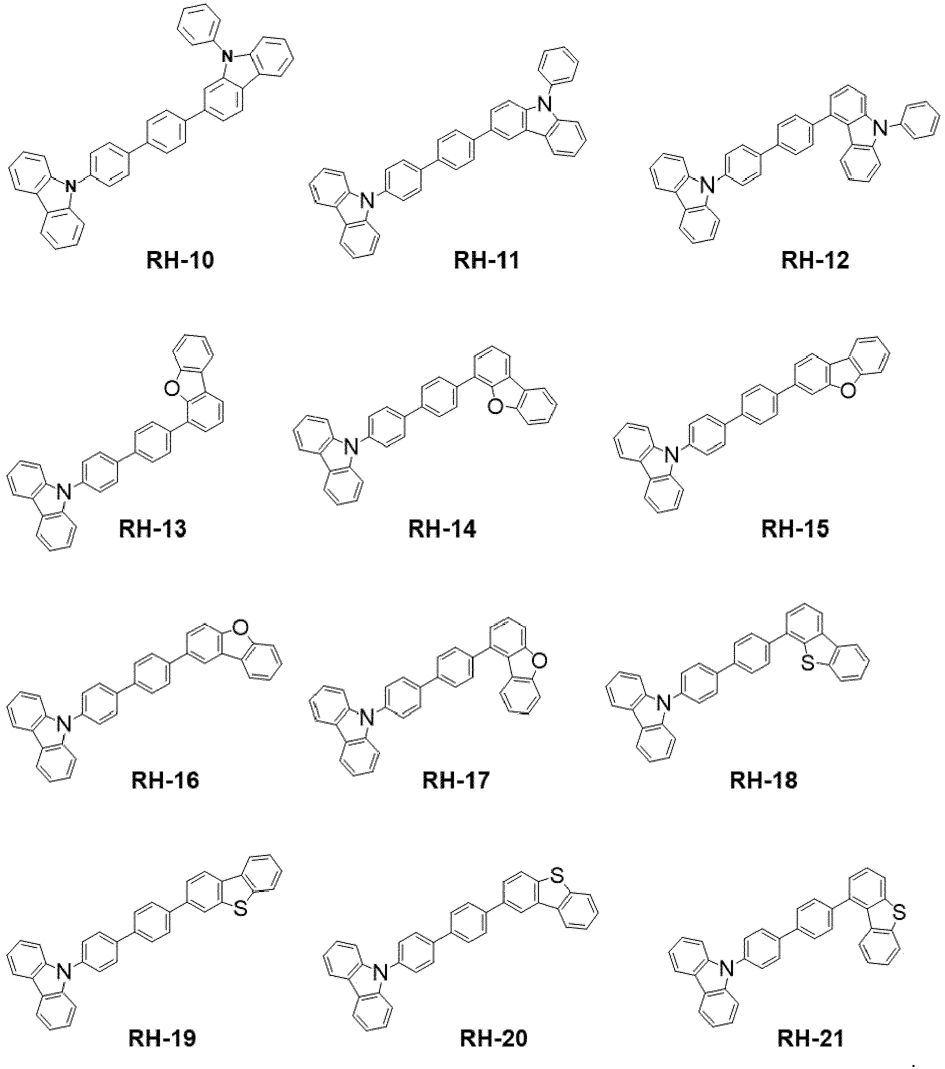

The contents of the thirteenth compound 752 can be more than the contents of the fourteenth compound 754, but can be less than the contents of the fifteenth compound 756 in the red EML1 750 of the red OLED D1-R. For example, the contents of each of the thirteenth compound 752 and the fifteenth compound 756 can be about 4000 to about 6000 parts by weight based upon the contents of the fourteenth compound 754 in the red EML1 750.

The sixteenth compound 762 of the red phosphorescent compound (phosphorescent emitter, phosphorescent dopant) in the red EML2 760 of the phosphorescence emitting layer can be at least one of or selected from, but is not limited to, the following organometallic compounds of Chemical Formula 21:

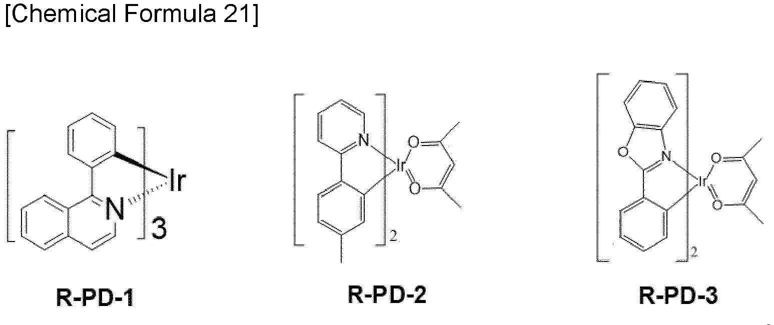

The seventeenth compound 764 of the second host in the red EML2 760 of the phosphorescence emitting layer can have, but is not limited to, the structure of Chemical Formula 19 and can be at least one of or selected from the compounds of Chemical Formula 20. The fifteenth compound 756 in the first EML1 750 can be identical to or different from the seventeenth compound 764 in the second EML2 760. In addition, each of the fifteenth compound 756 in the red EML1 750 and the seventeenth compound 764 in the red EML2 760 can be independently identical to or different from the second compound 354 in the blue EML1 350, respectively.

The contents of the seventeenth compound 764 can be more than the contents of the sixteenth compound 762 in the red EML2 760 of the red OLED D1-R. For example, the contents of the sixteenth compound 762 in the red EML2 760 can be, but is not limited to, about 0.1 wt% to about 10 wt%.

In the red OLED D1-R, the red EML2 760 of the phosphorescence emitting layer is disposed closer to the second electrode 230 of the transmissive electrode than the red EML1 750. In other words, the red EML2 760 of the phosphorescence emitting layer is disposed between the second electrode 230 of the transmissive electrode and the red EML1 750 of the fluorescence emitting layer. The red EML2 760, which has luminous efficiency higher than that of the red EML1 750 of the fluorescence emitting layer, is disposed adjacently to the transmissive electrode 230 so that the red OLED D1-R can have beneficial luminous property. For example, the quantum efficiency of the sixteenth compound 762 in the red EML2 760 can be higher than the quantum efficiency of the fourteenth compound 754 in the red EML1 750.

Alternatively, the first electrode 210 can be the transmissive electrode and the second electrode 230 can be the reflective electrode. In this case, the red EML2 of the phosphorescence emitting layer is disposed closer to the first electrode 210 of the transmissive electrode than the red EML1 of the fluorescence emitting layer. In other words, the red EML2 760 of the phosphorescence emitting layer is disposed between the first electrode 210 and the red EML1 750 of the fluorescence emitting layer.

Each of the HILs 310, 510 and 710 is disposed between the first electrode 210 and each of the HTLs 320, 520 and 720, respectively, and can improve an interface property between the inorganic first electrode 210 and the organic HTLs 320, 520 and 720. In one example embodiment, each of the HILs 310, 510 and 710 can independently include, but is not limited to, 4,4',4"-tris(3-methylphenylamino)triphenylamine (MTDATA), 4,4',4"-tris(N,N-diphenyl-amino)triphenylamine (NATA), 4,4',4"-tris(N-(naphthalene-1-yl)-N-phenyl-amino)triphenylamine (1T-NATA), 4,4',4"-tris(N-(naphthalene-2-yl)-N-phenyl-amino)triphenylamine (2T-NATA), copper phthalocyanine (CuPc), tris(4-carbazoyl-9-yl-phenyl)amine (TCTA), N,N'-diphenyl-N,N'-bis(1-naphthyl)-1,1'-biphenyl-4,4"-diamine (NPB; NPD), N,N'-bis{4-[bis(3-methylphenyl)amino]phenyl}-N,N'-diphenyl-4,4'-biphenyldiamine (DNTPD), 1,4,5,8,9,11-hexaazatriphenylenehexacarbonitrile (dipyrazino[2,3-f:2'3'-h]quinoxaline-2,3,6,7,10,11-hexacarbonitrile; HAT-CN), 2,3,5,6-tetrafluoro-7,7,8,8-tetracyano-quinodimethane (F4-TCNQ), 1,3,4,5,7,8-hexafluorotetracyanonaphthoquinodimethane (F6-TCN Q), 1,3,5-tris[4-(diphenylamino)phenyl]benzene (TDAPB), poly(3,4-ethylenedioxythiphene)polystyrene sulfonate (PEDOT/PSS), N-(biphenyl-4-yl)-9,9-dimethyl-N-(4-(9-phenyl-9H-carbazol-3-yl)phenyl)-9H-fluoren-2-amine, N,N'-diphenyl-N,N'-di[4-(N,N'-diphenyl-amino)phenyl]benzidine (NPNPB) and/or combinations thereof.

Alternatively, each of the HILs 310, 510 and 710 can independently include hole transporting material, as described below, doped with the hole injecting material (e.g., HAT-CN, F4-TCNA and/or F6-TCNNQ). The contents of the hole injecting material in each of the HILs 310, 510 and 710 can be independently, but is not limited to, about 2 wt% to about 15 wt%. The HILs 310, 510 and 710 can be omitted in compliance of the OLEDs D1-B, D1-G and D1-R property, respectively.

Each of the HTLs 320, 520 and 720 is disposed between each of the EMLs 340, 540 and 740 and each of the HILs 310, 510 and 710, respectively. In one example embodiment, each of the HTLs 320, 520 and 720 can include, but is not limited to, N,N'diphenyl-N,N'-bis(3-methylphenyl)-1,1'-biphenyl-4,4'-diamine (TPD), NPB(NPD), DNTPD, 4,4'-bis(N-carbazolyl)-1,1'-biphenyl (CBP), poly[N,N'-bis(4-butylphenyl)-N,N'-bis(phenyl)-benzidine] (Poly-TPD), poly[(9,9-dioctylfluorenyl-2,7-diyl)-co-(4,4'-(N-(4-sec-butylphenyl)diphenylamine))] (TFB), di-[4-(N,N-di-p-tolyl-amino)-phenyl]cyclohexane (TAPC), 3,5-di(9H-carbazol-9-yl)-N,N-diphenylaniline (DCDPA), N-(biphenyl-4-yl)-9,9-dimethyl-N-(4-(9-phenyl-9H-carbazol-3-yl)phenyl)-9H-fluoren-2-amine, N-(biphenyl-4-yl)-N-(4-(9-phenyl-9H-carbazol-3-yl)phenyl)biphenyl-4-amine), N-([1,1'-biphenyl]-4-yl)-9,9-dimethyl-N-(4-(9-phenyl-9H-carbazol-3-yl)phenyl)-9H-fluoren-2-amine, any one of the following compounds of following Chemical Formula 22 and/or combinations thereof.

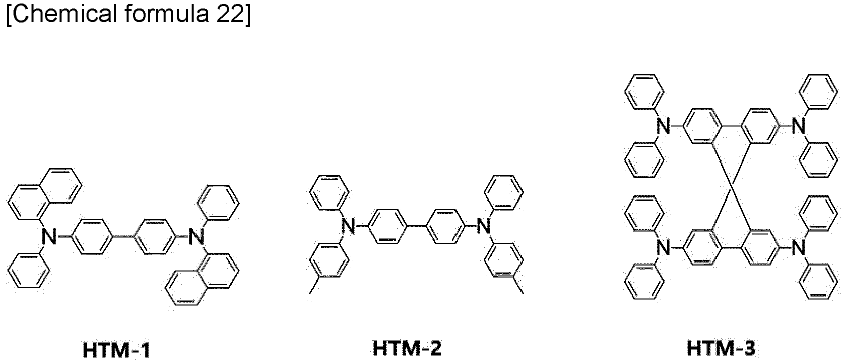

Each of the ETLs 380, 580 and 780 and each of the EILs 390, 590 and 790 can be laminated sequentially between each of the EMLs 340, 540 and 740 and the second electrode 230. An electron transporting material included in the ETLs 380, 580 and 780 has high electron moibity so as to provide electrons stably with the EMLs 340, 540 and 740 by fast electron transportation. In one example embodiment, each of the ETLs 380, 580 and 780 can independently include at least one of oxadiazole-based compounds, triazole-based compounds, phenanthroline-based compounds, benzoxazole-based compounds, benzothiazole-based compounds, benzimidazole-based compounds and triazine-based compounds.

More particularly, each of the ETLs 380, 580 and 780 can independently include, but is not limited to, tris-(8-hydroxyquinoline aluminum (Alqs), 2-biphenyl-4-yl-5-(4-t-butylphenyl)-1,3,4-oxadiazole (PBD), spiro-PBD, lithium quinolate (Liq), 1,3,5-tris(N-phenylbenzimidazol-2-yl)benzene (TPBi), bis(2-methyl-8-quinolinolato-N1,O8)-(1,1'-biphenyl-4-olato)aluminum (BAlq), 4,7-diphenyl-1,10-phenanthroline (Bphen), 2,9-bis(naphthalene-2-yl)4,7-diphenyl-1,10-phenanthroline (NBphen), 2,9-dimethyl-4,7-diphenyl-1,10-phenathroline (BCP), 3-(4-biphenyl)-4-phenyl-5-tert-butylphenyl-1,2,4-triazole (TAZ), 4-(Naphthalen-1-yl)-3,5-diphenyl-4H-1,2,4-triazole (NTAZ), 1,3,5-tri(p-pyrid-3-yl-phenyl)benzene (TpPyPB), 2,4,6-tris(3'-(pyridin-3-yl)biphenyl-3-yl)1,3,5-triazine (TmPPPyTz), poly[9,9-bis(3'-((N,N-dimethyl)-N-ethylammonium)-propyl)-2,7-fluorene]-alt-2,7-(9,9-dioctylfluorene)] (PFNBr), tris(phenylquinoxaline (TPQ), TSPO1, 2-[4-(9,10-di-naphthalen-2-yl-anthracen-2-yl)phenyl]-1-phenyl-1H-benzimidazole (ZADN) and/or combinations thereof.

Each of the EILs 390, 590 and 790 is disposed between the second electrode 230 and each of the ETLs 380, 580 and 780, respectively, and can improve physical properties of the second electrode 230 and therefore, can enhance the lifespan of the OLEDs D1-B, D1-G and D1-R. In one example embodiment, each of the EILs 390, 590 and 790 can independently include, but is not limited to, an alkali metal halide or an alkaline earth metal halide such as LiF, CsF, NaF, BaF₂ and the like, and/or an organometallic compound such as Liq, lithium benzoate, sodium stearate, and the like. Alternatively, the EIL can be omitted.

When holes are transferred to the second electrode 230 via the EMLs 340, 540 and 740 and/or electrons are transferred to the first electrode 210 via the EMLs 340, 540 and 740, the OLEDs D1-B, D1-G and D1-R can have short lifespan and reduced luminous efficiency. In order to prevent those phenomena, each the OLEDs D1-B, D1-G and D1-R in accordance with this aspect of the present disclosure can have at least one exciton blocking layer adjacent to each of the EMLs 340, 540 and 740, respectively.

As an example, each of the OLEDs D1-B, D1-G and D1-R can include each of the EBLs 330, 530 and 730 between each of the HTLs 320, 520 and 720 and each of the EMLs 340, 540 and 740, respectively, so as to control and prevent electron transfers. In one example embodiment, each of the EBLs 330, 530 and 730 can independently include, but is not limited to, TCTA, tris[4-(diethylamino)phenyl]amine, N-(biphenyl-4-yl)-9,9-dimethyl-N-(4-(9-phenyl-9H-carbazol-3-yl)phenyl)-9H-fluorene-2-amine, TAPC, MTDATA, 1,3-bis(carbazol-9-yl)benzene (mCP), 3,3-di(9H-carbazol-9-yl)biphenyl (mCBP), CuPc, TDAPB, DCDPA, 3,6-bis(N-carbazolyl)-N-phenyl-carbazole and/or combinations thereof.

In addition, each of the OLEDs D1-B, D1-G and D1-R can further include each of the HBLs 370, 570 and 770 as a second exciton blocking layer between each of the EMLs 340, 540 and 740 and each of the ETLs 380, 580 and 780 so that holes cannot be transferred from each of the EMLs 340, 540 and 740 to each of the ETLs 380, 580 and 780, respectively. In one example embodiment, each of the HBLs 370, 570 and 770 can independently include, but is not limited to, at least one of oxadiazole-based compounds, triazole-based compounds, phenanthroline-based compounds, benzoxazole-based compounds, benzothiazole-based compounds, benzimidazole-based compounds, and triazine-based compounds.

For example, each of the HBLs 370, 570 and 770 can independently include material having a relatively low HOMO energy level compared to the luminescent materials in each of the EMLs 340, 540 and 740. Each of the HBLs 370, 570 and 770 can independently include, but is not limited to, BCP, BAlq, Alqs, PBD, spiro-PBD, Liq, bis-4,5-(3,5-di-3-pyridylphenyl)-2-methylpyrimidine (B3PYMPM), DPEPO, 9-(6-(9H-carbazol-9-yl)pyridine-3-yl)-9H-3,9'-bicarbazole, TSPO1 and/or combinations thereof.

In the example embodiment above, each of the blue OLED D1-B, the green OLED D1-G and the red OLED D1-4 includes two emitting material layers disposed in a single emitting part. In another example embodiment, the OLED D illustrated in FIG. 2 can have multiple emitting parts.

FIG. 6 illustrates a schematic cross-sectional view of a blue organic light emitting diode D2-B disposed in the first pixel region SP1, FIG. 7 illustrates a schematic cross-sectional view of a green organic light emitting diode D2-G disposed in the second pixel region SP2, and FIG. 8 illustrates a schematic cross-sectional view of a red organic light emitting diode D2-R disposed in the third pixel region SP3.

As illustrated in FIG. 6, the blue OLED D2-B includes a first electrode 210 of a reflective electrode, a second electrode 230 of a transmissive (or semi-transmissive) electrode facing the first electrode 210 and a first emissive layer (blue emissive layer) 220-B2 disposed between the first and second electrodes 210 and 230. The first emissive layer 220-B2 includes a first blue emitting part 300 disposed adjacently to the first electrode 210 and including a first blue emitting material layer (blue EML1) 350, and a second blue emitting part 400 disposed adjacently to the second electrode 230 and including a second blue emitting material layer (blue EML2) 460. In addition, the first emissive layer 220-B2 can include a charge generation layer (CGL) 390A disposed between the first blue emitting part 300 and the second blue emitting part 400.

As illustrated in FIG. 7, the green OLED D2-G includes a first electrode 210 of a reflective electrode, a second electrode 230 of a transmissive (or semi-transmissive) electrode facing the first electrode 210 and a second emissive layer (green emissive layer) 220-G2 disposed between the first and second electrodes 210 and 230. The second emissive layer 220-G2 includes a first green emitting part 500 disposed adjacently to the first electrode 210 and including a first green emitting material layer (green EML1) 550, and a second green emitting part 600 disposed adjacently to the second electrode 230 and including a second green emitting material layer (green EML2) 660. In addition, the second emissive layer 220-G2 can include a charge generation layer (CGL) 590A disposed between the first green emitting part 500 and the second green emitting part 600.

As illustrated in FIG. 8, the red OLED D2-R includes a first electrode 210 of a reflective electrode, a second electrode 230 of a transmissive (or semi-transmissive) electrode facing the first electrode 210 and a third emissive layer (red emissive layer) 220-R2 disposed between the first and second electrodes 210 and 230. The third emissive layer 220-R2 includes a first red emitting part 700 disposed adjacently to the first electrode 210 and including a first red emitting material layer (red EML1) 750, and a second red mitting part 800 disposed adjacently to the second electrode 230 and including a second red emitting material layer (red EML2) 860. In addition, the third emissive layer 220-R2 can include a charge generation layer (CGL) 790A disposed between the first red emitting part 700 and the second red emitting part 800. In addition, each of the blue OLED D2-B, the green OLED D2-G and the red OLED D2-R can further include a capping layer 240 in order to improve light extraction. The capping layer 240 disposed in the blue OLED D2-B, the green OLED D2-G and the red OLED D2-R can be integrally formed by being connected to each other. Each of the blue OLED D2-B, the green OLED D2-G and the red OLED D2-R can be disposed in the first pixel region SP1, the second pixel region SP2 and the third pixel region SP3, respectively, in the organic light emitting display device 100.

The first electrode 210 can be an anode and the second electrode 230 can be a cathode in each of the blue OLED D2-B, the green OLED D2-G and the red OLED D2-R, respectively. The first electrode 210 can be the reflective electrode and the second electrode 230 can be the transmissive (or semi-transmissive) electrode. As an example, the first electrode 210 can include ITO or ITO/Ag/ITO and the second electrode 230 can include MgAg, but is not limited thereto. When the second electrode 230 includes MgAg, the contents of the Mg can be about 10 wt%. The first electrode 210 has a first light transmittance and the second electrode 230 has a second light transmittance larger than the first light transmittance.

The first blue emitting part 300 can further include at least one of a first hole transport layer (HTL1) 320 disposed between the first electrode 210 and the blue EML1 350 and a first electron transport layer (ETL1) 380 disposed between the blue EML1 350 and the CGL 390A. In addition, the first blue emitting part 300 can further include a hole injection layer (HIL) 310 disposed between the first electrode 210 and the HTL1 320. The first blue emitting part 300 can further include at least one of a first electron blocking layer (EBL1) 330 disposed between the HTL1 320 and the blue EML1 350 and a first hole blocking layer (HBL1) 370 disposed between the blue EML1 350 and the ETL1 380.

The second blue emitting part 400 can further include at least one of a second hole transport layer (HTL2) 420 disposed between the CGL 390A and the blue EML2 460 and a second electron transport layer (ETL2) 480 disposed between the blue EML2 460 and the second electrode 230. In addition, the second blue emitting part 400 can further include an electron injection layer (EIL) 490 disposed between the second electrode 230 and the ETL2 480. The second blue emitting part 400 can further include at least one of a second electron blocking layer (EBL2) 430 disposed between the HTL2 420 and the blue EML2 460 and a second hole blocking layer (HBL2) 470 disposed between the blue EML2 460 and the ETL2 480.

The first green emitting part 500 can further include at least one of a first hole transport layer (HTL1) 520 disposed between the first electrode 210 and the green EML1 550 and a first electron transport layer (ETL1) 580 disposed between the green EML1 550 and the CGL 590A. In addition, the first green emitting part 500 can further include a hole injection layer (HIL) 510 disposed between the first electrode 210 and the HTL1 520. The first green emitting part 500 can further include at least one of a first electron blocking layer (EBL1) 530 disposed between the HTL1 520 and the green EML1 550 and a first hole blocking layer (HBL1) 570 disposed between the green EML1 550 and the ETL1 580.

The second green emitting part 600 can further include at least one of a second hole transport layer (HTL2) 620 disposed between the CGL 590A and the green EML2 660 and a second electron transport layer (ETL2) 680 disposed between the green EML2 660 and the second electrode 230. In addition, the second green emitting part 600 can further include an electron injection layer (EIL) 690 disposed between the second electrode 230 and the ETL2 680. The second green emitting part 600 can further include at least one of a second electron blocking layer (EBL2) 630 disposed between the HTL2 620 and the green EML2 660 and a second hole blocking layer (HBL2) 670 disposed between the green EML2 660 and the ETL2 680.

The first red emitting part 700 can further include at least one of a first hole transport layer (HTL1) 720 disposed between the first electrode 210 and the red EML1 750 and a first electron transport layer (ETL1) 780 disposed between the red EML1 750 and the CGL 790A. In addition, the first red emitting part 700 can further include a hole injection layer (HIL) 710 disposed between the first electrode 210 and the HTL1 720. The first red emitting part 700 can further include at least one of a first electron blocking layer (EBL1) 730 disposed between the HTL1 720 and the red EML1 750 and a first hole blocking layer (HBL1) 770 disposed between the red EML1 750 and the ETL1 780.

The second red emitting part 800 can further include at least one of a second hole transport layer (HTL2) 820 disposed between the CGL 790A and the red EML2 860 and a second electron transport layer (ETL2) 880 disposed between the red EML2 860 and the second electrode 230. In addition, the second red emitting part 800 can further include an electron injection layer (EIL) 890 disposed between the second electrode 230 and the ETL2 880. The second red emitting part 800 can further include at least one of a second electron blocking layer (EBL2) 830 disposed between the HTL2 820 and the red EML2 860 and a second hole blocking layer (HBL2) 870 disposed between the red EML2 860 and the ETL2 880.

The CGL 390A disposed in the blue OLED D2-B can be a PN-junction charge generation layer with combining an N-type charge generation layer (N-CGL) 392 and a P-type charge generation layer (P-CGL) 394. The N-CGL 392 is disposed between the ETL1 380 and the HTL2 420 and the P-CGL 394 is disposed between the N-CGL 392 and the HTL2 420. The N-CGL 392 transfers electrons to the blue EML1 350 in the first blue emitting part 300 and the P-CGL 394 transfers holes to the blue EML2 460 in the second blue emitting part 400.

The CGL 590A disposed in the green OLED D2-G can be a PN-junction charge generation layer with combining an N-type charge generation layer (N-CGL) 592 and a P-type charge generation layer (P-CGL) 594. The N-CGL 592 is disposed between the ETL1 580 and the HTL2 620 and the P-CGL 594 is disposed between the N-CGL 592 and the HTL2 620. The N-CGL 592 transfers electrons to the green EML1 550 in the first green emitting part 500 and the P-CGL 594 transfers holes to the green EML2 660 in the second blue emitting part 600.

The CGL 790A disposed in the red OLED D2-R can be a PN-junction charge generation layer with combining an N-type charge generation layer (N-CGL) 792 and a P-type charge generation layer (P-CGL) 794. The N-CGL 792 is disposed between the ETL1 780 and the HTL2 820 and the P-CGL 794 is disposed between the N-CGL 792 and the HTL2 820. The N-CGL 792 transfers electrons to the red EML1 750 in the first red emitting part 700 and the P-CGL 794 transfers holes to the red EML2 860 in the second blue emitting part 800.

Each of the N-CGLs 392, 592 and 792 can independently include the electron transporting material doped with alkali metal (*e*.*g*., Li, Na, Ka, Rb, Cs) and/or alkaline earth metal (*e*.*g*., Mg, Ca, Sr, Ba, Ra). The contents of the alkali metal and/or the alkaline earth metal in each of the N-CGLs 392, 592 and 792 can be, but is not limited to, about 1 wt% to about 10 wt%.

Each of the P-CGLs 394, 594 and 794 can include the hole transporting material doped with the hole injecting material (*e*.*g*., HAT-CN, F4-TCNQ and/or F6-TCNNQ). The contents of the hole injecting material in each of the P-CGLs 394, 594 and 794 can be, but is not limited to, about 2 wt% to about 15 wt%.

Each of the HILs 310, 510 and 710, the HTL1s 320, 520 and 720, the EBL1s 330, 530 and 730, the HBL1s 370, 570 and 770, the ETL1s 380, 580 and 780, the HTL2s 420, 620 and 820, the EBL2s 430, 630 and 730, the HBL2s 470, 670 and 770, the ETL2s 480, 680 and 880, the EILs 390, 590 and 790 and the CGLs 390A, 590A and 790A can be a common layer in each of the blue OLED D2-B, the green OLED D2-G and the red OLED D2-R, respectively. The HILs 310, 510 and 710, the HTL1s 320, 520 and 720, the EBL1s 330, 530 and 730, the HBL1s 370, 570 and 770, the ETL1s 380, 580 and 780, the HTL2s 420, 620 and 820, the EBL2s 430, 630 and 730, the HBL2s 470, 670 and 770, the ETL2s 480, 680 and 880, the EILs 390, 590 and 790 and the CGLs 390A, 590A and 790A in the blue OLED D2-B, the green OLED D2-G and the red OLED D2-R can be integrally formed by being connected to each other. The materials and the contents in the HILs 310, 510 and 710, the HTL1s 320, 520 and 720, the EBL1s 330, 530 and 730, the HBL1s 370, 570 and 770, the ETL1s 380, 580 and 780, the HTL2s 420, 620 and 820, the EBL2s 430, 630 and 730, the HBL2s 470, 670 and 770, the ETL2s 480, 680 and 880 and EILs 390, 590 and 790 and the CGLs 390A, 590A and 790A can be a common layer in each of the blue OLED D2-B, the green OLED D2-G and the red OLED D2-R, respectively. The HILs 310, 510 and 710, the HTL1s 320, 520 and 720, the EBL1s 330, 530 and 730, the HBL1s 370, 570 and 770, the ETL1s 380, 580 and 780 and the EILs 490, 690 and 790 can be identical to the materials and contents described with referring to FIGS. 3 to 5.

The blue EML1 350 of the fluorescence emitting layer can include a first compound 352, and optionally, a second compound 354. The first compound 342 can be a first blue fluorescent compound (fluorescent emitter or fluorescent dopant) and can include, but is not limited to, the organic compound having the structure of Chemical Formulae 1 to 2. The second compound 354 can be a first blue host and can include, but is not limited to, the organic compound having the structure of Chemical Formulae 3 to 4.

The blue EML2 460 of PSF emitting layer can include a third compound 462, a fourth compound 464, and optionally, a fifth compound 466 and/or a sixth compound 468. The third compound 462 can be a second blue fluorescent compound (fluorescent emitter or fluorescent dopant) and can include, but is not limited to, the organic compound having the structure of Chemical Formulae 5 to 6. The fourth compound 464 can be a blue phosphorescent compound (auxiliary dopant) and can include, but is not limited to, the organometallic compound having the structure of Chemical Formulae 7 to 8. The fifth compound 466 can be a second blue host and can include, but is not limited to, the organic compound having the structure of Chemical Formulae 3 to 4. The sixth compound 468 can be a third blue host and can include, but is not limited to, the organic compound having the structure of Chemical Formulae 9 to 10.

The second compound 354 in the blue EML1 350 can be identical to or different from the fifth compound 466 in the blue EML2 460. In the blue EML2 460, a difference between the maximum absorption wavelength of the third compound 462 and the maximum photoluminescence wavelength of the fourth compound 464 can be about 15 nm or less. Accordingly, luminous properties of the blue OLED D2-B can be further improved.

In the blue OLED D2-B, the blue EML2 460 of the PSF emitting layer is disposed closer to the second electrode 230 of the transmissive electrode than the blue EML1 350. In other words, the blue EML2 460 of the PSF emitting layer is disposed between the second electrode 230 of the transmissive electrode and the blue EML1 350 of the fluorescence emitting layer.

In another example embodiment, a difference between a first luminescence peak intensity in the blue EML1 350 and a second luminescence peak intensity in the blue EML2 460 of the PSF emitting layer can be about 0.1 or less. In this case, a strong cavity effect can be realized in the blue OLED D2-B so that the blue OLED D2-B can have lower driving voltages and greatly improved blue luminous efficiency. In another example embodiment, a difference between the maximum luminescence wavelength of the first compound 352 in the blue EML1 350 and the maximum luminescence wavelength of the third compound 462 in the blue EML2 460 of the PSF emitting layer can be about 15 nm or less. In this case, the luminous efficiency of the blue OLED D2-B can be further improved.

The contents of the first compound 352 and the second compound 354 in the blue EML1 350 and the contents of the third compound 462, the fourth compound 464, the fifth compound 466 and the sixth compound 468 in the blue EML2 460 can be identical to the contents of corresponding materials described with referring to FIG. 3.

Alternatively, the first electrode 210 can be the transmissive (semi-transmissive) electrode and the second electrode 230 can be the reflective electrode. In this case, the blue EML2 of the PSF emitting layer is disposed closer to the first electrode 210 of the transmissive electrode than the blue EML1 of the fluorescence emitting layer. In other words, the blue EML2 460 of the PSF emitting layer is disposed between the first electrode 210 and the blue EML1 350 of the fluorescence emitting layer.

With referring to FIG. 7, the green EML1 550 of the fluorescence emitting layer can include a seventh compound 552, an eighth compound 554, and optionally a ninth compound 556. The green EMI2 560 of the fluorescence emitting layer can include a tenth compound 662, an eleventh compound 664, and optionally a twelfth compound 666.

Each of the seventh compound 552 in the green EML1 550 and the tenth compound 662 in the green EML2 660 is a first green delayed fluorescent compound (auxiliary dopant) and a second green delayed fluorescent compound (auxiliary dopant), respectively. The seventh compound 552 can be identical to or different from the tenth compound 662. Each of the seventh compound 552 and the tenth compound 662 can independently include, but is not limited to, the organic compound having the structure of Chemical Formulae 11 to 12. As an example, each of the seventh compound 552 and the tenth compound 662 can be independently an organic compound where two cyano groups substituted to the benzene ring in Chemical Formula 11 are each linked at an ortho- or meta- position.

Each of the eighth compound 554 in the green EML1 550 and the eleventh compound 564 in the green EML2 660 is a first green fluorescent compound (fluorescent emitter, fluorescent dopant) and a second green fluorescent compound (fluorescent emitter, fluorescent dopant), respectively. The eighth compound 554 can be identical to or different from the eleventh compound 664. Each of the eighth compound 554 and the eleventh compound 664 can independently include, but is not limited to, the organic compound having the structure of Chemical Formulae 13A to 14.

Each of the ninth compound 556 in the green EML1 540 and the twelfth compound 666 in the green EML2 660 is a first green host and a second green host, respectively. The ninth compound 556 can be identical to or different from the twelfth compound 666. Each of the ninth compound 556 and the twelfth compound 666 can include, but is not limited to, the organic compound having the structure of Chemical Formulae 15 to 16. In addition, each of the ninth compound 556 in the green EML1 550 and the twelfth compound 666 in the green EML2 660 can be independently identical to or different from the second compound 354 in the blue EML1 350, respectively.

The contents of the seventh compound 552, the eighth compound 554 and the ninth compound 556 in the green EML1 550 and the contents of the tenth compound 662, the eleventh compound 664 and the twelfth compound 666 in the green EML2 660 can be identical to the contents of corresponding materials described with referring to FIG. 4. Each of the green EML1 550 and the green EML2 660 includes independently each of the delayed fluorescent compounds 552 and 662, respectively, with beneficial luminous efficiency, so that the luminous efficiency and luminous lifetime of the green OLED D2-G can be improved. In addition, each of the green EML1 550 and the green EML2 660 includes independently each of the fluorescent compounds 554 and 664, respectively, with beneficial color purity, so that the color purity of the green OLED D1-G can be greatly improved.

With referring to FIG. 8, the red EML1 750 of the fluorescence emitting layer can include a thirteenth compound 752, a fourteenth compound 754, and optionally a fifteenth compound 756. The thirteenth compound 752 can be a red delayed fluorescent compound and can have, but is not limited to, the organic compound having the structure of Chemical Formulae 11 to 12. As an example, the thirteenth compound 752 can be an organic compound where two cyano groups substituted to the benzene ring in Chemical Formula 11 are each linked at a para-position. The fourteenth compound 754 can be a red fluorescent compound and can include, but is not limited to, the organic compound having the structure of Chemical Formulae 17 to 18. The fifteenth compound 756 can be a first red host and can include, but is not limited to, the organic compound having the structure of Chemical Formulae 19 to 20.

The red EML2 860 can include a sixteenth compound 862, and optionally a seventeenth compound 864. The sixteenth compound 862 of the phosphorescent compound (phosphorescent emitter or phosphorescent dopant) can be at least one of, but is not limited to, the organometallic compounds of Chemical Formula 21. The seventeenth compound 864 of the second red host can include, but is not limited to, the organic compound having the structure of Chemical Formulae 19 to 20. The fifteenth compound 756 in the red EML1 750 can be identical to or different from the seventeenth compound 864 in the red EML2 860. In addition, each of the fifteenth compound 756 in the red EML1 750 and the seventeenth compound 864 in the red EML2 860 can be independently identical to or different from the second compound 354 in the blue EML1 350, respectively.

The contents of the thirteenth compound 752, the fourteenth compound 754 and the fifteenth compound 756 in the red EML1 750 and the contents of the sixteen compound 862 and the seventeenth compound 864 in the red EML2 860 can be identical to the contents of corresponding materials described with referring to FIG. 5.

In the red OLED D2-R, the red EML2 860 of the phosphorescence emitting layer is disposed closer to the second electrode 230 of the transmissive electrode than the red EML1 750. In other words, the red EML2 860 of the phosphorescence emitting layer is disposed between the second electrode 230 of the transmissive electrode and the red EML1 750 of the fluorescence emitting layer. The red EML2 860, which has luminous efficiency higher than that of the red EML1 750 of the fluorescence emitting layer, is disposed adjacently to the transmissive electrode 230 so that the red OLED D2-R can have beneficial luminous property. For example, the quantum efficiency of the sixteenth compound 862 in the red EML2 860 can be higher than the quantum efficiency of the fourteenth compound 754 in the red EML1 750.

Alternatively, the first electrode 210 can be the transmissive electrode and the second electrode 230 can be the reflective electrode. In this case, the red EML2 of the phosphorescence emitting layer is disposed closer to the first electrode 210 of the transmissive electrode than the red EML1 of the fluorescence emitting layer. In other words, the red EML2 860 of the phosphorescence emitting layer is disposed between the first electrode 210 and the red EML1 750 of the fluorescence emitting layer.

The OLED where each of a blue light color, a green light color and a red light color is emitted in each pixel region is described in the above example embodiment. In another example embodiment, an organic light emitting display device can implement full-color including white color. FIG. 9 illustrates a schematic cross-sectional view of an organic light emitting display device in accordance with another example embodiment of the present disclosure.

As illustrated in FIG. 9, the organic light emitting display device 1000 includes a first substrate 1010 that defines each of a first pixel region SP1, a second pixel region SP2 and a third pixel region SP3, a second substrate 1012 facing the first substrate 1010, a thin film transistor Tr on the first substrate 1010, an OLED D disposed between the first and second substrates 1010 and 1012 and emitting white (W) light and a color filter layer 1090 disposed between the OLED D and the second substrate 1012. Each of the first pixel region SP1, the second pixel region SP2 and the third pixel region SP3 can be a blue pixel region, a green pixel region and a red pixel region, respectively. Optionally, the first substrate 1010 can further include a fourth pixel region of a white pixel region.

Each of the first and second substrates 1010 and 1012 can include, but is not limited to, glass, flexible material and/or polymer plastics. For example, each of the first and second substrates 1010 and 1012 can be made of PI, PES, PEN, PET, PC and/or combinations thereof. The second substrate 1012 can be omitted. The first substrate 1010, on which a thin film transistor Tr and the OLED D are arranged, forms an array substrate.

The thin film transistor Tr is disposed on the first substrate 1010. Alternatively, a buffer layer can be disposed on the first substrate 1010 and the thin film transistor Tr can be disposed on the buffer layer. As illustrated in FIG. 2, the thin film transistor includes a semiconductor layer, a gate electrode, a source electrode and a drain electrode, and acts as a driving element.

A passivation layer 1070 is disposed on thin film transistor Tr. The top surface of the passivation layer 1070 is flat, and the passivation layer 1070 has a drain contact hole 1072 that exposes or does not cover the drain electrode of the thin film transistor Tr.

The OLED D is located on the passivation layer 1070 and corresponding to the color filter layer 1090. The OLED D includes a first electrode 1110 that is connected to the drain electrode of the thin film transistor Tr, and an emissive layer 1120 and a second electrode 1130 disposed sequentially on the first electrode 1110. The OLED D emits white color light in each of the first to third pixel regions SP1, SPS and SP3.

The first electrode 1110 is formed for each of the pixel regions SP1, SP2 and SP3, and the second electrode 1130 can be formed integrally over a whole display area. One of the first and second electrodes 1110 and 1130 is an anode and the other of the first and second electrodes 1110 and 1130 is a cathode. In addition, the first electrode 1110 can be a reflective electrode and the second electrode 1130 can be a transmissive (or semi-transmissive) electrode. Alternatively, the first electrode 1110 can be the transmissive (or semi-transmissive) electrode and the second electrode 1130 can be the reflective electrode.

For example, the first electrode 1110 can be the anode and include a transparent conductive oxide layer including a conductive material having relatively high work function value, for example, TCO. The second electrode 1130 can be the cathode and include a metal material layer including a conductive material having relatively low work function, for example, low-resistant metal. For example, the transparent conductive oxide layer of the first electrode 1110 can include, but is not limited to, ITO, IZO, ITZO, SnO, ZnO, ICO, AZO, and/or the like, and the second electrode 1130 can include Al, Mg, Ag, alloy thereof (e.g., MgAg) and/or combinations thereof.

In one example embodiment, the light emitted from the emissive layer 1120 is incident to the color filter layer 1090 through the second electrode 1130 in the organic light emitting display device 1000, the second electrode 1130 can be thin so as to pass through the light.

The emissive layer 1120 is disposed on the first electrode 1110. The emissive layer 1120 includes at least two emitting parts each of which emits different colors. In one example embodiment, each of the emitting parts can have a single-layered emitting material layer (EML). Alternatively, each of the emitting parts can have a multiple-layered structure of a hole injection layer (HIL), a hole transport layer (HTL), an electron blocking layer (EBL), an EML, a hole blocking layer (HBL), an electron transport layer (ETL) and/or an electron injection layer (EIL) (FIG. 10). In addition, the emissive layer 1120 can further include a charge generation layer (CGL) disposed between the emitting parts.

A bank layer 1074 is disposed on the passivation layer 1070 in order to cover edges of the first electrode 1110. The bank layer 1074 exposes or does not cover a center of the first electrode 1110 corresponding to each of the first to third pixel regions SP1, SP2 and SP3. The bank layer 1074 can be omitted.

Since the OLED D emits white color light in the first to third pixel regions SP1, SP2 and SP3, the emissive layer 1120 can be formed as a continuous common layer in the pixel regions SP1, SP2 and SP3. The bank layer 1074 blocks the current leakage in the edge of the first electrode 1110, and can be omitted.

The organic light emitting display device 1000 can further include an encapsulation film 1080 disposed on the second electrode 1130 in order to prevent or reduce outer moisture from penetrating into the OLED D. Optionally, the organic light emitting display device 1000 can further comprise a polarizing plate disposed under the first substrate 1010 or on the second substrate 1012 to reduce of external light.

The color filter layer 1090 is disposed on the OLED D or the encapsulation film 1080. For example, the color filter layer 1090 can include a first color filter layer 1092, a second color filter layer 1094 and a third color filter layer 1096 each of which is disposed correspondingly to the first pixel region SP1, the second pixel region SP2 and the third pixel region SP3, respectively. Each of the first color filter layer 1092, the second color filter layer 1094 and the third color filter layer 1096 can be a blue color filter layer, a green color filter layer and a red color filter layer, respectively.

For example, the first color filter layer 1092 can include at least one of blue dye and blue pigment, the second color filter layer 1094 can include at least one of green dye and green pigment, and the third color filter layer 1096 can include at least one of red dye and red pigment. In one example embodiment, the color filter layer 1090 can be attached to the OLED through an adhesive layer. Alternatively, the color filter layer 1090 can be disposed directly on the OLED D.

In FIG. 9, the light emitted from the OLED D passes through the second electrode 230 and the color filter layer 1090 is disposed on the OLED D. That is, the organic light emitting display device 1000 can be a top-emission type. Alternatively, the light emitted from the OLED can pass through the first electrode 210 and the color filter layer 1080 can be disposed between the OLED D and the first substrate 1010 when the organic light emitting device 1000 is a bottom-emission type.

In addition, a color conversion layer can be formed or disposed between the OLED D and the color filter layer 1090. The color conversion layer may include a blue color conversion layer, a green color conversion layer and a red color conversion layer each of which is disposed correspondingly to the first pixel region SP1, the second pixel region SP2 and the third pixel region SP3, respectively, so as to convert the white (W) color light to each of a blue, green and red color lights, respectively. Alternatively, the organic light emitting display device 1000 can comprise the color conversion film instead of the color filter layer 1090.

As described above, the white (W) color light emitted from the OLED D is transmitted through the first color filter layer 1092, the second color filter layer 1094 and the third color filter layer 1096 each of which is disposed correspondingly to the first to third pixel regions SP1, SP2 and SP3, respectively, so that each of blue, green and red color lights is displayed in the first pixel region SP1, the second pixel region SP2 and the third pixel region SP3, respectively.

An OLED that can be applied into the organic light emitting display device will be described in more detail. FIG. 10 illustrates a schematic cross-sectional view of an organic light emitting diode having a tandem structure of three emitting parts.

As illustrated in FIG. 10, the OLED D3 includes a first electrode 1110, a second electrode 1130 facing the first electrode 1110 and an emissive layer 1120 disposed between the first and second electrodes 1110 and 1130. One of the first and second electrodes 1110 and 1130 is an anode and the other of the first and second electrodes 1110 and 1130 is a cathode. Alternatively, one of the first and second electrodes 1110 and 1130 is a reflective electrode and the other of the first and second electrodes 1110 and 1130 is a transmissive (or semi-transmissive) electrode. Hereinafter, the OLED D3 where the first electrode 1110 is a reflective electrode and the second electrode 1130 is a transmissive (semi-transmissive) electrode will be described. The OLED D3 can further include a capping layer 1140 for improving light extraction.

The emissive layer 1120 include a first emitting part 1200 disposed between the first electrode 1110 and the second electrode 1130, a second emitting part 1300 disposed between the first emitting part 1200 and the second electrode 1130, and a third emitting part 1400 disposed between the second emitting part 1300 and the second electrode 1130. In addition, the emissive layer 1120 can further include a first charge generation layer (CGL1) 1290 disposed between the first emitting part 1200 and the second emitting part 1300 and a second charge generation layer (CGL2) 1390 disposed between the second emitting part 1300 and the third emitting part 1400.

One of the first emitting part 1200, the second emitting part 1300 and the third emitting part 1400 can include a blue fluorescence emitting layer, another of the first emitting part 1200, the second emitting part 1300 and the third emitting part 1400 can include a PSF blue emitting layer and the third of the first emitting part 1200, the second emitting part 1300 and the third emitting part 1400 can include a red-green emitting layer. Hereinafter, the OLED D3 where the first emitting part 1200 includes a blue fluorescence emitting layer, the third emitting part 1400 includes a PSF blue emitting layer and the second emitting part 1300 includes a red-green emitting layer.

The first emitting layer (blue fluorescent emitting part) 1200 includes a first blue emitting material layer (blue EML1) 1250 of a blue fluorescence emitting layer. The first emitting part 1200 can further include at least one of a first hole transport layer (HTL1) 1220 disposed between the first electrode 1110 and the blue EML1 1250 and a first electron transport layer (ETL1) 1280 disposed between the blue EML1 1250 and the CGL1 1290. In addition, the first emitting part 1000 can further include a hole injection layer (HIL) 1210 disposed between the first electrode 1110 and the HTL1 1220. The first emitting part 1200 can further include at least one of a first electron blocking layer (EBL1) 1230 disposed between the HTL1 1220 and the blue EML1 1250 and a first hole blocking layer (HBL1) 1270 disposed between the blue EML1 1250 and the ETL1 1280.

The second emitting part (red-green emitting part) 1300 includes a red-green emitting material layer (red-green EML) 1340 that includes a first layer 1340A and a second layer 1340B. The second emitting part 1300 can further include at least one of a second hole transport layer (HTL2) 1320 disposed between the CGL1 1290 and the red-green EML 1340 and a second electron transport layer (ETL2) 1380 disposed between the red-green EML 1340 and the CGL2 1390. The second emitting part 1300 can further include at least one of a second electron blocking layer (EBL2) 1330 disposed between the HTL2 1320 and the red-green EML 1340 and a second hole blocking layer (HBL2) 1370 disposed between the red-green EML 1340 and the ETL2 1380.

The third emitting part (blue PSF fluorescence emitting part) 1400 includes a second blue emitting material layer (blue EML2) 1460 of a PSF emitting layer. The third emitting part 1400 can further include at least one of a third hole transport layer (HTL3) 1420 disposed between the CGL2 1390 and the blue EML2 1460 and a third electron transport layer (ETL3) 1480 disposed between the blue EML2 1460 and the second electrode 1130. In addition, the third emitting part 1400 can further include an electron injection layer (EIL) 1490 disposed between the ETL3 1480 and the second electrode 1130. The third emitting part 1400 can further include at least one of a third electron blocking layer (EBL3) 1430 disposed between the HTL3 1420 and the blue EML2 1460 and a third hole blocking layer (HBL3) 1470 disposed between the blue EML2 1460 and the ETL3 1480.

The CGL1 1290 is disposed between the first emitting part 1200 and the second emitting part 1300. In other words, the first emitting part 1200 and the second emitting part 1300 are connected by the CGL1 1290. The CGL1 1290 can be a PN-junction charge generation layer combining a first N-type charge generation layer (N-CGL1) 1292 and a first P-type charge generation layer (P-CGL1) 1294.

The N-CGL1 1292 is disposed between the ETL1 1280 and the HTL2 1320 and the P-CGL1 1294 is disposed between the N-CGL1 1292 and the HTL2 1320. The N-CGL1 1292 transfers electrons to the blue EML1 1250 in the first emitting part 1200 and the P-CGL1 1294 transfers holes to the red-green EML 1340 in the second emitting part 1300.

The CGL2 1390 is disposed between the second emitting part 1300 and the third emitting part 1400. In other words, the second emitting part 1300 and the third emitting part 1400 are connected by the CGL2 1390. The CGL2 1390 can be a PN-junction charge generation layer combining a second N-type charge generation layer (N-CGL2) 1392 and a second P-type charge generation layer (P-CGL2) 1394.

The N-CGL2 1392 is disposed between the ETL2 1380 and the HTL3 1420 and the P-CGL2 1394 is disposed between the N-CGL2 1392 and the HTL3 1420. The N-CGL2 1392 transfers electrons to the red-green EML 1340 in the second emitting part 1300 and the P-CGL2 1394 transfers holes to the blue EML2 1460 in the third emitting part 1400.

In the OLED D3, the materials and contents of the HIL 1210, HTLs 1220, 1320 and 1420, EBLs 1230, 1330 and 1430, HBLs 1270, 1370 and 1470, ETLs 1280, 1380 and 1480, CGLs 1290 and 1390 and EIL 1490 can be identical to the materials and contents described with referring to FIGS. 3 to 8.

The blue EML1 1250 of the fluorescence emitting layer includes a first compound 1252 and optionally a second compound 1254. The first compound 1252 can be a first blue fluorescent compound (fluorescent emitter or fluorescent dopant) and can include, but is not limited to, the organic compound having the structure of Chemical Formulae 1 to 2. The second compound 1254 can be a first blue host and can include, but is not limited to, the organic compound having the structure of Chemical Formulae 3 to 4.

The blue EML2 1460 of the PSF emitting layer includes a third compound 1462, a fourth compound 1464, and optionally a fifth compound 1466 and/or a sixth compound 1468. The third compound 1462 can be a second blue fluorescent compound (fluorescent emitter or fluorescent dopant) and can includes, but is not limited to, the organic compound having the structure of Chemical Formulae 5 to 6. The fourth compound 1464 can be a blue phosphorescent compound (auxiliary dopant) and can include, but is not limited to, the organometallic compound having the structure of Chemical Formulae 7 to 8. The fifth compound 1466 can be a second blue host and can include, but is not limited to, the organic compound having the structure of Chemical Formulae 3 to 4. The sixth compound 1466 can be a third blue host and can include, but is not limited to, the organic compound having the structure of Chemical Formulae 9 to 10.

The second compound 1254 in the blue EML1 1250 can be identical to or different from the fifth compound 1466 in the blue EML2 1460. The contents of the first compound 1252 and the second compound 1254 in the blue EML1 1250 and the contents of the third compound 1462, the fourth compound 1464, the fifth compound 1466 and the sixth compound 1468 can be identical to the contents of the corresponding compounds described with referring to FIG. 3.

The blue EML2 1460 of the PSF emitting layer is disposed closer to the second electrode 1130 of the transmissive electrode than the blue EML1 1250. In other words, the blue EML2 1460 of the PSF emitting layer is disposed between the second electrode 1130 of the transmissive electrode and the blue EML1 1250 of the fluorescence emitting layer.

Alternatively, the first electrode 1110 can be the transmissive (semi-transmissive) electrode and the second electrode 1130 can be the reflective electrode. In this case, the blue EML2 1460 of the PSF emitting layer is disposed closer to the first electrode 1110 of the transmissive electrode than the blue EML1 1250 of the fluorescence emitting layer. In other words, the blue EML2 1460 of the PSF emitting layer is disposed between the first electrode 1110 and the blue EML1 1250 of the fluorescence emitting layer.

One of the first layer 1340A and the second layer 1340B among the red-green EML 1340 can be a red emitting material layer (red EML) and the other of the first layer 1340A and the second layer 1340B can be a green emitting material layer (green EML). Hereinafter, the OLED D3 where the first layer 1340A is a red EML and the second layer 1340B is a green EML will be described.

The first layer 1340A of the red EML includes a first red emitting material layer (red EML1) 1350A and a second red emitting material layer (red EML2) 1360A disposed between the red EML1 1350 and the second layer 1340B.

The red EML1 1350A of a first red fluorescence emitting layer can include a thirteenth compound 1352a, a fourteenth compound 1354a, and optionally a fifteenth compound 1356a. The thirteenth compound can be a red delayed fluorescent compound and can include, but is not limited to, the organic compound having the structure of Chemical Formulae 11 to 12. As an example, the thirteenth compound 1352a can be an organic compound where two cyano groups substituted to the benzene ring in Chemical Formula 11 are each linked at a para-position. The fourteenth compound 1354a can be a red fluorescent compound and can include, but is not limited to, the organic compound having the structure of Chemical Formulae 17 to 18. The fifteenth compound 1356a can be a first red host and can include, but is not limited to, the organic compound having the structure of Chemical Formulae 19 to 20.

The red EML2 1360A of the phosphorescence emitting layer can include a sixteenth compound 1362a and optionally a seventeenth compound 1364a. The sixteenth compound 1362a can be a red phosphorescent compound (phosphorescent emitter or phosphorescent dopant) and can be at least one of, but is not limited to, the organometallic compounds of Chemical Formula 21. The seventeenth compound 1364a can be a second red host and can include, but is not limited to, the organic compound having the structure of Chemical Formulae 19 to 20. The fifteenth compound 1356a in the red EML1 1350A can be identical to or different form the seventeenth compound 1364a in the red EML2 1360A. In addition, each of the fifteenth compound 1356a in the red EML1 1350A and the seventeenth compound 1364a in the red EML2 1360A can be independently identical to or different from the second compound 1254 in the blue EML1 1250.

The contents of the thirteenth compound 1352a, the fourteenth compound 1354a and the fifteenth compound 1356a in the red EML1 1350A and the contents of the sixteenth compound 1362a and the seventeenth compound 1364a in the red EML2 1360A can be identical to the contents of the corresponding materials described with referring to FIG. 5.

The red EML2 1360A of the phosphorescence emitting layer is disposed closer to the second electrode 1130 of the transmissive electrode than the red EML1 1350A of the fluorescence emitting layer in the red EML 1340A. In other words, the red EML2 1360A of the phosphorescence emitting layer is disposed between the second electrode 1130 of the transmissive electrode and the red EML1 1350A of the fluorescence emitting layer.

Alternatively, the first electrode 1110 can be the transmissive electrode and the second electrode 1130 can be the reflective electrode. In this case, the red EML2 of the phosphorescence emitting layer can be disposed closer to the first electrode 1110 of the transmissive electrode than the red EML1 of the fluorescence emitting layer in the red EML 1340A. In other words, the red EML2 1360B of the phosphorescence emitting layer can be disposed been the first electrode 1110 and the red EML1 1350A of the fluorescence emitting layer.

The second layer 1340B of the green EML includes a first green emitting material layer (green EML1) 1350B and a second green emitting material layer (green EML2) 1360B disposed between the green EML1 1350B and the HBL2 1370.

The green EML1 1350B of the fluorescence emitting layer can include a seventh compound 1352b, an eighth compound 1354b, and optionally a ninth compound 1356b. The green EML2 1360B of the fluorescence emitting layer can include a tenth compound 1362b, an eleventh compound 1364b, and optionally a twelfth compound 1366b.

Each of the seventh compound 1352b in the green EML1 1350B and the tenth compound 1362b in the green EML2 1360B is a first green delayed fluorescent compound (auxiliary dopant) and a second green delayed fluorescent compound (auxiliary dopant), respectively. The seventh compound 1352b can be identical to or different from the tenth compound 1362b. Each of the seventh compound 1352b and the tenth compound 1362b can independently include, but is not limited to, the organic compound having the structure of Chemical Formulae 11 to 12. As an example, each of the seventh compound 1352b and the tenth compound 1362b can be independently an organic compound where two cyano groups substituted to the benzene ring in Chemical Formula 11 are each linked at an ortho-or meta- position.

Each of the eighth compound 1354b in the green EML1 1350B and the eleventh compound 1364b in the green EML2 1360B is a first green fluorescent compound (fluorescent emitter or fluorescent dopant) and a second green fluorescent compound, respectively. The eighth compound 1354b can be identical to or different form the eleventh compound 1364b. Each of the eighth compound 1354b and the eleventh compound 1364b can include, but is not limited to, the organic compound having the structure of Chemical Formulae 13A to 14.

Each of the ninth compound 1356b in the green EML1 1350B and the twelfth compound 1366b in the green EML2 1360B is a first green host and a second green host, respectively. The ninth compound 1356b can be identical to or different from the twelfth compound 1366b. Each of the ninth compound 1356b and the twelfth compound 1366b can include, but is not limited to, the organic compound having the structure of Chemical Formulae 15 to 16. In addition, each of the ninth compound 1356b in the green EML1 1350B and the twelfth compound 1366b in the green EML2 1360B can be independently identical to or different from the second compound 1254 in the blue EML1 1250.

The contents of the seventh compound 1352b, the eighth compound 1354b and the ninth compound 1356b in the green EML1 1350B and the contents of the tenth compound 1362b, the eleventh compound 1364b and the twelfth compound 1366b in the green EML2 1360B can be identical to the contents of the corresponding materials described with referring to FIG.7.

Alternatively, the red-green EML 1340 can further include a third layer of a yellow-green emitting material layer disposed between the first layer 1340A and the second layer 1340B. The third layer can include a yellow-green host and a yellow-green emitter (yellow-green dopant). The yellow-green host can include at least one of the second compound 1254, the fifth compound 1466, the sixth compound 1468, the ninth compound 1356b, the twelfth compound 1366b, the fifteenth compound 1356a and the seventeenth compound 1364a. For example, the yellow-green host can include at least one of the ninth compound 1356b, the twelfth compound 1366b, the fifteenth compound 1356a and the seventeenth compound 1364a.

The yellow-green emitter can include at least one of a yellow-green phosphorescent compound, a yellow-green fluorescent compound and a yellow-green delayed fluorescent compound. For example, the yellow-green emitter can include, but is not limited to, 5,6,11,12-tetraphenylnaphthalene (Rubrene), 2,8-di-tert-butyl-5,11-bis(4-tert-butylphenyl)-6,12-diphenyltetracene (TBRb), bis(2-phenylbenzothiazolato)(acetylacetonate)irdium (III) (Ir(BT)₂(acac)), bis(2-(9,9-diethytl-fluoren-2-yl)-1-phenyl-1H-benzo[d]imdiazolato)(acetylacetonate)iridium(III) (Ir(fbi)₂(acac)), bis(2-phenylpyridine)(3-(pyridine-2-yl)-2H-chromen-2-onate)iridium(III) (fac-Ir(ppy)₂Pc), bis(2-(2,4-difluorophenyl)quinoline)(picolinate)iridium(III) (FPQIrpic), bis(4-phenylthieno[3,2-c]pyridinato-N,C2') (acetylacetonate) iridium(III) (PO-01) and/or combinations thereof.

In another example embodiment, a difference between a first luminescence peak intensity in the blue EML1 1250 of the fluorescence emitting layer and a second luminescence peak intensity in the blue EML2 1460 of the PSF emitting layer can be about 0.1 or less. The blue EML2 1460 of the PSF emitting layer is disposed closer to the second electrode 1130 of the transmissive electrode than the blue EML1 1250 of the fluorescence emitting layer. Accordingly, a strong cavity effect can be realized in the OLED D3 so that the OLED D3 can have lower driving voltages and greatly improved blue luminous efficiency. In another example embodiment, a difference between the maximum absorption wavelength of the third compound 1462 and the maximum photoluminescence wavelength of the fourth compound 1464 in the blue EML2 1460 can be about 15 nm or less. Accordingly, luminous properties of the blue OLED D3 can be further improved.

In addition, the red EML2 1360A of the phosphorescence emitting layer, which has higher luminous efficiency than the red EML1 1350A of the fluorescence emitting layer, is disposed adjacently to the second electrode 1130 of the transmissive electrode so that the luminous efficiency of the OLED D3 can be further improved.

The green EML 1340B includes the green EML1 1350B and the green EML2 1360B each of which includes the delayed fluorescent compound 1352b or 1362b, respectively, with beneficial luminous efficiency, so that the luminous efficiency and the luminous lifespan of the OLED D3 can be greatly improved. In addition, each of the green EML1 1350B and the green EML2 1360B includes the green fluorescent compound 1354b or 1364b, respectively, with beneficial color purity, so that the color purity of the OLED D3 can be improved. Since the OLED D3 has a tandem structure, the OLED can realized a white emission with lower driving voltages and excellent luminous efficiency and color purity.

### [Green Organic Light Emitting Diode]

### Example 1 (Ex.1): Fabrication of an OLED

An organic light emitting diode where each of two emitting parts having a tandem structure includes a delayed fluorescent compound, respectively, in the following order:

Anode (ITO/Ag/ITO, 10 nm); a hole injection layer (HIL, NPB (98 wt%) and HAT-CN (2 wt%), 3 nm); a first hole transport layer (HTL1, NPB, 30 nm); a first electron blocking layer (EBL1, TAPC, 10 nm); a first emitting material layer (EML1, Compound GH-11 of Chemical Formula 16 (50 wt%), Compound TD-1 of Chemical Formula 12 (49.2 wt%) and Compound G-FD-4 of Chemical Formula 14 (0.8 wt%), 35 nm); a first hole blocking layer (HBL1, B3PYMPM, 10 nm); a first electron transport layer (ETL1, TPBi, 15 nm); N-type charge generation layer (N-CGL, TPBi (98 wt%) and Li (2 wt%), 12 nm); P-type charge generation layer (P-CGL, NPB (98 wt%) and HAT-CN (2 wt%), 8 nm), a second hole transport layer (HTL2, NPB, 40~120 nm); a second electron blocking layer (EBL2, TAPC, 10 nm); a second emitting material layer (EML2, Compound GH-7 of Chemical Formula 16 (50 wt%), Compound TD-1 of Chemical Formula 12 (49.5 wt5) and G-FD-1 of Chemical Formula 14 (0.5 wt%), 35 nm); a second hole blocking layer (HBL2, B3PYMPM, 10 nm); a second electron transport layer (ETL2, TPBi, 30 nm); an electron injection layer (EIL, LiF, 8 nm); a cathode (AgMg, 15 nm); and a capping layer (CPL, 60 nm).

The structures of materials used in the emissive layer and the CPL are illustrated in the following:

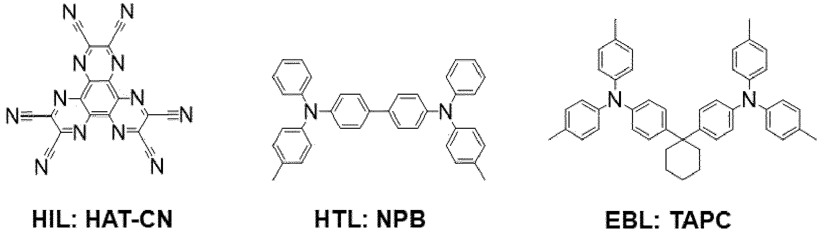

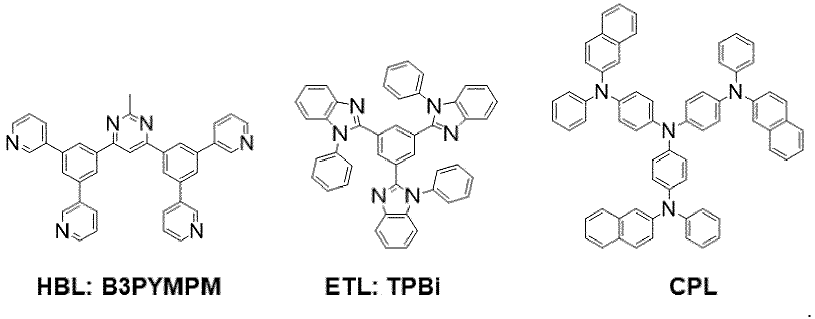

### Example 2 (Ex. 2): Fabrication of OLED

An OLED was fabricated using the same procedure and the same material as Example 1, except that EML1 and EML2 have been replaced for an EML1 that includes Compound GH-7 of Chemical Formula 16 (50 wt%), Compound TD-1 of Chemical Formula 12 (49.5 wt%) and Compound G-FD-1 of Chemical Formula 14 (0.5 wt%), and an EML2 that includes Compound GH-11 of Chemical Formula 16 (50 wt%), Compound TD-1 of Chemical Formula 12 (49.2 wt%) and Compound G-FD-4 of Chemical Formula 14 (0.8 wt%).

### Example 3 (Ex. 3): Fabrication of OLED

An OLED was fabricated using the same procedure and the same material as Example 1, except that EML1 and EML2 have been replaced for an EML1 and an EML2 each including Compound GH-11 of Chemical Formula 16 (50 wt%), Compound TD-1 of Chemical Formula 12 (49.2 wt%) and Compound G-FD-4 of Chemical Formula 14 (0.8 wt%), respectively.

### Example 4 (Ex. 4): Fabrication of OLED

An OLED was fabricated using the same procedure and the same material as Example 1, except that EML1 and EML2 have been replaced for an EML1 that includes Compound GH-7 of Chemical Formula 16 (50 wt%), Compound TD-1 of Chemical Formula 12 (49.2 wt%) and Compound G-FD-4 of Chemical Formula 14 (0.8 wt%), and an EML2 that includes Compound GH-11 of Chemical Formula 16 (50 wt%), Compound TD-1 of Chemical Formula 12 (49.2 wt%) and Compound G-FD-4 of Chemical Formula 14 (0.8 wt%).

### Example 5 (Ex. 5): Fabrication of OLED

An OLED was fabricated using the same procedure and the same material as Example 1, except that EML1 and EML2 have been replaced for an EML1 and an EML2 each including Compound GH-11 of Chemical Formula 16 (60 wt%), Compound TD-1 of Chemical Formula 12 (39.2 wt%) and Compound G-FD-4 of Chemical Formula 14 (0.8 wt%), respectively.

### Comparative Example 1 (Ref. 1): Fabrication of OLED

An OLED was fabricated using the same procedure and the same material as Example 1, except that EML1 and EML2 have been replaced for an EML1 and an EML2 each including Compound GH-11 of Chemical Formula 16 (94 wt%) and Compound G-PD below of green phosphorescent compound (6 wt%), respectively.

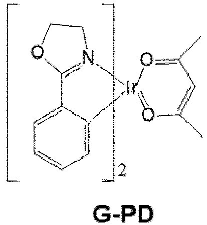

### Comparative Example 2 (Ref. 2): Fabrication of OLED

An OLED was fabricated using the same procedure and the same material as Example 1, except that the EML2 has been replaced by an EML2 that includes Compound GH-11 of Chemical Formula 16 (94 wt%) and Compound G-PD (6 wt%).

### Comparative Example 3 (Ref. 3: Fabrication of OLED

An OLED was fabricated using the same procedure and the same material as Example 2, except that the EML1 has been replaced for an EML1 that includes Compound GH-11 of Chemical Formula 16 (94 wt%) and Compound G-PD (6 wt%).

### Comparative Example 4 (Ref. 4: Fabrication of OLED

An OLED was fabricated using the same procedure and the same material as Example 1 except that the EML1 has been replaced for an EML1 that includes Compound GH-11 of Chemical Formula 16 (94 wt%) and Compound G-PD (6 wt%).

### Experimental Example 1: Measurement of Luminous Properties of OLEDs

The luminous properties for each of the OLEDs fabricated in Examples 1 to 5 and Comparative Examples 1 to 4 was measured. In particular, driving voltage (V), color coordinates (CIEx, CIEy), current efficiency (cd/A), power efficiency (Im/W), luminance (cd/m²), maximum electroluminescence wavelength (ELₘₐₓ, nm), full-width at half maximum (FWHM) and luminous lifetime (T₉₅) for the OLEDs were measured. The measurement results are indicated in the following Table 1.

**Table 1: Luminous Properties of OLED**

| Sample | V | CIEx | CIEy | cd/A | Im/W | cd/m 2 | ELₘₐₓ (nm) | FWHM (nm) | T₉₅ (hr) |
|---|---|---|---|---|---|---|---|---|---|
| Ref. 1 | 5.80 | 0.240 | 0.717 | 304.3 | 164.7 | 6373 | 528 | 28 | 1500 |
| Ref.2 | 5.63 | 0.218 | 0.735 | 257.6 | 143.8 | 6221 | 530 | 24 | 900 |
| Ref.3 | 5.59 | 0.240 | 0.718 | 310.8 | 174.6 | 6355 | 530 | 27 | 850 |
| Ref.4 | 6.23 | 0.256 | 0.709 | 282.9 | 142.8 | 6452 | 532 | 28 | 1000 |
| Ex.1 | 5.63 | 0.250 | 0.717 | 331.6 | 185.0 | 6418 | 532 | 25 | 900 |
| Ex.2 | 5.65 | 0.237 | 0.723 | 312.9 | 174.0 | 6338 | 530 | 24 | 900 |
| Ex.3 | 5.64 | 0.243 | 0.721 | 335.7 | 187.0 | 6376 | 532 | 25 | 1400 |
| Ex.4 | 5.58 | 0.252 | 0.715 | 318.6 | 179.5 | 6429 | 532 | 25 | 1250 |
| Ex.5 | 5.61 | 0.258 | 0.707 | 343.5 | 192.3 | 6469 | 532 | 29 | 700 |

As indicated in Table 1, as compared to the OLED fabricated in the Comparative Examples 1-4, in the OLED fabricated in Examples 1-5, the driving voltage was lowered by maximally 10.0%, current efficiency, power efficiency, luminance and luminous lifespan were improved by maximally 28.7%, 34.7%, 4.0% and 64.7%, respectively. In addition, as compared to the OLED fabricated in Comparative Example 1-4, the color coordinate and color purity of the OLED fabricated in Examples 1-5 maintained an equivalent level.

### [Red Organic Light Emitting Diode]

### Example 6 (Ex.6): Fabrication of OLED

An organic light emitting diode where a first emitting part includes a delayed fluorescent compound and a second emitting part includes a phosphorescent compound among two emitting parts having a tandem structure, as the following order:

Anode (ITO/Ag/ITO, 10 nm); a hole injection layer (HIL, NPB (98 wt%) and HAT-CN (2 wt%), 3 nm); a first hole transport layer (HTL1, NPB, 30 nm); a first electron blocking layer (EBL1, TAPC, 10 nm); a first emitting material layer (EML1, Compound RH-13 of Chemical Formula 20 (50 wt%), Compound TD-2 of Chemical Formula 12 (49.5 wt%) and Compound R-FD-1 of Chemical Formula 18 (0.5 wt%), 40 nm); a first hole blocking layer (HBL1, B3PYMPM, 10 nm); a first electron transport layer (ETL1, TPBi, 15 nm); N-type charge generation layer (N-CGL, TPBi (98 wt%) and Li (2 wt%), 12 nm); P-type charge generation layer (P-CGL, NPB (98 wt%) and HAT-CN (2 wt%), 8 nm), a second hole transport layer (HTL2, NPB, 40~120 nm); a second electron blocking layer (EBL2, TAPC, 10 nm); a second emitting material layer (EML2, Compound RH-1 of Chemical Formula 20 (98 wt%) and Compound R-PD-1 of Chemical Formula 21 (2 wt%), 35 nm); a second hole blocking layer (HBL2, B3PYMPM, 10 nm); a second electron transport layer (ETL2, TPBi, 30 nm); an electron injection layer (EIL, LiF, 8 nm); a cathode (AgMg, 15 nm); and a capping layer (CPL, 60 nm).

### Examples 7 (Ex. 7): Fabrication of OLED

An OLED was fabricated using the same procedure and the same material as Example 6, except that Compound R-FD-2 of Chemical Formula 18 was used instead of Compound R-FD-1 in the EML1.

### Example 8 (Ex. 8): Fabrication of OLED

An OLED was fabricated using the same procedure and the same material as Example 6, except that Compound RH-1 of Chemical Formula 20 was used instead of Compound RH-13 in the EML1.

### Comparative Example 5 (Ref. 5): Fabrication of OLED

An OLED was fabricated using the same procedure and the same material as Example 6, except that the EML1 and the EML2 have been replaced by an EML1 and an EML2 each including Compound RH-1 of Chemical Formula 20 (98 wt%) and Compound R-PD-1 of Chemical Formula 21 (2 wt%), respectively.

### Comparative Example 6 (Ref. 6): Fabrication of OLED

An OLED was fabricated using the same procedure and the same material as Example 6, except that the EML1 has been replaced by an EML1 that includes Compound RH-1 of Chemical Formula 20 (98 wt%) and Compound R-PD-1 of Chemical Formula 21, and that the EML2 has been replaced by an EML2 that includes Compound RH-13 of Chemical Formula 20 (50 wt%), Compound TD-2 of Chemical Formula 12 (49.5%) and Compound R-FD-1 of Chemical Formula 18 (0.5 wt%).

### Comparative Example 7 (Ref. 7): Fabrication of OLED

An OLED was fabricated using the same procedure and the same material as Example 6, except that the EML1 and the EML2 have been replaced by an EML1 and an EML2 each including Compound RH-13 of Chemical Formula 20 (50 wt%), Compound TD-2 of Chemical Formula 12 (49.5 wt%) and Compound R-FD-1 of Chemical Formula 18 (0.5 wt%), respectively.

### Experimental Example 2: Measurement of Luminous Properties of OLEDs

The luminous properties for each of the OLEDs fabricated in Examples 6 to 8 and Comparative Examples 5 to 7 was measured as Experimental Example 1. The measurement results are indicated in the following Table 2.

**Table 2: Luminous Properties of OLED**

| Sample | V | CIEx | CIEy | cd/A | Im/W | cd/m ² | ELₘₐₓ (nm) | FWHM (nm) | T₉₅ (hr) |
|---|---|---|---|---|---|---|---|---|---|
| Ref.5 | 6.16 | 0.680 | 0.318 | 127.2 | 64.8 | 7687 | 620 | 28 | 1654 |
| Ex.6 | 7.38 | 0.680 | 0.318 | 128.7 | 54.8 | 7652 | 622 | 29 | 2593 |
| Ex.7 | 6.04 | 0.680 | 0.318 | 138.7 | 72.1 | 7623 | 620 | 28 | 2200 |
| Ex.8 | 7.35 | 0.677 | 0.322 | 117.3 | 50.1 | 7802 | 620 | 29 | 2000 |
| Ref. 6 | 8.20 | 0.680 | 0.319 | 101.5 | 38.9 | 7663 | 622 | 30 | 1653 |
| Ref.7 | 9.80 | 0.677 | 0.321 | 76.0 | 24.3 | 7738 | 622 | 28 | 1300 |

As indicated in Table 2, as compared to the OLED fabricated in the Comparative Examples 5-7, in the OLED fabricated in Examples 6-8, the driving voltage was lowered by maximally 38.4%, current efficiency, power efficiency, luminance and luminous lifespan were improved by maximally 82.5%, 196.7%, 1.8% and 99.5.7%, respectively. In addition, as compared to the OLED fabricated in Comparative Example 5-7, the color coordinate and color purity of the OLED fabricated in Examples 6-8 maintained an equivalent level.

### [Blue Organic Light Emitting Diode]

### Example 9 (Ex.9): Fabrication of OLED

An organic light emitting diode where a first emitting part includes a fluorescent compound and a second emitting part includes a phosphorescent compound and a fluorescent compound among two emitting parts having a tandem structure, as the following order:
Anode (ITO/Ag/ITO, 10 nm); a hole injection layer (HIL, NPB (98 wt%) and HAT-CN (2 wt%), 3 nm); a first hole transport layer (HTL1, NPB, 30 nm); a first electron blocking layer (EBL1, TAPC, 10 nm); a first emitting material layer (EML1, Compound B-PH-1 of Chemical Formula 4 (99 wt%) and Compound B-FD1-1 of Chemical Formula 2 (1 wt%), 19 nm); a first hole blocking layer (HBL1, B3PYMPM, 10 nm); a first electron transport layer (ETL1, TPBi, 15 nm); N-type charge generation layer (N-CGL, TPBi (98 wt%) and Li (2 wt%), 12 nm); P-type charge generation layer (P-CGL, NPB (98 wt%) and HAT-CN (2 wt%), 8 nm), a second hole transport layer (HTL2, NPB, 40~120 nm); a second electron blocking layer (EBL2, TAPC, 10 nm); a second emitting material layer (EML2, Compound B-PH-1 of Chemical Formula 4 (44 wt%), Compound B-NH-1 of Chemical Formula 10 (44 wt%), Compound B-PD-4 of Chemical Formula 8 (11.5 wt%) and Compound B-FD-5 of Chemical Formula 6 (0.5 wt%), 19 nm); a second hole blocking layer (HBL2, B3PYMPM, 10 nm); a second electron transport layer (ETL2, TPBi, 30 nm); an electron injection layer (EIL, LiF, 8 nm); a cathode (AgMg, 15 nm); and a capping layer (CPL, 60 nm).

### Comparative Example 8 (Ref. 8): Fabrication of OLED

An OLED was fabricated using the same procedure and the same material as Example 9, except that the EML1 has been replaced by an EML1 that includes Compound B-PH-1 of Chemical Formula 4 (44 wt%), Compound B-NH-1 of Chemical Formula 10 (44 wt%), Compound B-PD-4 of Chemical Formula 8 (11.5 wt%) and Compound B-FD-5 of Chemical Formula 6, and the EML2 has been replaced by an EML2 that includes Compound B-PH-1 (99 wt%) and Compound B-FD1-1 of Chemical Formula 2 (1 wt%).

### Comparative Example 9 (Ref. 9): Fabrication of OLED

An OLED was fabricated using the same procedure and the same material as Example 9, except that the EML1 and the EML2 have been replaced by an EML1 and an EML2 each including Compound B-PH-1 of Chemical Formula 2 (99 wt%) and Compound B-FD1-1 of Chemical Formula 2 (1 wt%), respectively.

### Experimental Example 3: Measurement of Luminous Properties of OLEDs

The luminous properties for each of the OLEDs fabricated in Example 9 and Comparative Examples 8 to 9 was measured as Experimental Example 1. The measurement results are indicated in the following Table 3.

**Table 3: Luminous Properties of OLED**

| Sample | V | CIEx | CIEy | cd/A | T₉₅ (hr) |
|---|---|---|---|---|---|
| Ex.9 | 5.90 | 0.133 | 0.057 | 28.2 | 120 |
| Ref.8 | 6.00 | 0.133 | 0.064 | 23.7 | 90 |
| Ref.9 | 6.10 | 0.149 | 0.049 | 16.9 | 600 |

As indicated in Table 3, as compared to the OLED fabricated in the Comparative Examples 8-9, in the OLED fabricated in Example 9, the driving voltage was lowered by maximally 3.3%, current efficiency and luminous lifespan were improved by maximally 66.9% and 33.3%, respectively. In addition, as compared to the OLED fabricated in Comparative Example 8-9, the color coordinate and color purity of the OLED fabricated in Example 9 maintained an equivalent level.

### Examples 10-17 (Ex. 10-17): Fabrication of white OLED

A white OLED was fabricated by combining the red OLED, the green OLED and the blue OLED fabricated in Examples as indicated in Table 4 below.

### Comparative Examples 10-32 (Ref. 10-32): Fabrication of white OLED

A white OLED was fabricated by combining the red OLED, the green OLED and the blue OLED fabricated in Examples as indicated in Tables 4 and 5 below.

### Experimental Example 4: Measurement of Luminous Properties of OLEDs

Current efficiency for each of the white OLEDs fabricated in Examples 10-17 and Comparative Examples 10-32 was measured as Experimental Example 1, and color coordinate for each of the white OLEDs were determined by simulation. The color coordinate in all white OLEDs was (0.313, 0.329). The measurement results for the white OLEDs are indicated in the following Tables 4 and 5.

**Table 4: Luminous Properties of OLED**

| Sample | Red OLED | Green OLED | Blue OLED | cd/A |
|---|---|---|---|---|
| Ref.10 | Ref. 5 | Ref. 1 | Ex.9 | 173.9 |
| Ref.11 | Ref. 5 | Ref.2 | Ex.9 | 164.1 |
| Ref.12 | Ex.6 | Ref.2 | Ex.9 | 164.6 |
| Ref.13 | Ex.6 | Ref. 3 | Ex.9 | 175.7 |
| Ref.14 | Ex.6 | Ref.4 | Ex.9 | 170.2 |
| Ex. 10 | Ex.6 | Ex.1 | Ex.9 | 179.4 |
| Ex. 11 | Ex.6 | Ex.3 | Ex.9 | 180.1 |
| Ex. 12 | Ex.6 | Ex.4 | Ex.9 | 177.2 |
| Ex. 13 | Ex.6 | Ex. 5 | Ex.9 | 181.4 |
| Ref.15 | Ex. 7 | Ref.2 | Ex.9 | 167.6 |
| Ref.16 | Ex. 7 | Ref.4 | Ex.9 | 173.5 |
| Ex. 14 | Ex. 7 | Ex.3 | Ex.9 | 183.8 |
| Ex. 15 | Ex. 7 | Ex.4 | Ex.9 | 180.7 |
| Ex. 16 | Ex. 7 | Ex. 5 | Ex.9 | 185.1 |
| Ref.17 | Ref.6 | Ref. 1 | Ex.9 | 162.8 |
| Ref.18 | Ref.6 | Ref.2 | Ex.9 | 154.1 |
| Ref.19 | Ref.6 | Ref.4 | Ex.9 | 159.0 |
| Ref.20 | Ref.6 | Ex.3 | Ex.9 | 167.7 |

**Table 5: Luminous Properties of OLED**

| Sample | Red OLED | Green OLED | Blue OLED | cd/A |
|---|---|---|---|---|
| Ref.21 | Ref.7 | Ref. 1 | Ex.9 | 147.1 |
| Ref.22 | Ref.7 | Ref.2 | Ex.9 | 140.0 |
| Ref.23 | Ref.7 | Ref.4 | Ex.9 | 144.0 |
| Ref.24 | Ref.7 | Ex.3 | Ex.9 | 151.1 |
| Ref.25 | Ex.8 | Ref.2 | Ex.9 | 160.6 |
| Ref.26 | Ex.8 | Ref. 3 | Ex.9 | 171.2 |
| Ex.17 | Ex.8 | Ex.5 | Ex.9 | 176.6 |
| Ref.27 | Ex.7 | Ex.3 | Ref. 8 | 170.3 |
| Ref.28 | Ex.7 | Ex.3 | Ref. 9 | 143.6 |
| Ref.29 | Ex.6 | Ex.3 | Ref. 8 | 167.1 |
| Ref.30 | Ex.6 | Ex.3 | Ref. 9 | 141.3 |
| Ref.31 | Ex.6 | Ex.5 | Ref. 8 | 168.2 |
| Ref.32 | Ex.6 | Ex.5 | Ref. 9 | 142.1 |

As indicated in Tables 4 and 5, as compared to the OLED fabricated in the Comparative Examples 10-32, in the OLED fabricated in Examples 10-17, the current efficiency was improved by maximally 32.2%.

Moreover, the following further embodiments are described:

### [Embodiment 1x]

An organic light emitting device, including:
A substrate defining a first pixel region, a second pixel region and a third pixel region;
   and
an organic light emitting diode disposed over the substrate,
wherein the organic light emitting diode includes a transmissive electrode, a reflective electrode facing the transmissive electrode and an emissive layer disposed between the transmissive electrode and the reflective electrode, and corresponds to each of the first pixel region, the second pixel region and the third pixel region, respectively,
wherein the emissive layer of the organic light emitting diode disposed in the first pixel region includes a first blue emitting material layer including a first fluorescent compound, and a second blue emitting material layer disposed between the first blue emitting material layer and the transmissive electrode and including a second fluorescent compound and a blue phosphorescent compound, and
wherein the emissive layer of the organic light emitting diode disposed in the second pixel region includes a first green emitting material layer including a first green delayed fluorescent compound, and a second green emitting material layer disposed between the first green emitting material layer and the transmissive layer and including a second green delayed fluorescent compound.

### [Embodiment 2x]

The organic light emitting device of embodiment 1x, wherein the first blue fluorescent compound includes an organic compound having the following structure of Chemical Formula 1: 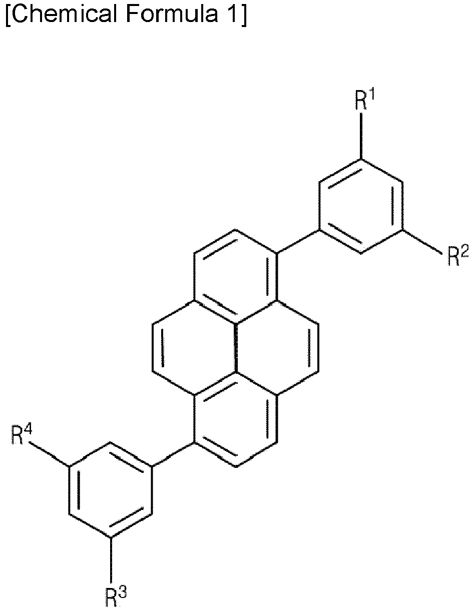 wherein, in the Chemical Formula 1,
each of R¹, R², R³ and R⁴ is independently hydrogen, an unsubstituted or substituted C₁-C₂₀ alkyl group, an unsubstituted or substituted C₆-C₃₀ aryl group or an unsubstituted or substituted C₆-C₃₀ aryl amino group.

### [Embodiment 3x]

The organic light emitting device of embodiment 1x or 2x, wherein the first blue fluorescent compound is at least one of the following compounds:

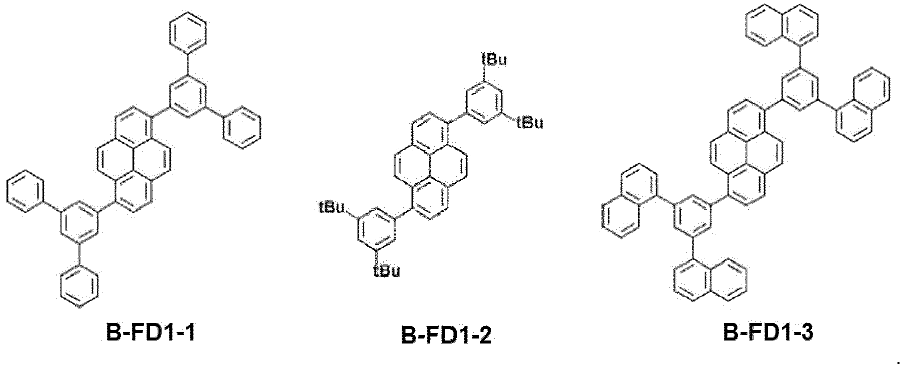

### [Embodiment 4x]

The organic light emitting device of any one of embodiments 1x to 3x, wherein the first blue emitting material layer further includes a first blue host having the following structure of Chemical Formula 3: 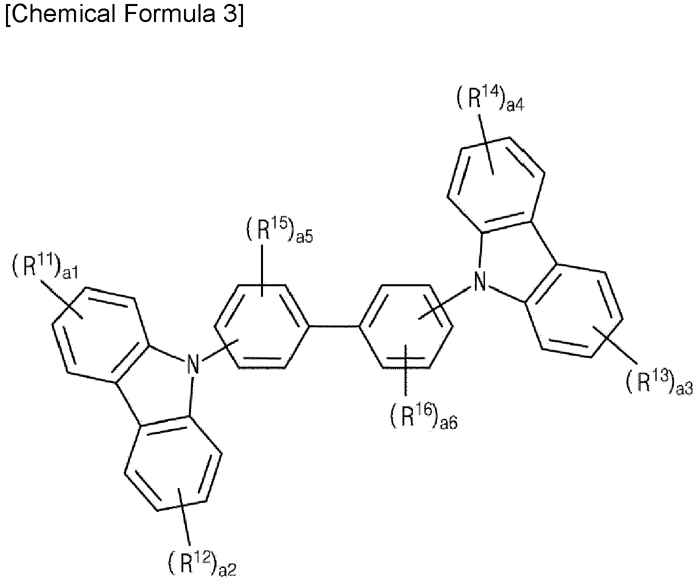 wherein, in the Chemical Formula 3,
each of R¹¹, R¹², R¹³, R¹⁴, R¹⁵ and R¹⁶ is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹ is identical to or different from each other when a1 is 2, 3 or 4, where each R¹² is identical to or different from each other when a2 is 2, 3 or 4, where each R¹³ is identical to or different from each other when a3 is 2, 3 or 4, where each R¹⁴ is identical to or different from each other when a4 is 2, 3 or 4, where each R¹⁵ is identical to or different from each other when a5 is 2, 3 or 4, and where each R¹⁶ is identical to or different from each other when a6 is 2, 3 or 4; and
each of a1, a2, a3, a4, a5 and a6 is independently 0, 1, 2, 3 or 4.

### [Embodiment 5x]

The organic light emitting device of embodiment 4x, wherein the first blue host has the following structure of Chemical Formula 3A or Chemical Formula 3B: 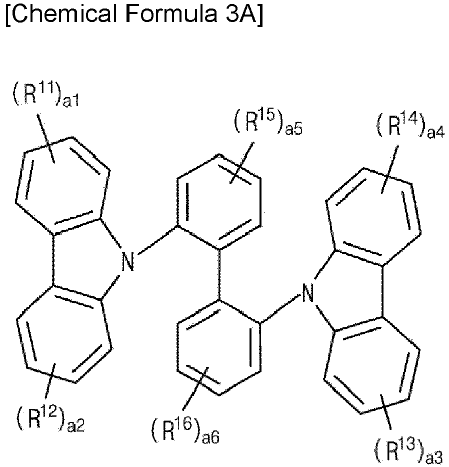 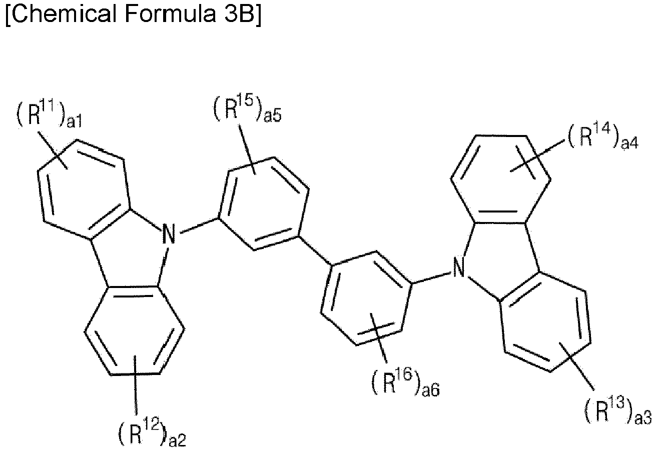 wherein, in the Chemical Formulae 3A and 3B,
each of R¹¹, R¹², R¹³, R¹⁴, R¹⁵ and R¹⁶, and a1, a2, a3, a4, a5 and a6 is a same as defined in Chemical Formula 3.

### [Embodiment 6x]

The organic light emitting device of embodiment 4x or 5x, wherein the first blue host is at least one of the following compounds:

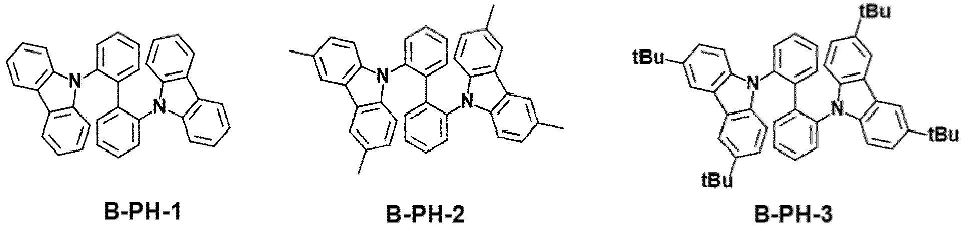

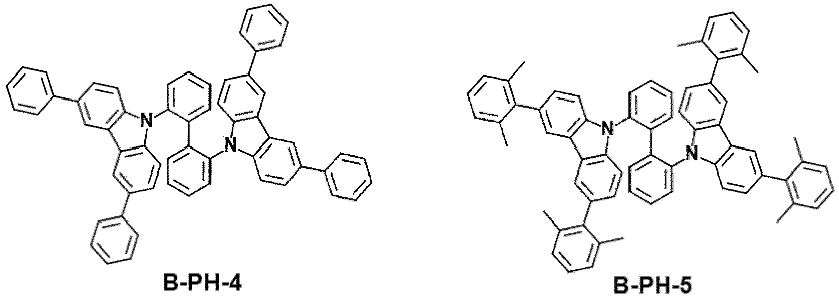

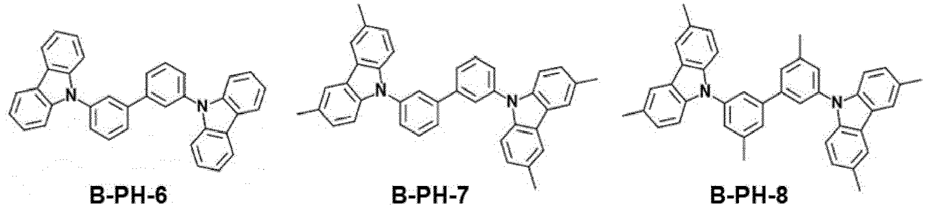

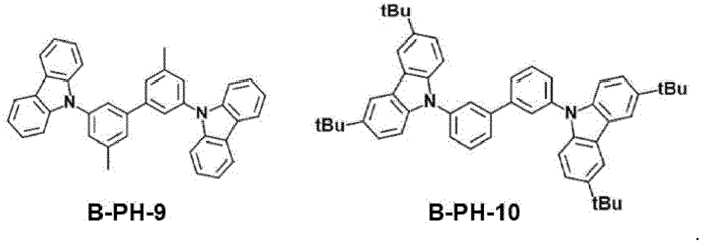

### [Embodiment 7x]

The organic light emitting device of any one of embodiments 1x to 6x, wherein the second blue fluorescent compound includes an organic compound having the following structure of Chemical Formula 5: 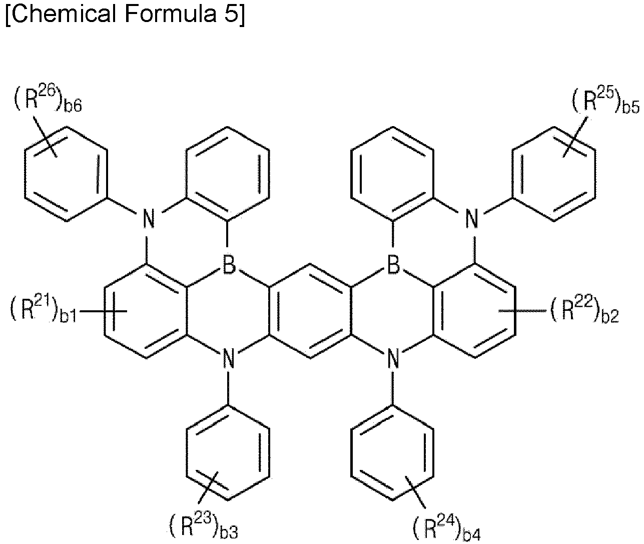 wherein, in the Chemical Formula 5,
each of R²¹ and R²² is independently an unsubstituted or substituted C₆-C₃₀ aryl group, an unsubstituted or substituted C₃-C₃₀ hetero aryl group or an unsubstituted or substituted C₆-C₃₀ aryl amino group, where each R²¹ is identical to or different from each other when b1 is 2 or 3, and where each R²² is identical to or different from each other when b2 is 2 or 3;
each of R²³, R²⁴, R²⁵ and R²⁶ is independently an unsubstituted or substituted C₁-C₂₀ alkyl group or an unsubstituted or substituted C₆-C₃₀ aryl group, where each R²³ is identical to or different from each other when b3 is 2, 3, 4 or 5, where each R²⁴ is identical to or different from each other when b4 is 2, 3, 4 or 5, where each R²⁵ is identical to or different from each other when b5 is 2, 3, 4 or 5, and where each R²⁶ is identical to or different from each other when b6 is 2, 3, 4 or 5;
each of b1 and b2 is independently 0, 1, 2 or 3; and
each of b3, b4, b5 and b6 is independently 0, 1, 2, 3, 4 or 5.

### [Embodiment 8x]

The organic light emitting device of any one of embodiments 1x to 7x, wherein the second blue fluorescent compound includes an organic compound having the following structure of Chemical Formula 5A: 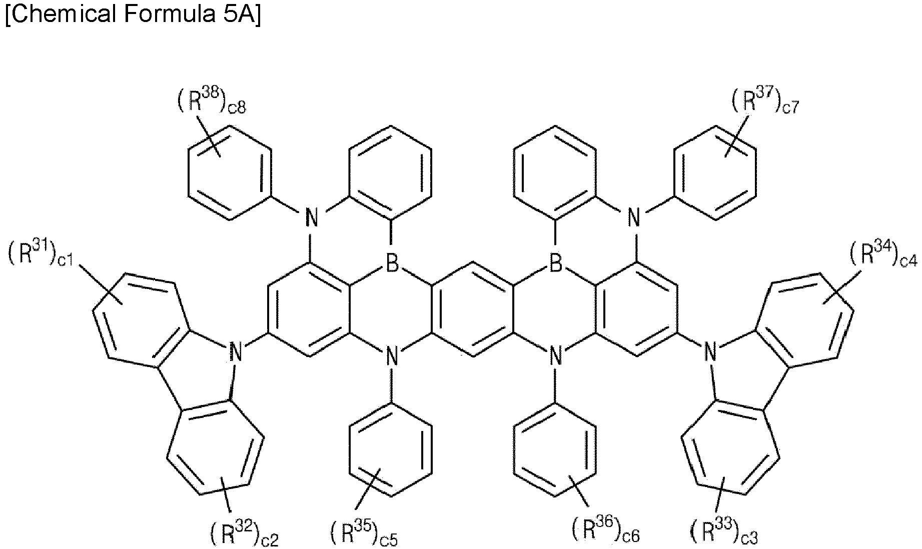 wherein, in the Chemical Formula 5A,
each of R³¹, R³², R³³, R³⁴, R³⁵, R³⁶, R³⁷ and R³⁸ is independently an unsubstituted or substituted C₁-C₂₀ alkyl group or an unsubstituted or substituted C₆-C₃₀ aryl group, where each R³¹ is identical to or different from each other when c1 is 2, 3 or 4, where each R³² is identical to or different from each other when c2 is 2, 3 or 4, where each R³³ is identical to or different from each other when c3 is 2, 3 or 4, where each R³⁴ is identical to or different from each other when c4 is 2, 3 or 4, where each R³⁵ is identical to or different from each other when c5 is 2, 3, 4 or 5, where each R³⁶ is identical to or different from each other when c6 is 2, 3, 4 or 5, where each R³⁷ is identical to or different from each other when c7 is 2, 3, 4 or 5, and where each R³⁸ is identical to or different from each other when c8 is 2, 3, 4 or 5;
each of c1, c2, c3 and c4 is independently 0, 1, 2, 3 or 4; and
each of c5, c6, c7 and c8 is independently 0, 1, 2, 3, 4 or 5.

### [Embodiment 9x]

The organic light emitting device of any one of embodiments 1x to 8x, wherein the second blue fluorescent compound is at least one of the following compounds:

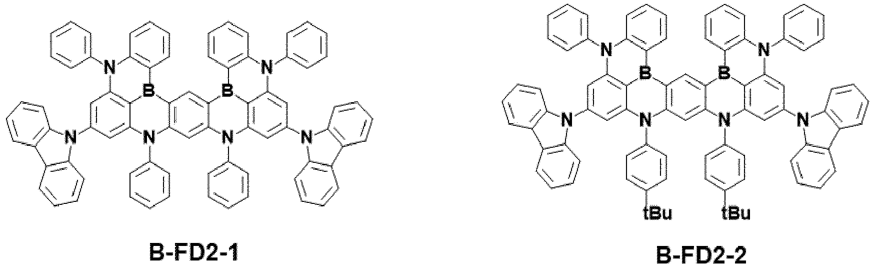

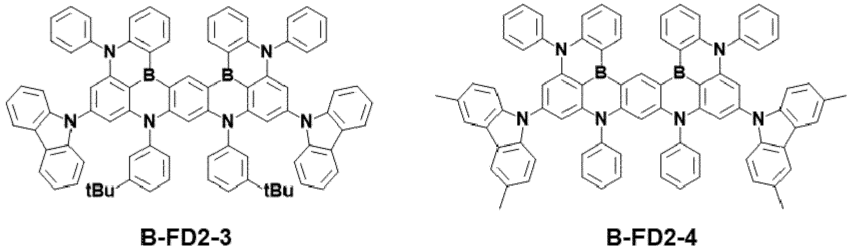

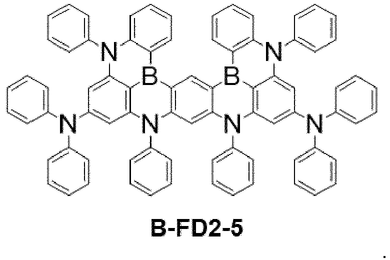

### [Embodiment 10x]

The organic light emitting device of any one of embodiments 1x to 9x, wherein the blue phosphorescent compound includes an organometallic compound having the following structure of Chemical Formula 7: 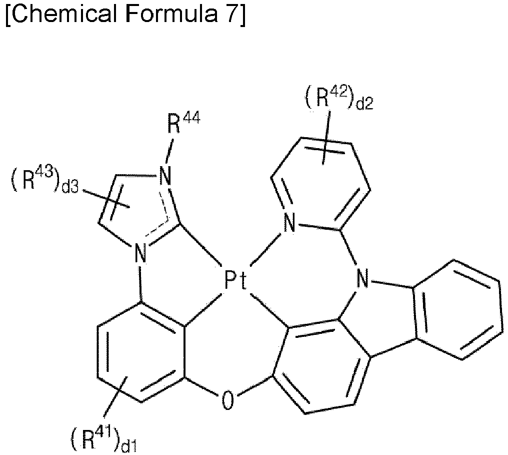 wherein, in the Chemical Formula 7,
each of R⁴¹, R⁴² and R⁴³ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁴¹ is identical to or different from each other when d1 is 2 or 3, where each R⁴² is identical to or different from each other when d2 is 2, 3 or 4, and where each R⁴³ is identical to or different from each other when d3 is 2;
R⁴⁴ is hydrogen, an unsubstituted or substituted C₁-C₂₀ alkyl group, an unsubstituted or substituted C₆-C₃₀ aryl group or an unsubstituted or substituted C₃-C₃₀ hetero aryl group;
d1 is 0, 1, 2 or 3;
d2 is 0, 1, 2, 3 or 4; and
d3 is 0, 1 or 2.

### [Embodiment 11x]

The organic light emitting device of any one of embodiments 1x to 10x, wherein the blue phosphorescent compound is at least one of the following organometallic compounds:

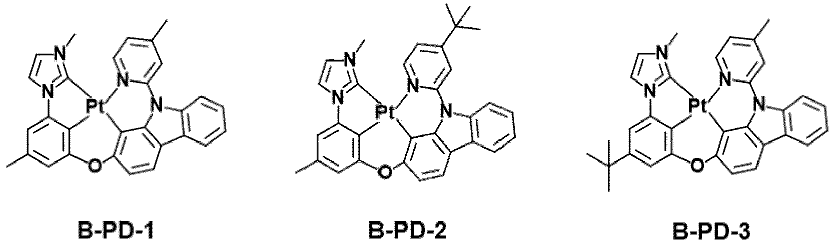

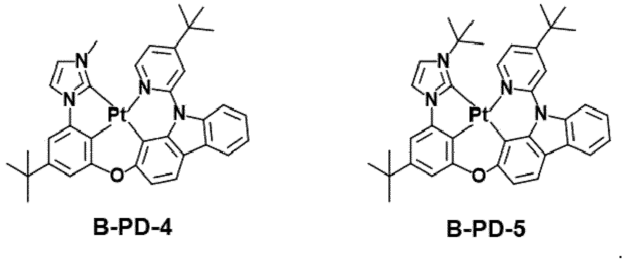

### [Embodiment 12x]

The organic light emitting device of any one of embodiments 1x to 11x, wherein the second blue emitting material layer further includes at least one of a second blue host having the following structure of Chemical Formula 3 and a third blue host having the following structure of Chemical Formula 9: 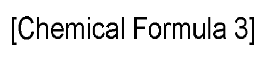 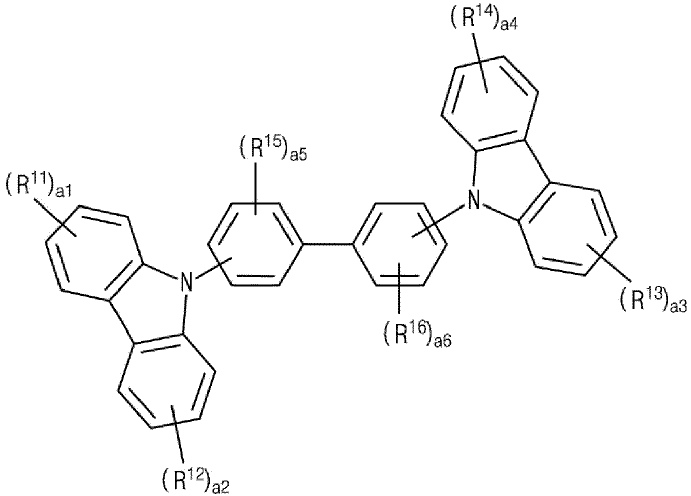 wherein, in the Chemical Formula 3,
each of R¹¹, R¹², R¹³, R¹⁴, R¹⁵ and R¹⁶ is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹ is identical to or different from each other when a1 is 2, 3 or 4, where each R¹² is identical to or different from each other when a2 is 2, 3 or 4, where each R¹³ is identical to or different from each other when a3 is 2, 3 or 4, where each R¹⁴ is identical to or different from each other when a4 is 2, 3 or 4, where each R¹⁵ is identical to or different from each other when a5 is 2, 3 or 4, and where each R¹⁶ is identical to or different from each other when a6 is 2, 3 or 4; and
each of a1, a2, a3, a4, a5 and a6 is independently 0, 1, 2, 3 or 4, 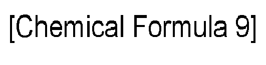 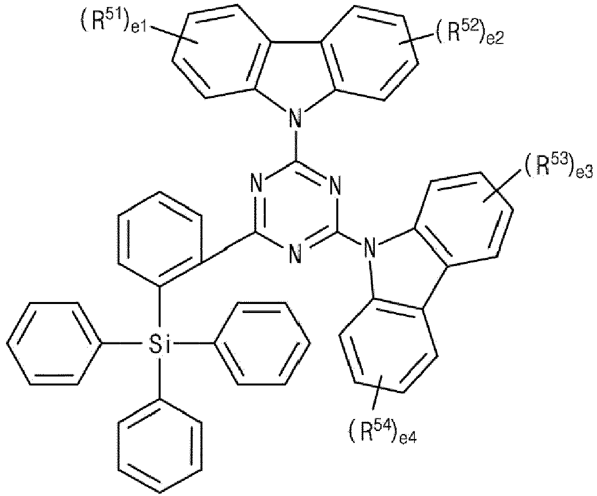 wherein, in the Chemical Formula 9,
   each of R⁵¹, R⁵², R⁵³ and R⁵⁴ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁵¹ is identical to or different from each other when e1 is 2, 3 or 4, where each R⁵² is identical to or different from each other when e2 is 2, 3 or 4, where each R⁵³ is identical to or different from each other when e3 is 2, 3 or 4, and where each R⁵⁴ is identical to or different from each other when e4 is 2, 3 or 4; and
   each of e1, e2, e3 and e4 is independently 0, 1, 2, 3 or 4.

### [Embodiment 13x]

The organic light emitting device of embodiment 12x, wherein the third blue host is at least one of the following compounds:

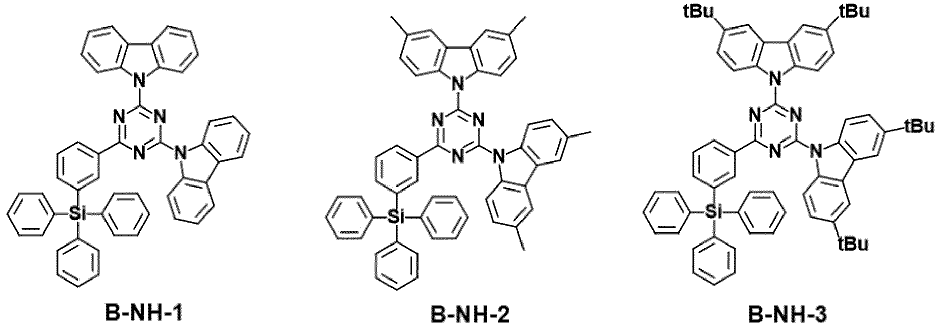

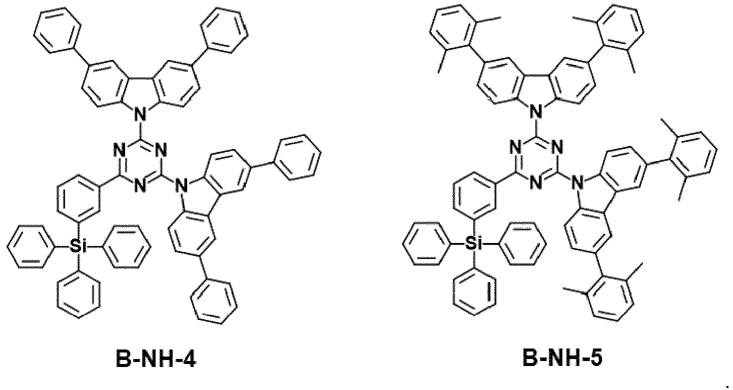

### [Embodiment 14x]

The organic light emitting device of any one of embodiments 1x to 13x, wherein each of the first green delayed fluorescent compound and the second green delayed fluorescent compound independently includes an organic compound having the following structure of Chemical Formula 11: 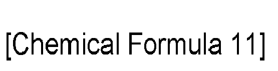 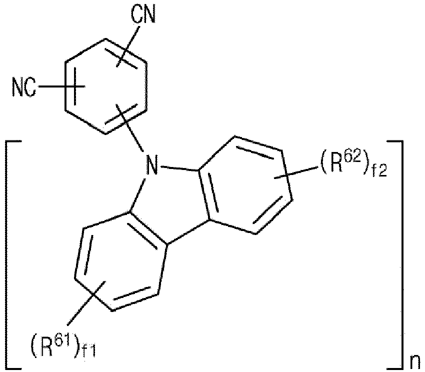 wherein, in the Chemical Formula 11,
each of R⁶¹ and R⁶² is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁶¹ is identical to or different from each other when f1 is 2, 3 or 4, and where each R⁶² is identical to or different from each other when f2 is 2, 3 or 4;
each of f1 and f2 is independently 0, 1, 2, or 4; and
n is 1, 2, 3 or 4.

### [Embodiment 15x]

The organic light emitting device of any one of embodiments 1x to 14x, each of the first green delayed fluorescent compound and the second green delayed fluorescent compound is independently at least one of the following compounds, respectively:

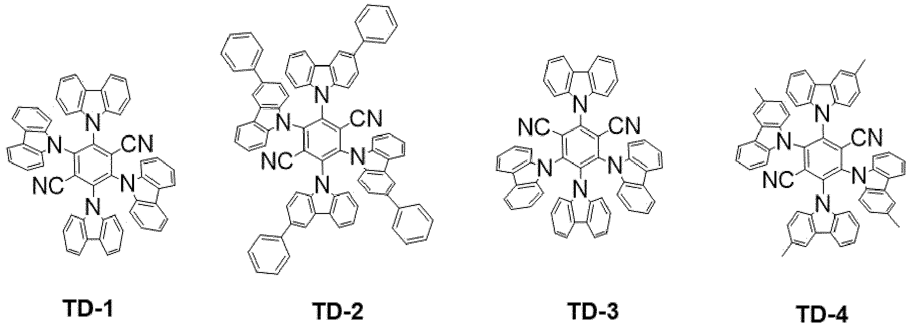

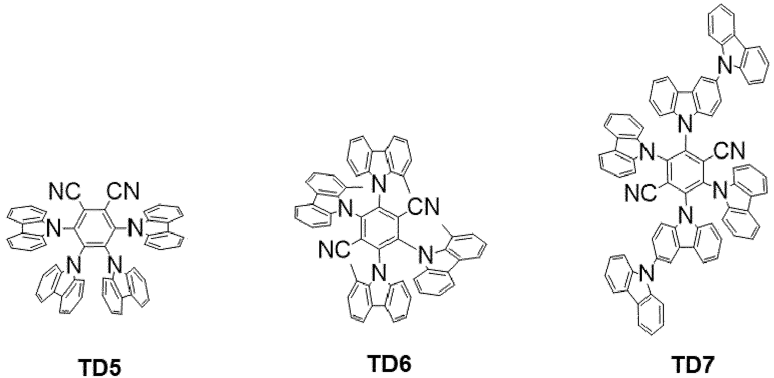

### [Embodiment 16x]

The organic light emitting device of any one of embodiments 1x to 15x, wherein the first green emitting material layer further includes a first green fluorescent compound and the second green emitting material layer further includes a second green fluorescent compound.

### [Embodiment 17x]

The organic light emitting device of embodiment 16x, wherein each of the first green fluorescent compound and the second green fluorescent compound independently includes an organic compound having the following structure of Chemical Formula 13A or Chemical Formula 13B: 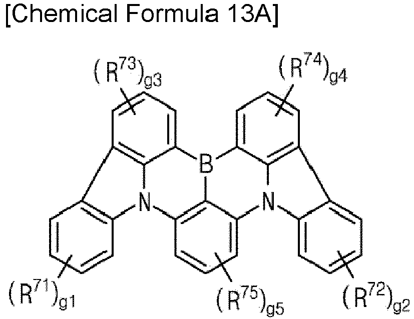 wherein, in the Chemical Formula 13A,
each of R⁷¹, R⁷², R⁷³ and R⁷⁴ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁷¹ is identical to or different from each other when g1 is 2, 3 or 4, where each R⁷² is identical to or different from each other when g2 is 2, 3 or 4, where each R⁷³ is identical to or different from each other when g3 is 2 or 3, where each R⁷⁴ is identical to or different from each other when g4 is 2 or 3;
R⁷⁵ is an unsubstituted or substituted C₃-C₃₀ hetero aryl group, or
optionally, two adjacent R⁷⁵ when g5 is 2 or 3 can be further linked to form an unsubstituted or substituted C₆-C₃₀ aryl ring or an unsubstituted or substituted C₃-C₂₀ hetero aryl ring;
each of g1 and g2 is independently 0, 1, 2, 3 or 4; and
each of g3, g4 and g5 is independently 0, 1, 2 or 3, 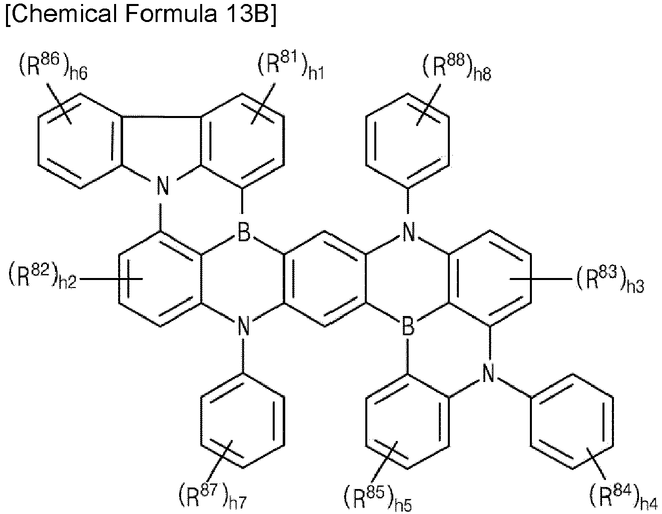 wherein, in the Chemical Formula 13B,
   each of R⁸¹, R⁸², R⁸³, R⁸⁴, R⁸⁵, R⁸⁶, R⁸⁷ and R⁸⁸ is independently an unsubstituted or substituted C₁-C₂₀ alkyl group, an unsubstituted or substituted C₆-C₃₀ aryl group or an unsubstituted or substituted C₃-C₃₀ hetero aryl group, or optionally, R⁸⁴ is fused to a ring including R⁸³ or a ring including R⁸⁵ to form a 5-membering ring or a 6-membering ring including a nitrogen atom, where each R⁸¹ is identical to or different from each other when h1 is 2 or 3, where each R⁸² is identical to or different from each other when h2 is 2 or 3, where each R⁸³ is identical to or different from each other when h3 is 2 or 3, where each R⁸⁴ is identical to or different from each other when h4 is 2, 3, 4 or 5, where each R⁸⁵ is identical to or different from each other when h5 is 2, 3 or 4, where each R⁸⁶ is identical to or different from each other when h6 is 2, 3 or 4, where each R⁸⁷ is identical to or different from each other when h7 is 2, 3, 4 or 5, and where each R⁸⁸ is identical to or different from each other when h8 is 2, 3, 4 or 5;
   each of h1, h2 and h3 is independently 0, 1, 2 or 3;
   each of h5 and h6 is independently 0, 1, 2, 3 or 4; and
   each of h4, h7 and h8 is independently 0, 1, 2, 3, 4 or 5.

### [Embodiment 18x]

The organic light emitting device of embodiment 16x or 17x, wherein each of the first green fluorescent compound and the second green fluorescent compound is independently at least one of the following compounds:

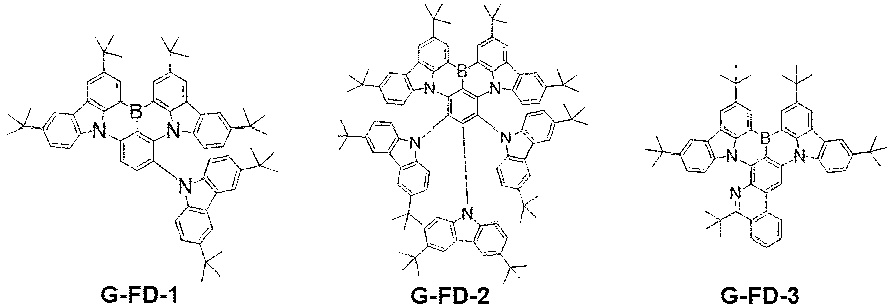

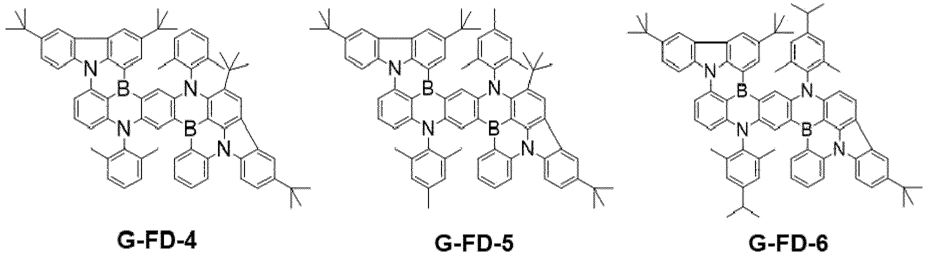

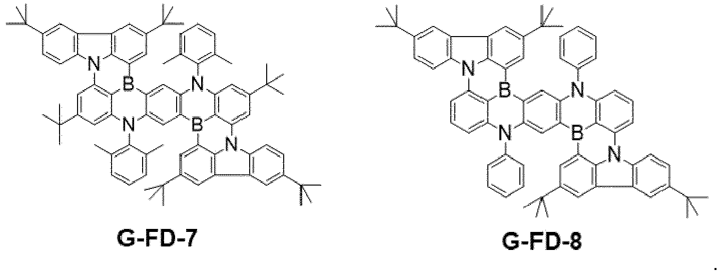

### [Embodiment 19x]

The organic light emitting device of any one of embodiments 16x to 18x, wherein the first green emitting material layer further includes a first green host and the second green emitting material layer further includes a second green host.

### [Embodiment 20x]

The organic light emitting diode of embodiment 19x, wherein each of the first green host and the second green host independently includes an organic compound having the following structure of Chemical Formula 15: 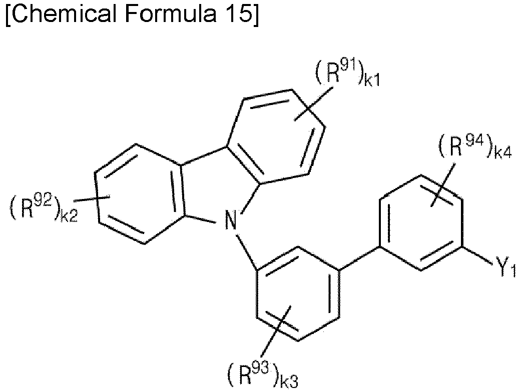 wherein, in the Chemical Formula 15,
each of R⁹¹ and R⁹² is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁹¹ is identical to or different from each other when k1 is 2, 3 or 4, and where each R⁹² is identical to or different from each other when k2 is 2, 3 or 4;
each of R⁹³ and R⁹⁴ is independently an unsubstituted or substituted C₁-C₂₀ alkyl group, an unsubstituted or substituted C₆-C₃₀ aryl group or an unsubstituted or substituted C₃-C₃₀ hetero aryl group, or optionally, R⁹³ and R⁹⁴ can be further linked to form an unsubstituted or substituted hetero ring, where each R⁹³ is identical to or different from each other when k3 is 2, 3 or 4, and where each R⁹⁴ is identical to or different from each other when k4 is 2, 3 or 4;
Y' has the following structure of Chemical Formula 15A or Chemical Formula 15B;
each of k1, k2, k3 and k4 is independently 0, 1, 2, 3 or 4, 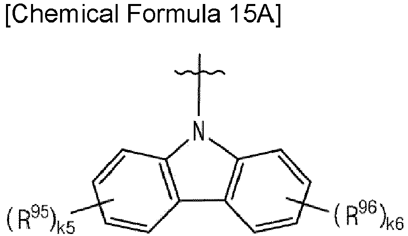 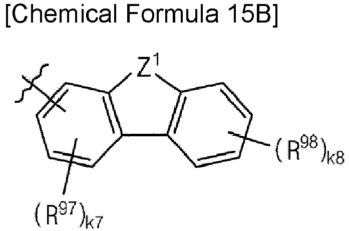 wherein, in Chemical Formulae 15A and 15B,
   each of R⁹⁵, R⁹⁶, R⁹⁷ and R⁹⁸ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁹⁵ is identical to or different from each other when k5 is 2, 3 or 4, where each R⁹⁶ is identical to or different from each other when k6 is 2, 3 or 4, where each R⁹⁷ is identical to or different from each other when k7 is 2 or 3, and where each R⁹⁸ is identical to or different from each other when k8 is 2, 3 or 4;
   each of k5, k6 and k8 is independently 0, 1, 2, 3 or 4;
   k7 is 0, 1, 2 or 3;
   Z¹ is NR⁹⁹, O or S, where R⁹⁹ is hydrogen, an unsubstituted or substituted C₁-C₂₀ alkyl group, an unsubstituted or substituted C₆-C₃₀ aryl group or an unsubstituted or substituted C₃-C₃₀ hetero aryl group.

### [Embodiment 21x]

The organic light emitting device of embodiment 19x or 20x, wherein each of the first host and the second host is independently at least one of the following compounds:

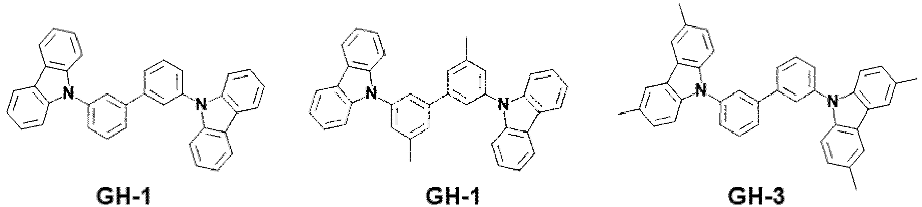

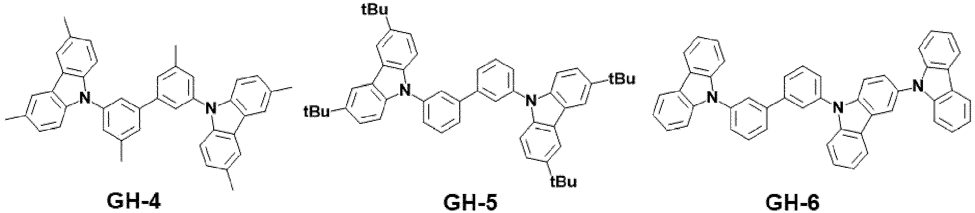

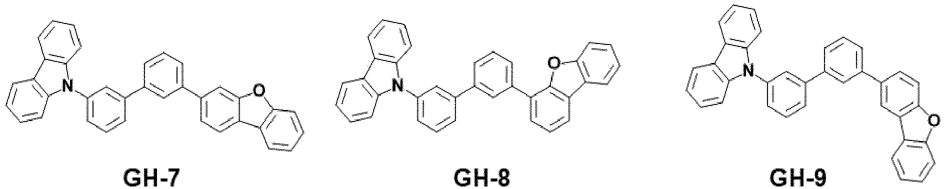

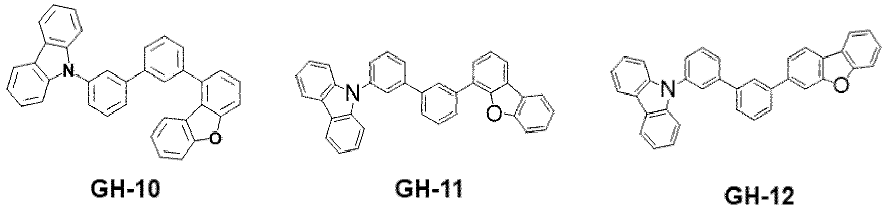

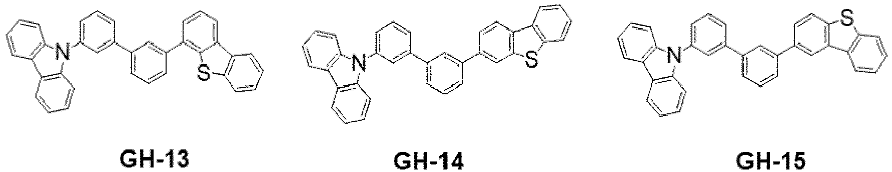

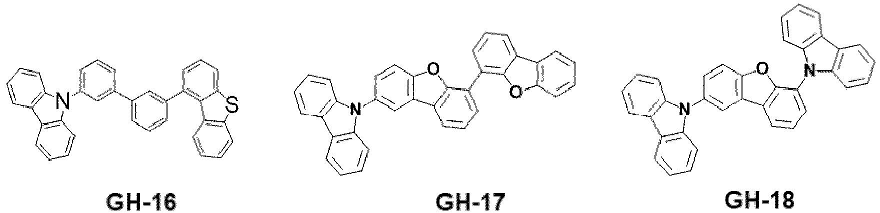

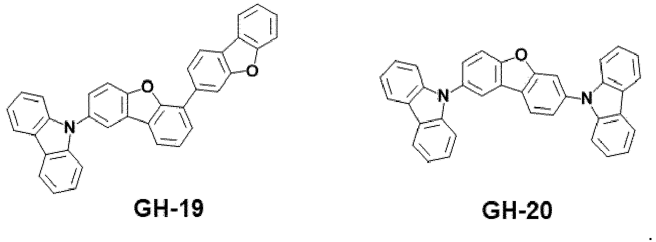

### [Embodiment 22x]

The organic light emitting device of any one of embodiments 1x to 21x, wherein the emissive layer of the organic light emitting diode disposed in the third pixel region includes a first red emitting material layer including a red delayed fluorescent compound and a red fluorescent compound, and a second red emitting material layer disposed between the first red emitting material layer and the transmissive electrode and including a red phosphorescent compound.

### [Embodiment 23x]

The organic light emitting device of embodiment 22x, wherein the red delayed fluorescent compound has the following structure of Chemical Formula 11: 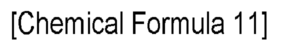 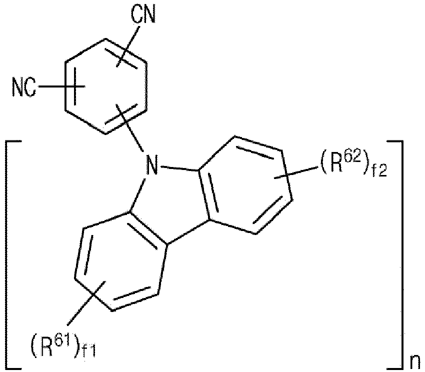 wherein, in the Chemical Formula 11,
each of R⁶¹ and R⁶² is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁶¹ is identical to or different from each other when f1 is 2, 3 or 4, and where each R⁶² is identical to or different from each other when f2 is 2, 3 or 4;
each of f1 and f2 is independently 0, 1, 2, or 4; and
n is 1, 2, 3 or 4.

### [Embodiment 24x]

The organic light emitting device of embodiment 22x or 23x, wherein the red fluorescent compound has the following structure of Chemical Formula 17: 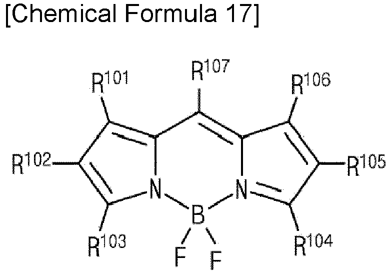 wherein, in the Chemical Formula 17,
each of R¹⁰¹, R¹⁰², R¹⁰³, R¹⁰⁴, R¹⁰⁵ and R¹⁰⁶ is independently hydrogen, an unsubstituted or substituted C₁-C₂₀ alkyl group, an unsubstituted or substituted C₆-C₃₀ aryl group or an unsubstituted or substituted C₃-C₃₀ hetero aryl group; and
R¹⁰⁷ is an unsubstituted or substituted C₆-C₃₀ aryl group or an unsubstituted or substituted C₃-C₃₀ hetero aryl group.

### [Embodiment 25x]

The organic light emitting device of any one of embodiments 22x to 24x, wherein the red fluorescent compound is at least one of the following compounds:

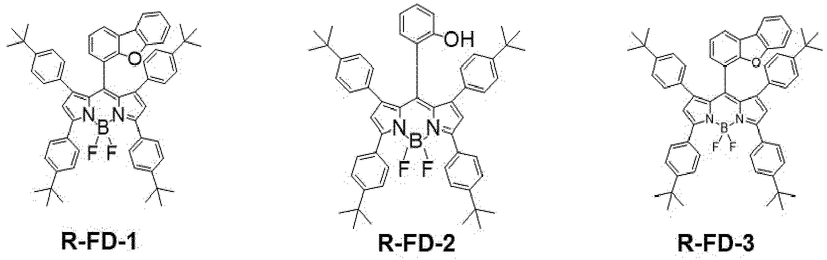

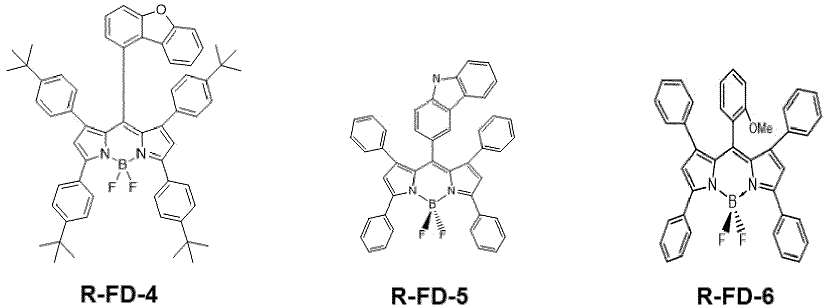

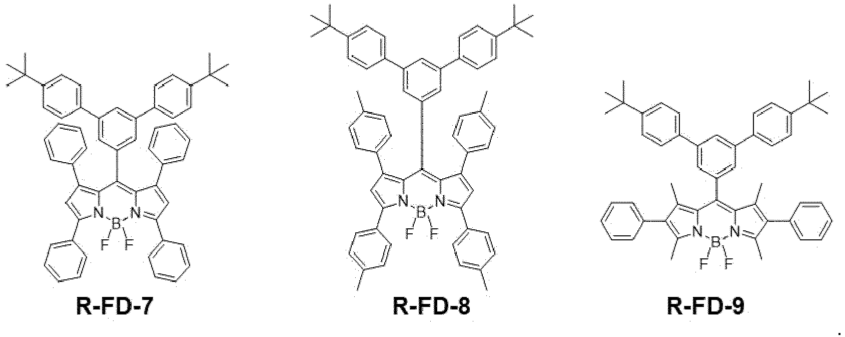

### [Embodiment 26x]

The organic light emitting device of any one of embodiments 22x to 25x, wherein the first red emitting material layer further includes a first red host and the second red emitting material layer further includes a second red host.

### [Embodiment 27x]

The organic light emitting device of embodiment 26x, wherein each of the first red host and the second red host independently includes an organic compound having the following structured of Chemical Formula 19: 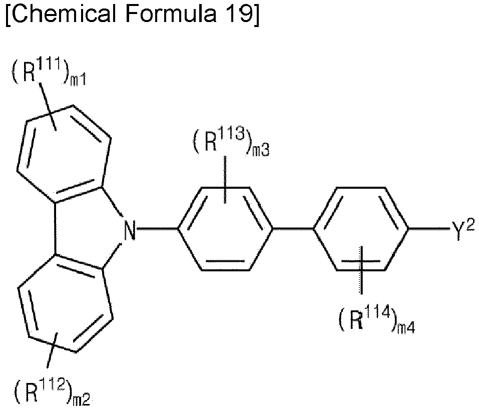 wherein, in the Chemical Formula 19,
each of R¹¹¹ and R¹¹² is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹¹ is identical to or different from each other when m1 is 2, 3 or 4, and where each R¹¹² is identical to or different from each other when m2 is 2, 3 or 4;
each of R¹¹³ and R¹¹⁴ is independently an unsubstituted or substituted C₁-C₂₀ alkyl group, an unsubstituted or substituted C₆-C₃₀ aryl group or an unsubstituted or substituted C₃-C₃₀ hetero aryl group, or optionally, R¹¹³ and R¹¹⁴ can be further linked to form an unsubstituted or substituted hetero ring, where each R¹¹³ is identical to or different from each other when m3 is 2, 3 or 4, and where each R¹¹⁴ is identical to or different from each other when m4 is 2, 3 or 4;
Y² has the following structure of Chemical Formula 19A or Chemical Formula 19B;
each of m1, m2, m3 and m4 is independently 0, 1, 2, 3 or 4, 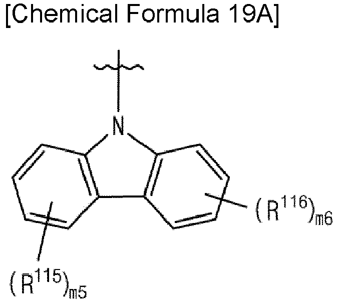 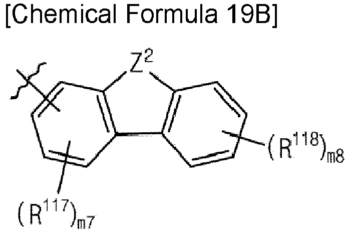 wherein, in Chemical Formulae 19A and 19B,
   each of R¹¹⁵, R¹¹⁶, R¹¹⁷ and R¹¹⁸ is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹⁵ is identical to or different from each other when m5 is 2, 3 or 4, where each R¹¹⁶ is identical to or different from each other when m6 is 2, 3 or 4, where each R¹¹⁷ is identical to or different from each other when m7 is 2 or 3, and where each R¹¹⁸ is identical to or different from each other when m8 is 2, 3 or 4;
   each of m5, m6 and m8 is independently 0, 1, 2, 3 or 4;
   m7 is 0, 1, 2 or 3;
   Z² is NR¹¹⁹, O or S, where R¹¹⁹ is hydrogen, an unsubstituted or substituted C₁-C₂₀ alkyl group, an unsubstituted or substituted C₆-C₃₀ aryl group or an unsubstituted or substituted C₃-C₃₀ hetero aryl group.

### [Embodiment 28x]

The organic light emitting device of embodiments 26x or 27x, wherein each of the first red host and the second red host is independently at least one of the following compounds:

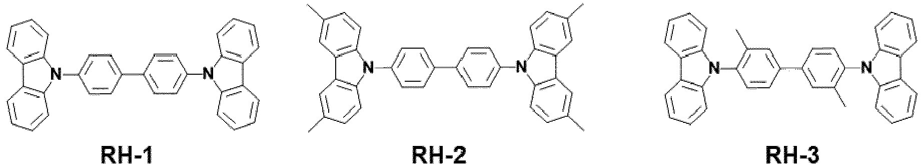

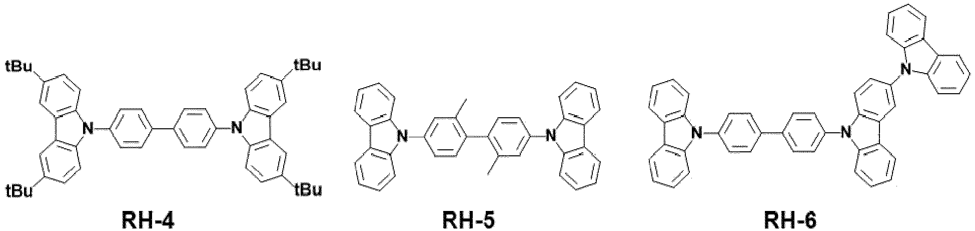

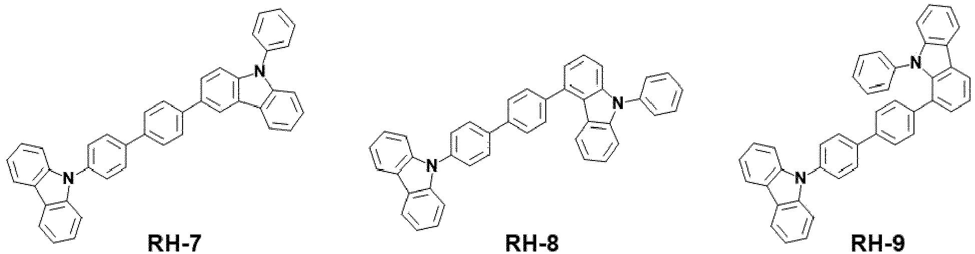

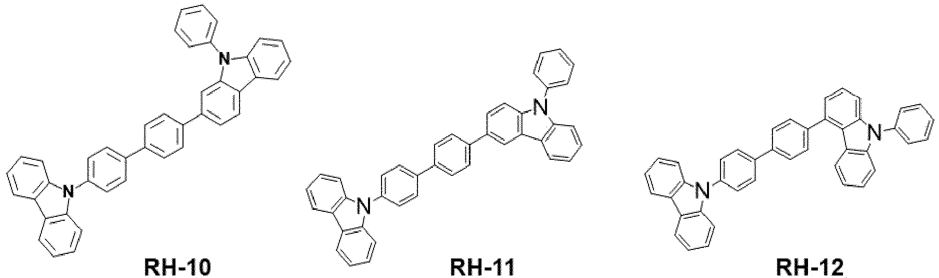

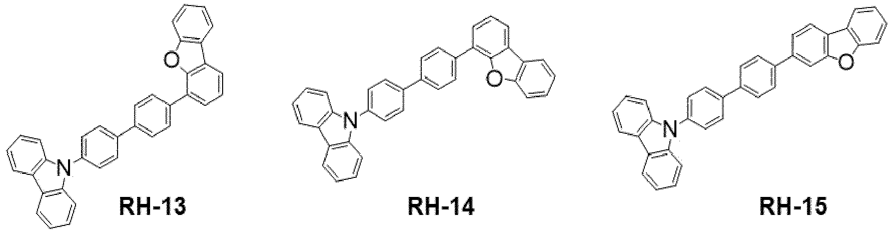

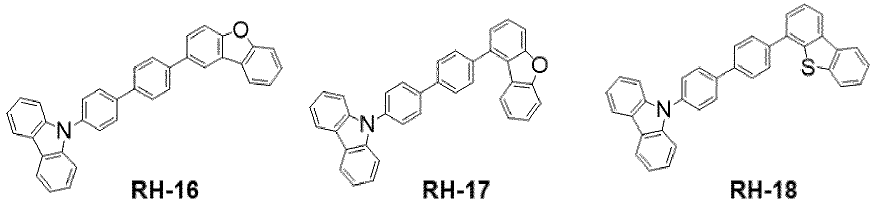

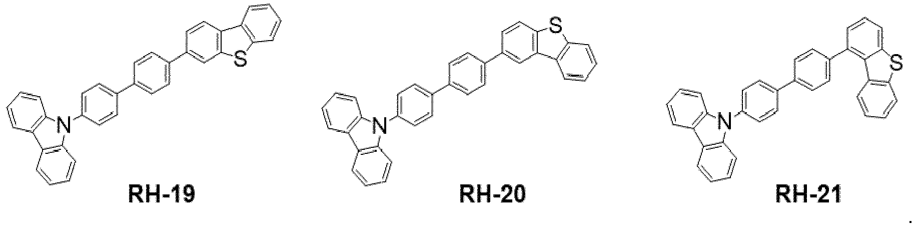

### [Embodiment 29x]

The organic light emitting device of any one of embodiments 22x to 28x, wherein the red phosphorescent compound is at least one of the following organometallic compounds:

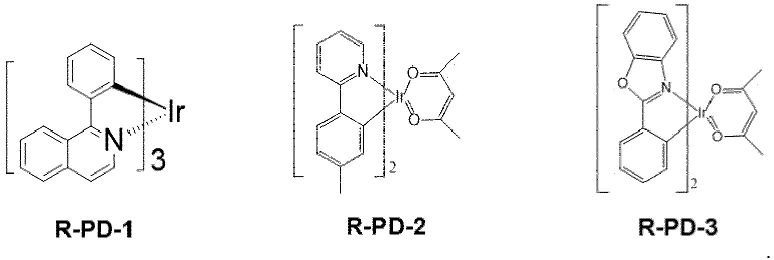

### [Embodiment 30x]

The organic light emitting device of any one of embodiments 1x to 29x, wherein each of the first blue emitting material layer and the second blue emitting material layer and each of the first green emitting material layer and the second green emitting material layer are located within a single emitting part, respectively.

### [Embodiment 31x]

The organic light emitting device of any one of embodiments 1x to 30x, wherein the emissive layer of the organic light emitting diode disposed in the first pixel region includes a first blue emitting part including the first blue emitting material layer, a second blue emitting part including the second blue emitting material layer and a charge generation layer disposed between the first blue emitting part and the second blue emitting part, and
wherein the emissive layer of the organic light emitting diode disposed in the second pixel region includes a first green emitting part including the first green emitting material layer, a second green emitting part including the second green emitting material layer and a charge generation layer disposed between the first green emitting part and the second green emitting part.

### [Embodiment 32x]

An organic light emitting diode, including:
a reflective electrode;
a transmissive electrode facing the reflective electrode; and
an emissive layer disposed between the reflective electrode and the transmissive electrode,
wherein the emissive layer includes:
   a first emitting part including a first blue emitting material layer;
   a second emitting part disposed between the first emitting part and the transmissive electrode, the second emitting part including a green emitting material layer;
   a third emitting part disposed between the second emitting part and the transmissive electrode, the third emitting part including a second blue emitting material layer;
   a first charge generation layer disposed between the first emitting part and the second emitting part; and
   a second charge generation layer disposed between the second emitting part and the third emitting part,
wherein the first blue emitting material layer includes a first blue fluorescent compound,
wherein the second blue emitting material layer includes a second blue fluorescent compound and a blue phosphorescent compound, and
wherein the green emitting material layer includes a first green emitting material layer including a first green delayed fluorescent compound, and a second green emitting material layer disposed between the first green emitting material layer and the second charge generation layer and including a second green delayed fluorescent compound.

### [Embodiment 33x]

The organic light emitting diode of embodiment 32x, wherein the first blue compound includes an organic compound having the following structure of Chemical Formula 1: 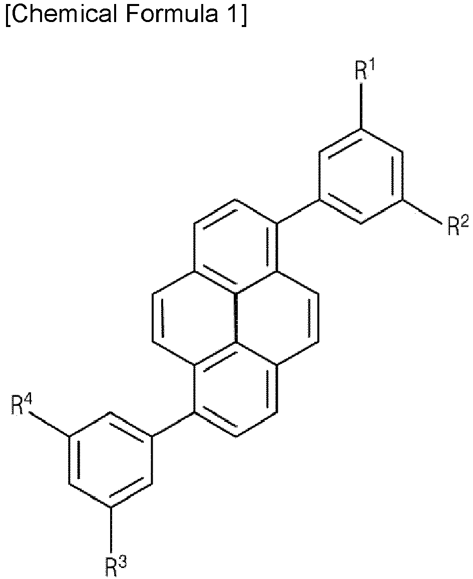 wherein, in the Chemical Formula 1,
each of R¹, R², R³ and R⁴ is independently hydrogen, an unsubstituted or substituted C₁-C₂₀ alkyl group, an unsubstituted or substituted C₆-C₃₀ aryl group or an unsubstituted or substituted C₆-C₃₀ aryl amino group.

### [Embodiment 34x]

The organic light emitting diode of embodiment 32x or 33x, wherein the first blue emitting material layer further includes a first blue host having the following structure of Chemical Formula 3: 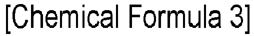 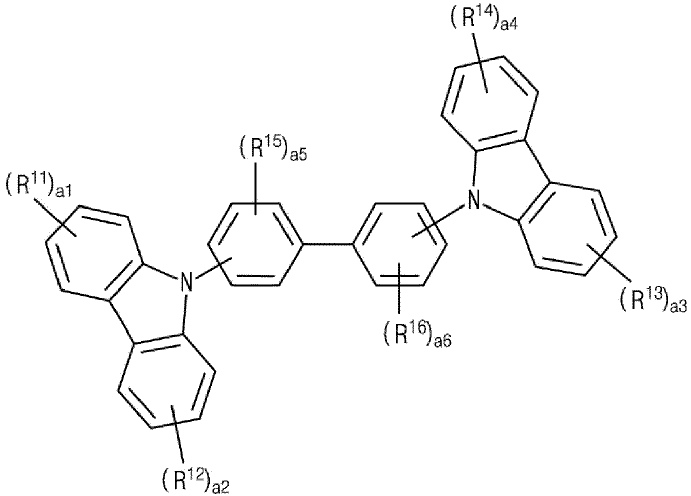 wherein, in the Chemical Formula 3,
each of R¹¹, R¹², R¹³, R¹⁴, R¹⁵ and R¹⁶ is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹ is identical to or different from each other when a1 is 2, 3 or 4, where each R¹² is identical to or different from each other when a2 is 2, 3 or 4, where each R¹³ is identical to or different from each other when a3 is 2, 3 or 4, where each R¹⁴ is identical to or different from each other when a4 is 2, 3 or 4, where each R¹⁵ is identical to or different from each other when a5 is 2, 3 or 4, and where each R¹⁶ is identical to or different from each other when a6 is 2, 3 or 4; and
each of a1, a2, a3, a4, a5 and a6 is independently 0, 1, 2, 3 or 4.

### [Embodiment 35x]

The organic light emitting diode of embodiment 34x, wherein first blue host has the following structure of Chemical Formula 3A or Chemical Formula 3B: 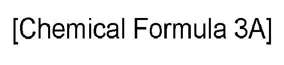 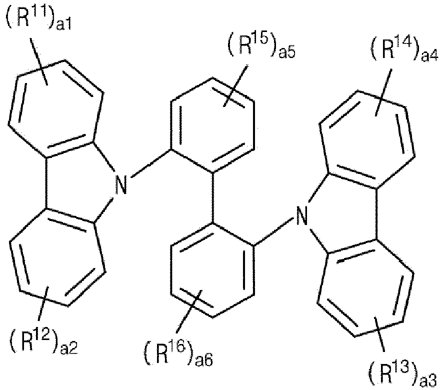 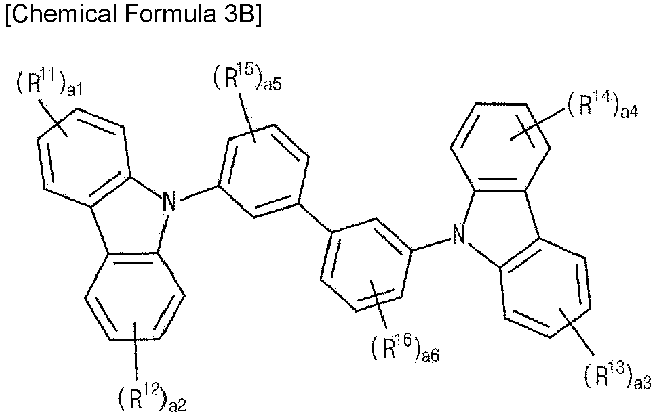 wherein, in the Chemical Formulae 3A and 3B,
each of R¹¹, R¹², R¹³, R¹⁴, R¹⁵ and R¹⁶, and a1, a2, a3, a4, a5 and a6 is a same as defined in Chemical Formula 3.

### [Embodiment 36x]

The organic light emitting diode of any one of embodiments 32x to 35x, wherein the second blue fluorescent compound includes an organic compound having the following structure of Chemical Formula 5: 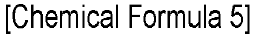 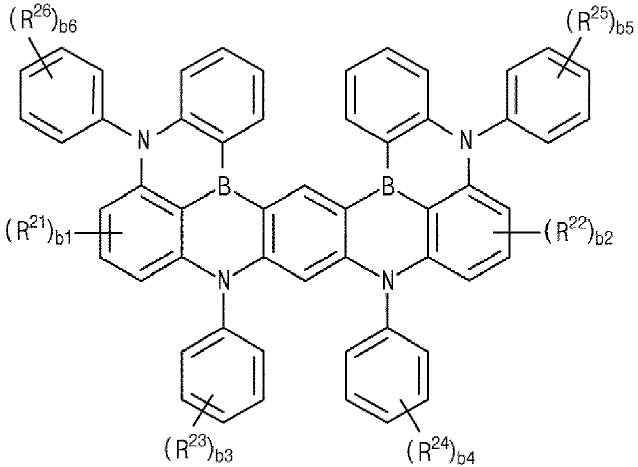 wherein, in the Chemical Formula 5,
each of R²¹ and R²² is independently an unsubstituted or substituted C₆-C₃₀ aryl group, an unsubstituted or substituted C₃-C₃₀ hetero aryl group or an unsubstituted or substituted C₆-C₃₀ aryl amino group, where each R²¹ is identical to or different from each other when b1 is 2 or 3, and where each R²² is identical to or different from each other when b2 is 2 or 3;
each of R²³, R²⁴, R²⁵ and R²⁶ is independently an unsubstituted or substituted C₁-C₂₀ alkyl group or an unsubstituted or substituted C₆-C₃₀ aryl group, where each R²³ is identical to or different from each other when b3 is 2, 3, 4 or 5, where each R²⁴ is identical to or different from each other when b4 is 2, 3, 4 or 5, where each R²⁵ is identical to or different from each other when b5 is 2, 3, 4 or 5, and where each R²⁶ is identical to or different from each other when b6 is 2, 3, 4 or 5;
each of b1 and b2 is independently 0, 1, 2 or 3; and
each of b3, b4, b5 and b6 is independently 0, 1, 2, 3, 4 or 5.

### [Embodiment 37x]

The organic light emitting diode of any one of embodiments 32x to 36x, wherein the second blue fluorescent compound includes an organic compound having the following structure of Chemical Formula 5A: 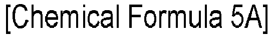 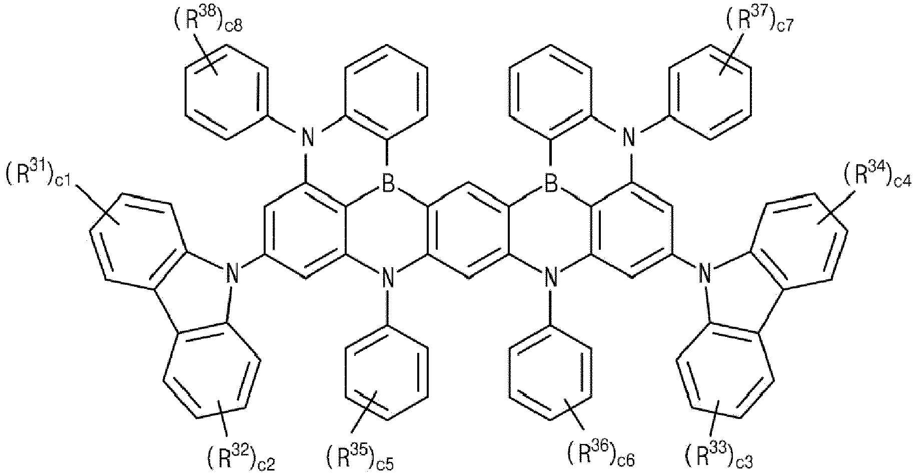 wherein, in the Chemical Formula 5A,
each of R³¹, R³², R³³, R³⁴, R³⁵, R³⁶, R³⁷ and R³⁸ is independently an unsubstituted or substituted C₁-C₂₀ alkyl group or an unsubstituted or substituted C₆-C₃₀ aryl group, where each R³¹ is identical to or different from each other when c1 is 2, 3 or 4, where each R³² is identical to or different from each other when c2 is 2, 3 or 4, where each R³³ is identical to or different from each other when c3 is 2, 3 or 4, where each R³⁴ is identical to or different from each other when c4 is 2, 3 or 4, where each R³⁵ is identical to or different from each other when c5 is 2, 3, 4 or 5, where each R³⁶ is identical to or different from each other when c6 is 2, 3, 4 or 5, where each R³⁷ is identical to or different from each other when c7 is 2, 3, 4 or 5, and where each R³⁸ is identical to or different from each other when c8 is 2, 3, 4 or 5;
each of c1, c2, c3 and c4 is independently 0, 1, 2, 3 or 4; and
each of c5, c6, c7 and c8 is independently 0, 1, 2, 3, 4 or 5.

### [Embodiment 38x]

The organic light emitting diode of any one of embodiments 32x to 37x, wherein the blue phosphorescent compound includes an organometallic compound having the following structure of Chemical Formula 7: 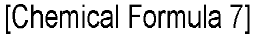 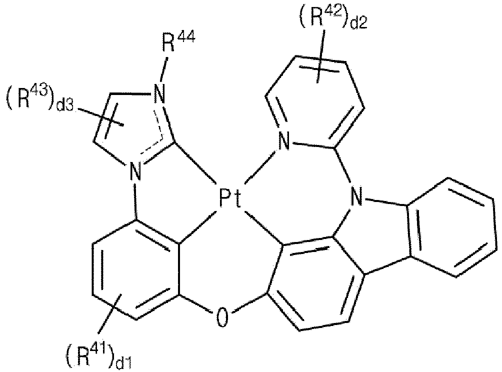 wherein, in the Chemical Formula 7,
each of R⁴¹, R⁴² and R⁴³ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁴¹ is identical to or different from each other when d1 is 2 or 3, where each R⁴² is identical to or different from each other when d2 is 2, 3 or 4, and where each R⁴³ is identical to or different from each other when d3 is 2;
R⁴⁴ is hydrogen, an unsubstituted or substituted C₁-C₂₀ alkyl group, an unsubstituted or substituted C₆-C₃₀ aryl group or an unsubstituted or substituted C₃-C₃₀ hetero aryl group;
d1 is 0, 1, 2 or 3;
d2 is 0, 1, 2, 3 or 4; and
d3 is 0, 1 or 2.

### [Embodiment 39x]

The organic light emitting diode of any one of embodiments 32x to 38x, wherein the second blue emitting material layer further includes at least one of a second blue host having the following structure of Chemical Formula 3 and a third blue host having the following structure of Chemical Formula 9: 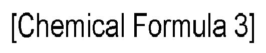 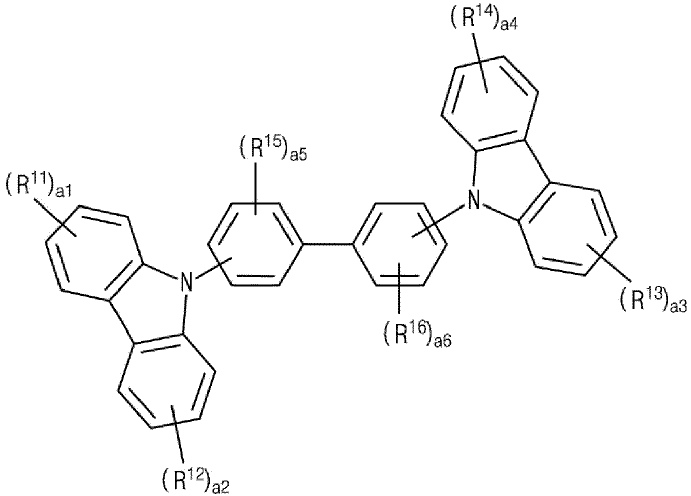 wherein, in the Chemical Formula 3,
each of R¹¹, R¹², R¹³, R¹⁴, R¹⁵ and R¹⁶ is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹ is identical to or different from each other when a1 is 2, 3 or 4, where each R¹² is identical to or different from each other when a2 is 2, 3 or 4, where each R¹³ is identical to or different from each other when a3 is 2, 3 or 4, where each R¹⁴ is identical to or different from each other when a4 is 2, 3 or 4, where each R¹⁵ is identical to or different from each other when a5 is 2, 3 or 4, and where each R¹⁶ is identical to or different from each other when a6 is 2, 3 or 4; and
each of a1, a2, a3, a4, a5 and a6 is independently 0, 1, 2, 3 or 4, 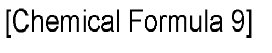 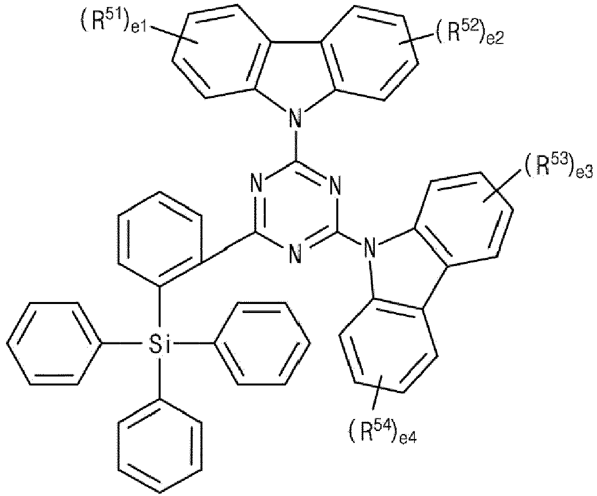 wherein, in the Chemical Formula 9,
   each of R⁵¹, R⁵², R⁵³ and R⁵⁴ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁵¹ is identical to or different from each other when e1 is 2, 3 or 4, where each R⁵² is identical to or different from each other when e2 is 2, 3 or 4, where each R⁵³ is identical to or different from each other when e3 is 2, 3 or 4, and where each R⁵⁴ is identical to or different from each other when e4 is 2, 3 or 4; and
   each of e1, e2, e3 and e4 is independently 0, 1, 2, 3 or 4.

### [Embodiment 40x]

The organic light emitting diode of any one of embodiments 32x to 39x, wherein each of the first green delayed fluorescent compound and the second green delayed fluorescent compound independently includes an organic compound having the following structure of Chemical Formula 11: 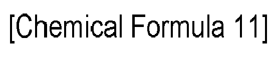 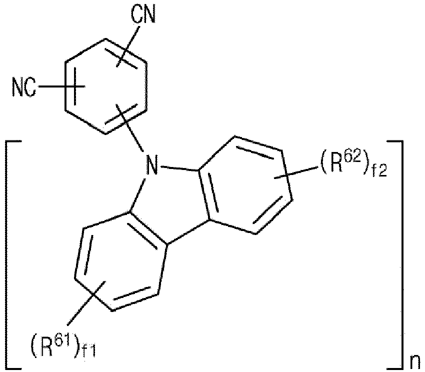 wherein, in the Chemical Formula 11,
each of R⁶¹ and R⁶² is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁶¹ is identical to or different from each other when f1 is 2, 3 or 4, and where each R⁶² is identical to or different from each other when f2 is 2, 3 or 4;
each of f1 and f2 is independently 0, 1, 2, or 4; and
n is 1, 2, 3 or 4.

### [Embodiment 41x]

The organic light emitting diode of any one of embodiments 32x to 40x, wherein the first green emitting material layer further includes a first green fluorescent compound and the second green emitting material layer further includes a second green fluorescent compound.

### [Embodiment 42x]

The organic light emitting diode of embodiment 41x, wherein each of the first green fluorescent compound and the second green fluorescent compound independently includes an organic compound having the following structure of Chemical Formula 13A or Chemical Formula 13B: 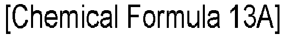 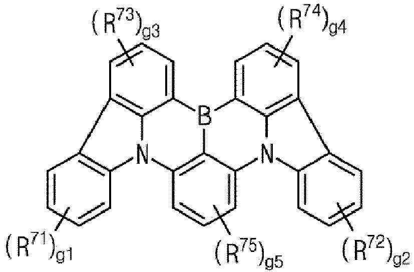 wherein, in the Chemical Formula 13A,
each of R⁷¹, R⁷², R⁷³ and R⁷⁴ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁷¹ is identical to or different from each other when g1 is 2, 3 or 4, where each R⁷² is identical to or different from each other when g2 is 2, 3 or 4, where each R⁷³ is identical to or different from each other when g3 is 2 or 3, where each R⁷⁴ is identical to or different from each other when g4 is 2 or 3;
R⁷⁵ is an unsubstituted or substituted C₃-C₃₀ hetero aryl group, or
optionally, two adjacent R⁷⁵ when g5 is 2 or 3 can be further linked to form an unsubstituted or substituted C₆-C₃₀ aryl ring or an unsubstituted or substituted C₃-C₂₀ hetero aryl ring;
each of g1 and g2 is independently 0, 1, 2, 3 or 4; and
each of g3, g4 and g5 is independently 0, 1, 2 or 3, 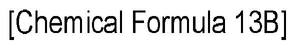 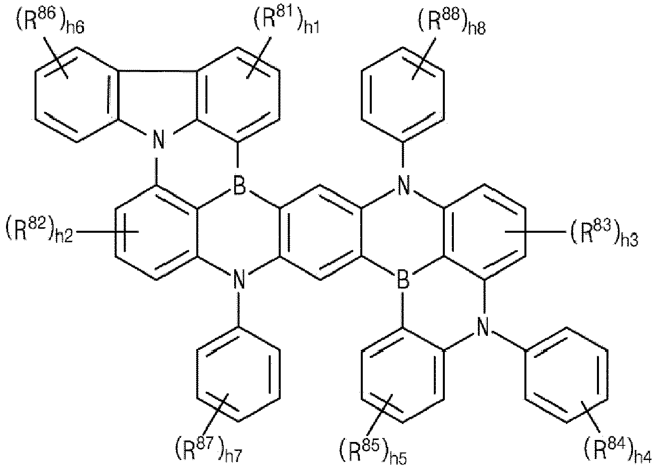 wherein, in the Chemical Formula 13B,
   each of R⁸¹, R⁸², R⁸³, R⁸⁴, R⁸⁵, R⁸⁶, R⁸⁷ and R⁸⁸ is independently an unsubstituted or substituted C₁-C₂₀ alkyl group, an unsubstituted or substituted C₆-C₃₀ aryl group or an unsubstituted or substituted C₃-C₃₀ hetero aryl group, or optionally, R⁸⁴ is fused to a ring including R⁸³ or a ring including R⁸⁵ to form a 5-membering ring or a 6-membering ring including a nitrogen atom, where each R⁸¹ is identical to or different from each other when h1 is 2 or 3, where each R⁸² is identical to or different from each other when h2 is 2 or 3, where each R⁸³ is identical to or different from each other when h3 is 2 or 3, where each R⁸⁴ is identical to or different from each other when h4 is 2, 3, 4 or 5, where each R⁸⁵ is identical to or different from each other when h5 is 2, 3 or 4, where each R⁸⁶ is identical to or different from each other when h6 is 2, 3 or 4, where each R⁸⁷ is identical to or different from each other when h7 is 2, 3, 4 or 5, and where each R⁸⁸ is identical to or different from each other when h8 is 2, 3, 4 or 5;
   each of h1, h2 and h3 is independently 0, 1, 2 or 3;
   each of h5 and h6 is independently 0, 1, 2, 3 or 4; and
   each of h4, h7 and h8 is independently 0, 1, 2, 3, 4 or 5.

### [Embodiment 43x]

The organic light emitting diode of embodiment 41x or 42x, wherein the first green emitting material layer further includes a first green host and the second green emitting material layer further includes a second green host.

### [Embodiment 44x]

The organic light emitting diode of embodiment 43x, wherein each of the first green host and the second green host independently includes an organic compound having the following structure of Chemical Formula 15: 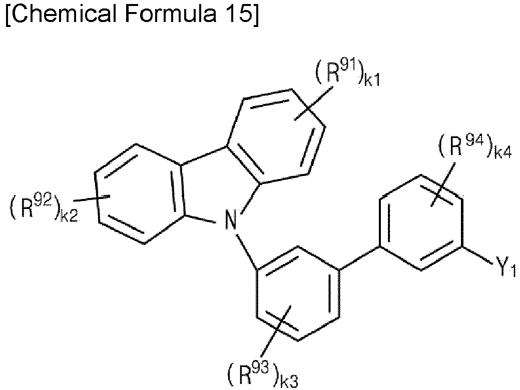 wherein, in the Chemical Formula 15,
each of R⁹¹ and R⁹² is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁹¹ is identical to or different from each other when k1 is 2, 3 or 4, and where each R⁹² is identical to or different from each other when k2 is 2, 3 or 4;
each of R⁹³ and R⁹⁴ is independently an unsubstituted or substituted C₁-C₂₀ alkyl group, an unsubstituted or substituted C₆-C₃₀ aryl group or an unsubstituted or substituted C₃-C₃₀ hetero aryl group, or optionally, R⁹³ and R⁹⁴ can be further linked to form an unsubstituted or substituted hetero ring, where each R⁹³ is identical to or different from each other when k3 is 2, 3 or 4, and where each R⁹⁴ is identical to or different from each other when k4 is 2, 3 or 4;
Y' has the following structure of Chemical Formula 15A or Chemical Formula 15B;
each of k1, k2, k3 and k4 is independently 0, 1, 2, 3 or 4, 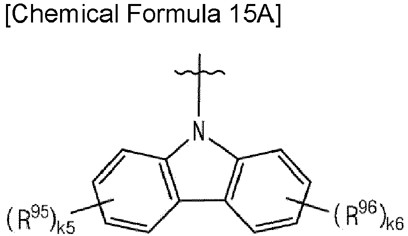 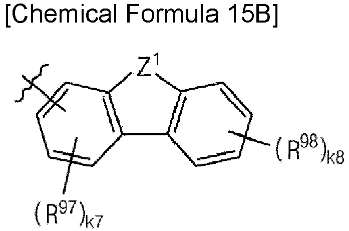 wherein, in Chemical Formulae 15A and 15B,
   each of R⁹⁵, R⁹⁶, R⁹⁷ and R⁹⁸ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁹⁵ is identical to or different from each other when k5 is 2, 3 or 4, where each R⁹⁶ is identical to or different from each other when k6 is 2, 3 or 4, where each R⁹⁷ is identical to or different from each other when k7 is 2 or 3, and where each R⁹⁸ is identical to or different from each other when k8 is 2, 3 or 4;
   each of k5, k6 and k8 is independently 0, 1, 2, 3 or 4;
   k7 is 0, 1, 2 or 3;
   Z¹ is NR⁹⁹, O or S, where R⁹⁹ is hydrogen, an unsubstituted or substituted C₁-C₂₀ alkyl group, an unsubstituted or substituted C₆-C₃₀ aryl group or an unsubstituted or substituted C₃-C₃₀ hetero aryl group.

### [Embodiment 45x]

The organic light emitting diode of any one of embodiments 32x to 44x, wherein the second emitting part further includes a red emitting material layer, wherein the red emitting material layer is disposed between the green emitting material layer and the first charge generation layer or disposed between the green emitting material layer and the second charge generation layer, and

wherein the red emitting material layer includes a first red emitting material layer including a red delayed fluorescent compound and a red fluorescent compound, and a second red emitting material layer disposed between the first red emitting material layer and the second charge generation layer and including a red phosphorescent compound.

### [Embodiment 46x]

The organic light emitting diode of embodiment 45x, wherein the red delayed fluorescent compound has the following structure of Chemical Formula 11: 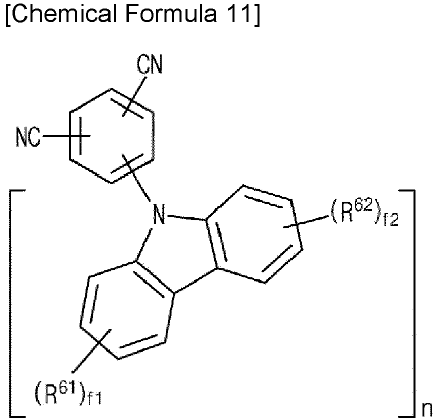 wherein, in the Chemical Formula 11,
each of R⁶¹ and R⁶² is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁶¹ is identical to or different from each other when f1 is 2, 3 or 4, and where each R⁶² is identical to or different from each other when f2 is 2, 3 or 4;
each of f1 and f2 is independently 0, 1, 2, or 4; and
n is 1, 2, 3 or 4.

### [Embodiment 47x]

The organic light emitting diode of embodiment 45x or 46x, wherein the red fluorescent compound has the following structure of Chemical Formula 17: 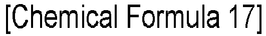 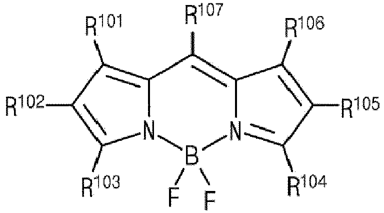 wherein, in the Chemical Formula 17,
each of R¹⁰¹, R¹⁰², R¹⁰³, R¹⁰⁴, R¹⁰⁵ and R¹⁰⁶ is independently hydrogen, an unsubstituted or substituted C₁-C₂₀ alkyl group, an unsubstituted or substituted C₆-C₃₀ aryl group or an unsubstituted or substituted C₃-C₃₀ hetero aryl group; and
R¹⁰⁷ is an unsubstituted or substituted C₆-C₃₀ aryl group or an unsubstituted or substituted C₃-C₃₀ hetero aryl group.

### [Embodiment 48x]

The organic light emitting diode of any one of embodiments 45x to 47x, wherein the first red emitting material layer further includes a first red host and the second red emitting material layer further includes a second red host.

### [Embodiment 49x]

The organic light emitting diode of embodiment 48x, wherein each of the first red host and the second red host independently includes an organic compound having the following structured of Chemical Formula 19: 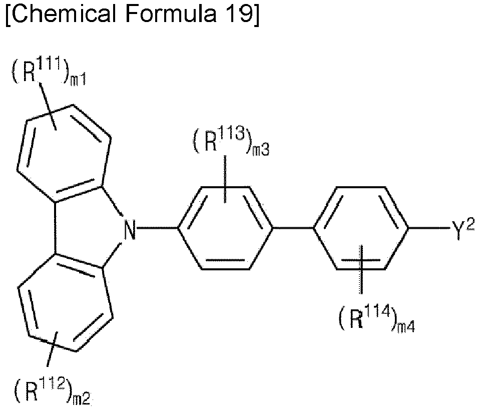 wherein, in the Chemical Formula 19,
each of R¹¹¹ and R¹¹² is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹¹ is identical to or different from each other when m1 is 2, 3 or 4, and where each R¹¹² is identical to or different from each other when m2 is 2, 3 or 4;
each of R¹¹³ and R¹¹⁴ is independently an unsubstituted or substituted C₁-C₂₀ alkyl group, an unsubstituted or substituted C₆-C₃₀ aryl group or an unsubstituted or substituted C₃-C₃₀ hetero aryl group, or optionally, R¹¹³ and R¹¹⁴ can be further linked to form an unsubstituted or substituted hetero ring, where each R¹¹³ is identical to or different from each other when m3 is 2, 3 or 4, and where each R¹¹⁴ is identical to or different from each other when m4 is 2, 3 or 4;
Y² has the following structure of Chemical Formula 19A or Chemical Formula 19B;
each of m1, m2, m3 and m4 is independently 0, 1, 2, 3 or 4, 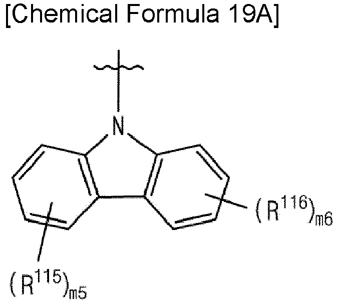 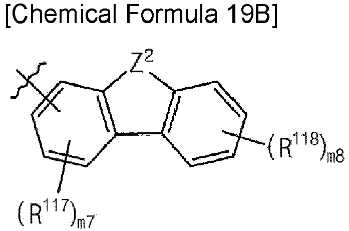 wherein, in Chemical Formulae 19A and 19B,
   each of R¹¹⁵, R¹¹⁶, R¹¹⁷ and R¹¹⁸ is independently an unsubstituted or substituted C₁-C₂₀ alkyl group, an unsubstituted or substituted C₆-C₃₀ aryl group or an unsubstituted or substituted C₃-C₃₀ hetero aryl group, where each R¹¹⁵ is identical to or different from each other when m5 is 2, 3 or 4, where each R¹¹⁶ is identical to or different from each other when m6 is 2, 3 or 4, where each R¹¹⁷ is identical to or different from each other when m7 is 2 or 3, and where each R¹¹⁸ is identical to or different from each other when m8 is 2, 3 or 4;
   each of m5, m6 and m8 is independently 0, 1, 2, 3 or 4;
   m7 is 0, 1, 2 or 3;
   Z² is NR¹¹⁹, O or S, where R¹¹⁹ is hydrogen, an unsubstituted or substituted C₁-C₂₀ alkyl group, an unsubstituted or substituted C₆-C₃₀ aryl group or an unsubstituted or substituted C₃-C₃₀ hetero aryl group.

### [Embodiment 50x]

The organic light emitting diode of any one of embodiments 45x to 49x, wherein the second emitting part further includes a yellow green emitting material layer disposed between the green emitting material layer and the red emitting material layer.

### [Embodiment 51x]

An organic light emitting device including:
a substrate; and
the organic light emitting diode of any one of embodiments 32x to 50x disposed over the substrate.

## Claims

1. An organic light emitting device (100), including:
a substrate (110) defining a first pixel region (SP1) and a second pixel region (SP2); and
an organic light emitting diode (D) disposed over the substrate (110),
wherein the organic light emitting diode (D) includes a transmissive electrode (230), a reflective electrode (210) facing the transmissive electrode and an emissive layer (220) disposed between the transmissive electrode (230) and the reflective electrode (210),
wherein the organic light emitting diode (D) respectively corresponds to each of the first pixel region (SP1) and the second pixel region (SP2),
wherein the emissive layer comprises a first emissive layer (220-B1, 220-B2) and a second emissive layer (220-G1, 220-G2),
wherein the first emissive layer (220-B1, 220-B2) of the organic light emitting diode (D1-B, D2-B) is disposed in the first pixel region (SP1) and includes a first blue emitting material layer (350) including a first blue fluorescent compound (352), and a second blue emitting material layer (360, 460) disposed between the first blue emitting material layer (350) and the transmissive electrode (230) and including a second blue fluorescent compound (362, 462) and a blue phosphorescent compound (364, 464), and
wherein the second emissive layer (220-G1, 220-G2) of the organic light emitting diode (D1-G, D2-G) is disposed in the second pixel region (SP2) and includes a first green emitting material layer (550) including a first green delayed fluorescent compound (552), and a second green emitting material layer (560, 660) disposed between the first green emitting material layer (550) and the transmissive layer (230) and including a second green delayed fluorescent compound (562, 662).

2. The organic light emitting device (100), according to claim 1, further including:
a first charge generation layer (390A) disposed between the first blue emitting material layer (350) and the second blue emitting material layer (460); and
a second charge generation layer (590A) disposed between the first green emitting material layer (550) and the second green emitting material layer (660).

3. The organic light emitting device (100), according to claim 1 or 2, wherein the first blue emitting material layer (350) further includes a first blue host (354) and the second blue emitting material layer (360, 460) further includes at least one of a second blue host (366, 466) and a third blue host (368, 468).

4. The organic light emitting device (100), according to any one of claims 1 to 3, wherein the first green emitting material layer (550) further includes a first green fluorescent compound (554) and the second green emitting material (560, 660) layer further includes a second green fluorescent compound (564, 664).

5. The organic light emitting device (100), according to any one of claims 1 to 4, wherein the first green emitting material layer (550) further includes a first green host (556) and the second green emitting material (560, 660) layer further includes a second green host (566, 666).

6. The organic light emitting device (100), according to any one of claims 1 to 5, wherein
the substrate (110) further defines a third pixel region (SP3);
the organic light emitting diode (D) further corresponds to the third pixel region (SP3);
the emissive layer further comprises a third emissive layer (220-R1, 220-R2);
and
the third emissive layer (220-R1, 220-R2) of the organic light emitting diode (D1-R, D2-R) is disposed in the third pixel region (SP3) and includes a first red emitting material layer (750) including a red delayed fluorescent compound (752) and a red fluorescent compound (754) and a second red emitting material layer (760, 860) disposed between the first red emitting material layer (750) and the second electrode (230) and including a red phosphorescent compound (762, 862).

7. The organic light emitting device (100), according to claim 6 further comprising a third charge generation layer (790A) disposed between the first red emitting material layer (750) and the second red emitting material layer (860).

8. The organic light emitting device (100), according to claim 6 or 7, wherein the first red emitting material layer (750) further includes a first red host (756) and the second red emitting material layer (760, 860) further includes a second red host (764, 864).

9. The organic light emitting device (100), according to any one of claims 1 to 5, wherein each of the first blue emitting material layer (350) and the second blue emitting material layer (360, 460) and each of the first green emitting material layer (550) and the second green emitting material layer (560, 660) are located within a single emitting part, respectively.

10. The organic light emitting device (100), according to any one of claims 6 to 8, wherein each of the first blue emitting material layer (350) and the second blue emitting material layer (360, 460), each of the first green emitting material layer (550) and the second green emitting material layer, and each of the first red emitting material layer (750) and the second red emitting material layer (760, 860) are located within a single emitting part, respectively.

11. The organic light emitting device (100), according to any one of claims 1 to 10, wherein:
(i) the first blue fluorescent compound (352) includes an organic compound having the following structure of Chemical Formula 1: 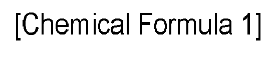 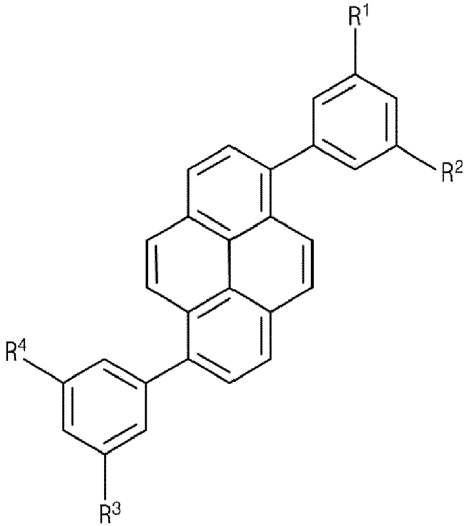 wherein, in the Chemical Formula 1,
each of R¹, R², R³ and R⁴ is independently hydrogen, an unsubstituted or substituted C₁-C₂₀ alkyl group, an unsubstituted or substituted C₆-C₃₀ aryl group or an unsubstituted or substituted C₆-C₃₀ aryl amino group;
(ii) the second blue fluorescent (362, 462) compound includes an organic compound having the following structure of Chemical Formula 5: 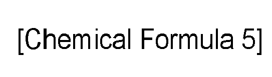 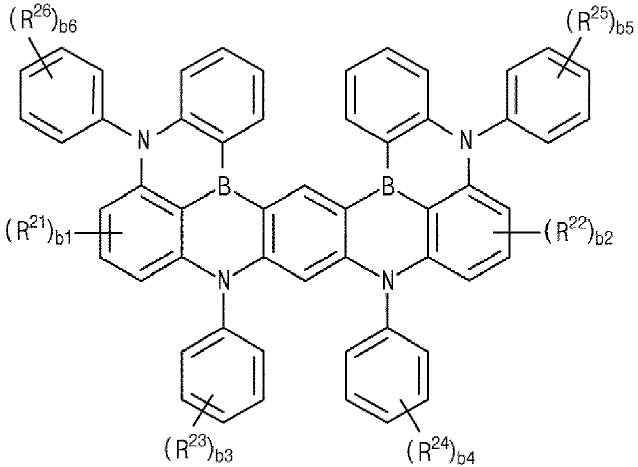 wherein, in the Chemical Formula 5,
each of R²¹ and R²² is independently an unsubstituted or substituted C₆-C₃₀ aryl group, an unsubstituted or substituted C₃-C₃₀ hetero aryl group or an unsubstituted or substituted C₆-C₃₀ aryl amino group, where each R²¹ is identical to or different from each other when b1 is 2 or 3, and where each R²² is identical to or different from each other when b2 is 2 or 3;
each of R²³, R²⁴, R²⁵ and R²⁶ is independently an unsubstituted or substituted C₁-C₂₀ alkyl group or an unsubstituted or substituted C₆-C₃₀ aryl group, where each R²³ is identical to or different from each other when b3 is 2, 3, 4 or 5, where each R²⁴ is identical to or different from each other when b4 is 2, 3, 4 or 5, where each R²⁵ is identical to or different from each other when b5 is 2, 3, 4 or 5, and where each R²⁶ is identical to or different from each other when b6 is 2, 3, 4 or 5;
each of b1 and b2 is independently 0, 1, 2 or 3; and
each of b3, b4, b5 and b6 is independently 0, 1, 2, 3, 4 or 5; and
(iii)
blue phosphorescent compound (364, 464) includes an organometallic compound having the following structure of Chemical Formula 7: 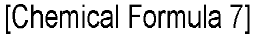 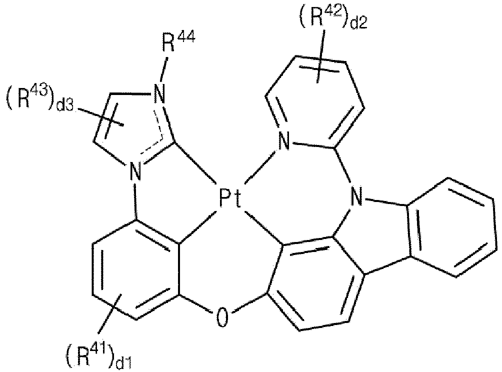 wherein, in the Chemical Formula 7,
each of R⁴¹, R⁴² and R⁴³ is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁴¹ is identical to or different from each other when d1 is 2 or 3, where each R⁴² is identical to or different from each other when d2 is 2, 3 or 4, and where each R⁴³ is identical to or different from each other when d3 is 2;
R⁴⁴ is hydrogen, an unsubstituted or substituted C₁-C₂₀ alkyl group, an unsubstituted or substituted C₆-C₃₀ aryl group or an unsubstituted or substituted C₃-C₃₀ hetero aryl group;
d1 is 0, 1, 2 or 3;
d2 is 0, 1, 2, 3 or 4; and
d3 is 0, 1 or 2.

12. The organic light emitting device (100), according to any one of claims 1 to 11, wherein each of the first green delayed fluorescent compound (552) and the second green delayed fluorescent compound (562, 662) independently includes an organic compound having the following structure of Chemical Formula 11: 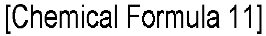 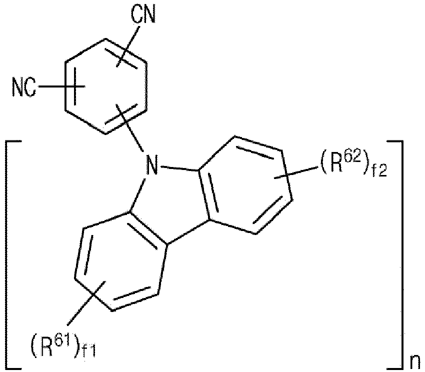 wherein, in the Chemical Formula 11,
each of R61 and R62 is independently an unsubstituted or substituted C1-C20 alkyl group, an unsubstituted or substituted C6-C30 aryl group or an unsubstituted or substituted C3-C30 hetero aryl group, where each R61 is identical to or different from each other when f1 is 2, 3 or 4, and where each R62 is identical to or different from each other when f2 is 2, 3 or 4;
each of f1 and f2 is independently 0, 1, 2, or 4; and
n is 1, 2, 3 or 4.

13. The organic light emitting device (100), according to any one of claim 6 and claims 7 to 12 depending on claim 6, wherein the red delayed fluorescent compound (752) has the following structure of Chemical Formula 11: 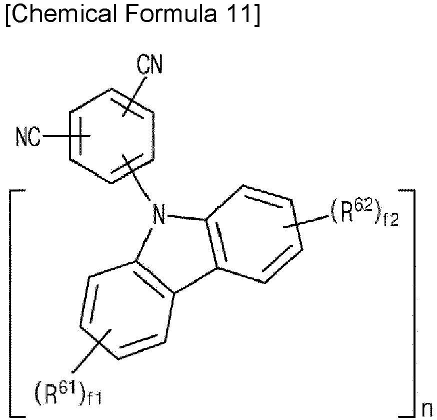 wherein, in the Chemical Formula 11,
each of R⁶¹ and R⁶² is independently an unsubstituted or substituted C₁-C₂₀ alkyl group, an unsubstituted or substituted C₆-C₃₀ aryl group or an unsubstituted or substituted C₃-C₃₀ hetero aryl group, where each R⁶¹ is identical to or different from each other when f1 is 2, 3 or 4, and where each R⁶² is identical to or different from each other when f2 is 2, 3 or 4;
each of f1 and f2 is independently 0, 1, 2, or 4; and
n is 1, 2, 3 or 4.

14. The organic light emitting device (100), according to any one of claim 6 and claims 7 to 13 depending on claim 6, wherein the red fluorescent compound (754) has the following structure of Chemical Formula 17: 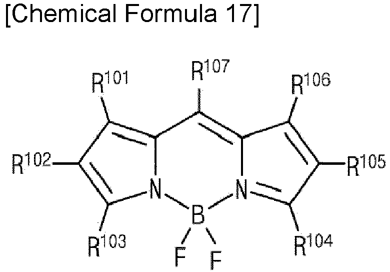 wherein, in the Chemical Formula 17,
each of R¹⁰¹, R¹⁰², R¹⁰³, R¹⁰⁴, R¹⁰⁵ and R¹⁰⁶ is independently hydrogen, an unsubstituted or substituted C₁-C₂₀ alkyl group, an unsubstituted or substituted C₆-C₃₀ aryl group or an unsubstituted or substituted C₃-C₃₀ hetero aryl group; and
R¹⁰⁷ is an unsubstituted or substituted C₆-C₃₀ aryl group or an unsubstituted or substituted C₃-C₃₀ hetero aryl group.
